# EUROPEAN PATENT APPLICATION

(11) **EP 4 485 973 A1**
(43) Date of publication of application: **01.01.2025**
(21) Application number: 24183202.1
(22) Date of filing: 19.06.2024
(51) Int. Cl.: H04R 17/00

(54) **VIBRATION APPARATUS AND APPARATUS INCLUDING THE SAME**

(30) Priority: 30.06.2023 KR 20230085155
(71) Applicant: LG Display Co., Ltd., Seoul 07336 (KR)
(72) Inventor: KO, Sungwook, 245, LG-ro, Wollong-Myeon, Paju-si, Gyeonggi-do, 10845 (KR); KANG, MinGyu, 245, LG-ro, Wollong-Myeon, Paju-si, Gyeonggi-do, 10845 (KR)
(74) Representative: Bryn-Jacobsen, Caelia

(57) **Abstract**

A vibration apparatus includes a vibration generating part. The vibration generating part includes a plurality of vibration parts each including a first surface including a first pattern portion and a second surface including a third pattern portion, the plurality of vibration parts being stacked on each other, a first connection member electrically connected to the first pattern portion of each of the plurality of vibration parts, and a second connection member electrically connected to the third pattern portion of each of the plurality of vibration parts.

## Description

### CROSS-REFERENCE TO RELATED APPLICATION

This application claims the priority to Korean Patent Application No. 10-2023-0085155 filed in the Republic of Korea on June 30, 2023.

### BACKGROUND

### Technical Field

The present disclosure relates to a vibration apparatus and an apparatus including the same.

### Discussion of the Related Art

An apparatus includes a separate speaker or a sound apparatus providing a sound. When a speaker is disposed in an apparatus, the speaker occupies a space, due to this, the design and spatial disposition of the apparatus are limited.

A speaker applied to the apparatus may be, for example, an actuator including a magnet and a coil. However, when an actuator is applied to the apparatus, a thickness thereof is thickened. Therefore, piezoelectric devices for realizing a thin thickness are attracting much attention.

### SUMMARY

Speakers or vibration apparatuses with a piezoelectric device applied thereto may be driven or vibrated by a driving power or a driving signal supplied through a signal cable.

Vibration apparatuses (or film actuators) include a film which includes a line and a pad electrode for applying a driving power to a piezoelectric device. The vibration apparatuses need a process of patterning the line and the pad electrode on the film and a soldering process or the like of electrically connecting the pad electrode to the signal cable.

The inventors of the present disclosure have performed extensive research and experiments for implementing a vibration apparatus in which a manufacturing process and a structure of the vibration apparatus may be simplified. Through the extensive research and experiments, the inventors of the present disclosure have invented a vibration apparatus having a new structure and an apparatus including the same, in which a manufacturing process and a structure of the vibration apparatus may be simplified.

One or more aspects of the present disclosure are directed to providing a vibration apparatus and an apparatus including the same, in which a manufacturing process and a structure of the vibration apparatus may be simplified.

One or more aspects of the present disclosure are directed to providing a vibration apparatus and an apparatus including the same, in which the manufacturing cost of a vibration apparatus may be reduced and a process yield rate may increase.

One or more aspects of the present disclosure are directed to providing a vibration apparatus and an apparatus including the same, in which a sound pressure level characteristic of a sound may be enhanced.

One or more aspects of the present disclosure are directed to providing a vibration apparatus and an apparatus including the same, which may be connected to a signal supply member without a soldering process.

One or more aspects of the present disclosure are directed to providing a vibration apparatus with a signal supply member integrated therein and an apparatus including the vibration apparatus.

Additional features, advantages, and aspects will be set forth in the description that follows, and in part will be apparent from the description, or may be learned by practice of the inventive concepts provided herein. Other features, advantages, and aspects of the present disclosure may be realized and attained by the structure particularly pointed out in the written description, or derivable therefrom, and the claims hereof as well as the appended drawings.

To achieve these and other advantages and aspects of the present disclosure, as embodied and broadly described herein, in one or more aspects, a vibration apparatus comprises a vibration generating part, the vibration generating part comprises a plurality of vibration parts each including a first surface including a first pattern portion and a second surface including a third pattern portion, the plurality of vibration parts being stacked on each other, a first connection member electrically connected to the first pattern portion of each of the plurality of vibration parts, and a second connection member electrically connected to the third pattern portion of each of the plurality of vibration parts.

In one or more aspects, an apparatus comprises a passive vibration member, and one or more vibration generating apparatuses configured to vibrate the passive vibration member. The one or more vibration generating apparatuses comprise a vibration apparatus. The vibration apparatus comprises a vibration generating part, the vibration generating part comprises a plurality of vibration parts each including a first surface including a first pattern portion and a second surface including a third pattern portion, the plurality of vibration parts being stacked on each other, a first connection member electrically connected to the first pattern portion of each of the plurality of vibration parts, and a second connection member electrically connected to the third pattern portion of each of the plurality of vibration parts.

According to one or more examples of the present disclosure, a structure and a manufacturing process of a vibration apparatus may be simplified.

According to one or more examples of the present disclosure, the manufacturing cost of a vibration apparatus may be reduced, and a process yield rate may increase.

According to one or more examples of the present disclosure, a sound pressure level characteristic of a sound may be enhanced.

According to one or more examples of the present disclosure, a signal supply member and a vibration apparatus may be connected to each other without a soldering process.

According to one or more examples of the present disclosure, as a signal supply member and a vibration apparatus are provided as one body, the signal supply member and the vibration apparatus may be configured as one part (or an element or one component).

According to one or more examples of the present disclosure, a crack or damage may be prevented or reduced from occurring at a vibration generating part during a film laminating process.

Other systems, methods, features and advantages will be, or will become, apparent to one with skill in the art upon examination of the following figures and detailed description. It is intended that all such additional systems, methods, features and advantages be included within this description, be within the scope of the present disclosure, and be protected by the following claims. Nothing in this section should be taken as a limitation on those claims. Further aspects and advantages are discussed below in conjunction with aspects of the disclosure.

It is to be understood that both the foregoing description and the following description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure, are incorporated in and constitute a part of this disclosure, illustrate aspects and examples of the disclosure and together with the description serve to explain principles of the disclosure.
FIG. 1 illustrates a vibration apparatus according to an example of the present disclosure.
FIG. 2 illustrates a vibration generating part illustrated in FIG. 1 according to an example of the present disclosure.
FIG. 3 is an exploded perspective view of the vibration generating part illustrated in FIG. 2 according to an example of the present disclosure.
FIG. 4 is an exploded perspective view illustrating a vibration part illustrated in FIGs. 2 and 3 according to an example of the present disclosure.
FIG. 5 is a cross-sectional view taken along line A-A' illustrated in FIG. 2 according to an example of the present disclosure.
FIG. 6 is a cross-sectional view taken along line B-B' illustrated in FIG. 2 according to an example of the present disclosure.
FIG. 7 is a cross-sectional view taken along line C-C' illustrated in FIG. 1 according to an example of the present disclosure.
FIG. 8 is a cross-sectional view taken along line D-D' illustrated in FIG. 1 according to an example of the present disclosure.
FIG. 9 illustrates a vibration apparatus according to another example of the present disclosure.
FIG. 10 is a cross-sectional view as a cross-sectional surface taken along line E-E' illustrated in FIG. 9 according to an example of the present disclosure is seen from a side.
FIG. 11 is a perspective view illustrating a pad member and a signal supply member illustrated in FIGs. 9 and 10 according to an example of the present disclosure.
FIG. 12 illustrates a vibration apparatus according to another example of the present disclosure.
FIG. 13 illustrates a vibration generating part illustrated in FIG. 12 according to another example of the present disclosure.
FIG. 14 is an exploded perspective view of the vibration generating part illustrated in FIG. 13 according to another example of the present disclosure.
FIG. 15 is an exploded perspective view illustrating a vibration part illustrated in FIGs. 13 and 14 according to another example of the present disclosure.
FIG. 16 is a cross-sectional view taken along line F-F' illustrated in FIG. 13 according to another example of the present disclosure.
FIG. 17 is a cross-sectional view taken along line G-G' illustrated in FIG. 12 according to another example of the present disclosure.
FIG. 18 illustrates a vibration apparatus according to another example of the present disclosure.
FIG. 19 illustrates a vibration generating part illustrated in FIG. 18 according to another example of the present disclosure.
FIG. 20 is an exploded perspective view of the vibration generating part illustrated in FIG. 19 according to another example of the present disclosure.
FIG. 21 is an exploded perspective view illustrating a vibration part illustrated in FIGs. 19 and 20 according to another example of the present disclosure.
FIG. 22 is a cross-sectional view taken along line H-H' illustrated in FIG. 19 according to another example of the present disclosure.
FIG. 23 is a cross-sectional view taken along line I-I' illustrated in FIG. 18 according to another example of the present disclosure.
FIG. 24 is another exploded perspective view of the vibration generating part illustrated in FIG. 19 according to another example of the present disclosure.
FIG. 25 is an exploded perspective view illustrating a vibration part illustrated in FIG. 24 according to another example of the present disclosure.
FIG. 26 is another cross-sectional view taken along line H-H' illustrated in FIG. 19 according to another example of the present disclosure.
FIG. 27 illustrates an apparatus according to an example of the present disclosure.
FIG. 28 is a cross-sectional view taken along line J-J' illustrated in FIG. 27 according to an example of the present disclosure.
FIG. 29 illustrates a sound output characteristic of a vibration apparatus according to an example of the present disclosure and a sound output characteristic of a vibration apparatus according to an experimental example.

Throughout the drawings and the detailed description, unless otherwise described, the same drawing reference numerals should be understood to refer to the same elements, features, and structures. The sizes, lengths, and thicknesses of layers, regions and elements, and depiction of thereof may be exaggerated for clarity, illustration, and convenience.

### DETAILED DESCRIPTION

Reference is now made in detail to aspects of the present disclosure, examples of which may be illustrated in the accompanying drawings. In the following description, when a detailed description of well-known methods, functions, structures or configurations may unnecessarily obscure aspects of the present disclosure, a detailed description of such known functions or configurations may have been omitted for brevity. Further, repetitive descriptions may be omitted for brevity. The progression of processing steps and/or operations described is a non-limiting example.

The sequence of steps and/or operations is not limited to that set forth herein and may be changed to occur in an order that is different from an order described herein, with the exception of steps and/or operations necessarily occurring in a particular order. In one or more examples, two operations in succession may be performed substantially concurrently, or the two operations may be performed in a reverse order or in a different order depending on a function or operation involved.

Unless stated otherwise, like reference numerals may refer to like elements throughout even when they are shown in different drawings. Unless stated otherwise, the same reference numerals may be used to refer to the same or substantially the same elements throughout the specification and the drawings. In one or more aspects, identical elements (or elements with identical names) in different drawings may have the same or substantially the same functions and properties unless stated otherwise. Names of the respective elements used in the following explanations are selected only for convenience and may be thus different from those used in actual products.

Advantages and features of the present disclosure, and implementation methods thereof, are clarified through the aspects described with reference to the accompanying drawings. The present disclosure may, however, be embodied in different forms and should not be construed as limited to the example aspects set forth herein. Rather, these example aspects are examples and are provided so that this disclosure may be thorough and complete to assist those skilled in the art to understand the inventive concepts without limiting the protected scope of the present disclosure.

Shapes, dimensions (e.g., sizes, lengths, widths, heights, thicknesses, locations, radii, diameters, and areas), proportions, ratios, angles, numbers, the number of elements, and the like disclosed herein, including those illustrated in the drawings, are merely examples, and thus, the present disclosure is not limited to the illustrated details. It is, however, noted that the relative dimensions of the components illustrated in the drawings are part of the present disclosure.

Where a term like "comprise," "have," "include," "contain," "constitute," "made of," "formed of," "composed of," or the like is used with respect to one or more elements (e.g., layers, films, regions, components, sections, members, parts, regions, areas, portions, steps, operations, and/or the like), one or more other elements may be added unless a term such as "only" or the like is used. The terms used in the present disclosure are merely used to describe particular example aspects, and are not intended to limit the scope of the present disclosure. The terms of a singular form may include plural forms unless the context clearly indicates otherwise.

The word "exemplary" is used to mean serving as an example or illustration, unless otherwise specified. Aspects are example aspects. In one or more implementations, "examples," "aspects," "examples," and the like should not be construed to be preferred or advantageous over other implementations. An aspect, an example, an example aspect, or the like may refer to one or more aspects, one or more examples, one or more example aspects, or the like, unless stated otherwise. Further, the term "may" encompasses all the meanings of the term "can."

In one or more aspects, unless explicitly stated otherwise, an element, feature, or corresponding information (e.g., a level, range, dimension, size, or the like) is construed to include an error or tolerance range even where no explicit description of such an error or tolerance range is provided. An error or tolerance range may be caused by various factors (e.g., process factors, internal or external impact, noise, or the like). In interpreting a numerical value, the value is interpreted as including an error range unless explicitly stated otherwise.

In describing a positional relationship, when the positional relationship between two parts (e.g., layers, films, regions, components, sections, or the like) is described, for example, using "on," "upon," "on top of," "over," "under," "above," "below," "beneath," "near," "close to," "adjacent to," "beside," "next to," "at or on a side of," or the like, one or more other parts may be located between the two parts unless a more limiting term, such as "immediate(ly)," "direct(ly)," or "close(ly)," is used. For example, where a structure is described as being positioned "on," "upon," "on top of," "over," "under," "above," "below," "beneath," "near," "close to," "adjacent to," "beside," "next to," "at or on a side of," or the like another structure, this description should be construed as including a case in which the structures contact each other as well as a case in which one or more additional structures are disposed or interposed therebetween. Furthermore, the terms "front," "rear," "back," "left," "right," "top," "bottom," "downward," "upward," "upper," "lower," "up," "down," "column," "row," "vertical," "horizontal," and the like refer to an arbitrary frame of reference.

Spatially relative terms, such as "below," "beneath," "lower," "on," "above," "upper" and the like, can be used to describe a correlation between various elements (e.g., layers, films, regions, components, sections, or the like) as shown in the drawings. The spatially relative terms are to be understood as terms including different orientations of the elements in use or in operation in addition to the orientation depicted in the drawings. For example, if the elements shown in the drawings are turned over, elements described as "below" or "beneath" other elements would be oriented "above" other elements. Thus, the term "below," which is an example term, can include all directions of "above" and "below." Likewise, an exemplary term "above" or "on" can include both directions of "above" and "below."

In describing a temporal relationship, when the temporal order is described as, for example, "after," "subsequent," "next," "before," "preceding," "prior to," or the like, a case that is not consecutive or not sequential may be included and thus one or more other events may occur therebetween, unless a more limiting term, such as "just," "immediate(ly)," or "direct(ly)," is used.

The terms, such as "below," "lower," "above," "upper" and the like, may be used herein to describe a relationship between element(s) as illustrated in the drawings. It will be understood that the terms are spatially relative and based on the orientation depicted in the drawings.

It is understood that, although the terms "first," "second," or the like may be used herein to describe various elements (e.g., layers, films, regions, components, sections, members, parts, regions, areas, portions, steps, operations, and/or the like), these elements should not be limited by these terms, for example, to any particular order, precedence, or number of elements. These terms are used only to distinguish one element from another. For example, a first element may denote a second element, and, similarly, a second element may denote a first element, without departing from the scope of the present disclosure. Furthermore, the first element, the second element, and the like may be arbitrarily named according to the convenience of those skilled in the art without departing from the scope of the present disclosure. For clarity, the functions or structures of these elements (e.g., the first element, the second element and the like) are not limited by ordinal numbers or the names in front of the elements. Further, a first element may include one or more first elements. Similarly, a second element or the like may include one or more second elements or the like.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

For the expression that an element (e.g., layer, film, region, component, section, or the like) is described as "connected," "coupled," "attached," "adhered," or the like to another element, the element can not only be directly connected, coupled, attached, adhered, or the like to another element, but also be indirectly connected, coupled, attached, adhered, or the like to another element with one or more intervening elements disposed or interposed between the elements, unless otherwise specified.

For the expression that an element (e.g., layer, film, region, component, section, or the like) "contacts," "overlaps," or the like with another element, the element can not only directly contact, overlap, or the like with another element, but also indirectly contact, overlap, or the like with another element with one or more intervening elements disposed or interposed between the elements, unless otherwise specified.

The phrase that an element (e.g., layer, film, region, component, section, or the like) is "provided," "disposed," "connected," "coupled," or the like in, on, with or to another element may be understood as that at least a portion of the element is provided, disposed, connected, coupled, or the like in, on, with or to at least a portion of another element, or that the entirety of the element is provided, disposed, connected, coupled, or the like in another element. The phase that an element (e.g., layer, film, region, component, section, or the like) "contacts," "overlaps," or the like with another element may be understood, for example, as that at least a portion of the element contacts, overlaps, or the like with a least a portion of another element, that the entirety of the element contacts, overlaps, or the like with a least a portion of another element, or that at least a portion of the element contacts, overlaps, or the like with the entirety of another element.

The terms such as a "line" or "direction" should not be interpreted only based on a geometrical relationship in which the respective lines or directions are parallel or perpendicular to each other. Such terms may mean a wider range of lines or directions within which the components of the present disclosure can operate functionally. For example, the terms "first direction," "second direction," and the like, such as a direction parallel or perpendicular to "x-axis," "y-axis," or "z-axis," should not be interpreted only based on a geometrical relationship in which the respective directions are parallel or perpendicular to each other, and may be meant as directions having wider directivities within the range within which the components of the present disclosure can operate functionally.

The term "at least one" should be understood as including any and all combinations of one or more of the associated listed items. For example, each of the phrases of "at least one of a first item, a second item, or a third item" and "at least one of a first item, a second item, and a third item", may represent (i) a combination of items provided by one or more of the first item, the second item, and the third item or (ii) only one of the first item, the second item, and the third item.

The expression of a first element, a second elements, "and/or" a third element should be understood to encompass one of the first, second, and third elements, as well as any and all combinations of the first, second and third elements. By way of example, A, B and/or C encompass only A; only B; only C; any of A, B, and C (e.g., A, B, or C); some combinations of A, B, and C (e.g., A and B; A and C; or B and C); and all of A, B, and C. Furthermore, an expression "A/B" may be understood as A and/or B. For example, an expression "A/B" can refer to only A; only B; A or B; or A and B.

In one or more aspects, the terms "between" and "among" may be used interchangeably simply for convenience unless stated otherwise. For example, an expression "between a plurality of elements" may be understood as among a plurality of elements. In another example, an expression "among a plurality of elements" may be understood as between a plurality of elements. In one or more examples, the number of elements may be two. In one or more examples, the number of elements may be more than two. Furthermore, when an element (e.g., layer, film, region, component, sections, or the like) is referred to as being "between" at least two elements, the element may be the only element between the at least two elements, or one or more intervening elements may also be present.

In one or more aspects, the phrases "each other" and "one another" may be used interchangeably simply for convenience unless stated otherwise. For example, an expression "different from each other" may be understood as different from one another. In another example, an expression "different from one another" may be understood as different from each other. In one or more examples, the number of elements involved in the foregoing expression may be two. In one or more examples, the number of elements involved in the foregoing expression may be more than two.

In one or more aspects, the phrases "one or more among" and "one or more of" may be used interchangeably simply for convenience unless stated otherwise.

The term "or" means "inclusive or" rather than "exclusive or." For example, unless otherwise stated or clear from the context, the expression that "x uses a or b" means any one of natural inclusive permutations. For example, "a or b" may mean "a," "b," or "a and b." For example, "a, b or c" may mean "a," "b," "c," "a and b," "b and c," "a and c," or "a, b and c."

Features of various aspects of the present disclosure may be partially or entirely coupled to or combined with each other, may be technically associated with each other, and may be operated, linked, or driven together in various ways. Aspects of the present disclosure may be implemented or carried out independently from each other, or may be implemented or carried out together in a co-dependent or related relationship. In one or more aspects, the components of each apparatus according to various aspects of the present disclosure may be operatively coupled and configured.

Unless otherwise defined, the terms (including technical and scientific terms) used herein have the same meaning as commonly understood by one of ordinary skill in the art to which example aspects belong. It should be further understood that terms, such as those defined in commonly used dictionaries, should be interpreted as having a meaning that is, for example, consistent with their meaning in the context of the relevant art and should not be interpreted in an idealized or overly formal sense, unless expressly defined otherwise herein.

The terms used herein have been selected as being general in the related technical field; however, there may be other terms depending on the development and/or change of technology, convention, preference of technicians, and so on. Therefore, the terms used herein should not be understood as limiting technical ideas, but should be understood as examples of the terms for describing example aspects.

Further, in a specific case, a term may be arbitrarily selected by an applicant, and in this case, the detailed meaning thereof is described herein. Therefore, the terms used herein should be understood based on not only the name of the terms, but also the meaning of the terms and the content hereof.

"X-axis direction," "Y-axis direction," and "Z-axis direction," should not be construed by a geometric relation only of a mutual vertical relation and may have broader directionality within the range that elements of the present disclosure may act functionally.

In the following description, various example aspects of the present disclosure are described in detail with reference to the accompanying drawings. With respect to reference numerals to elements of each of the drawings, the same elements may be illustrated in other drawings, and like reference numerals may refer to like elements unless stated otherwise. The same or similar elements may be denoted by the same reference numerals even though they are depicted in different drawings.

In addition, for convenience of description, a scale, dimension, size, and thickness of each of the elements illustrated in the accompanying drawings may be different from an actual scale, dimension, size, and thickness, and thus, aspects of the present disclosure are not limited to a scale, dimension, size, and thickness illustrated in the drawings.

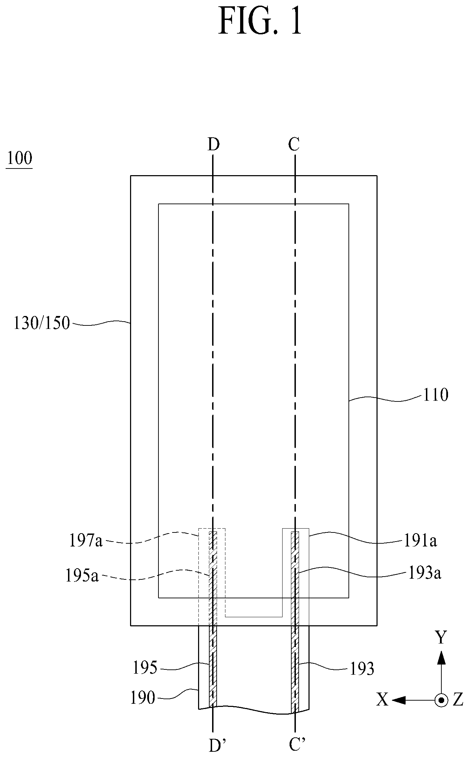

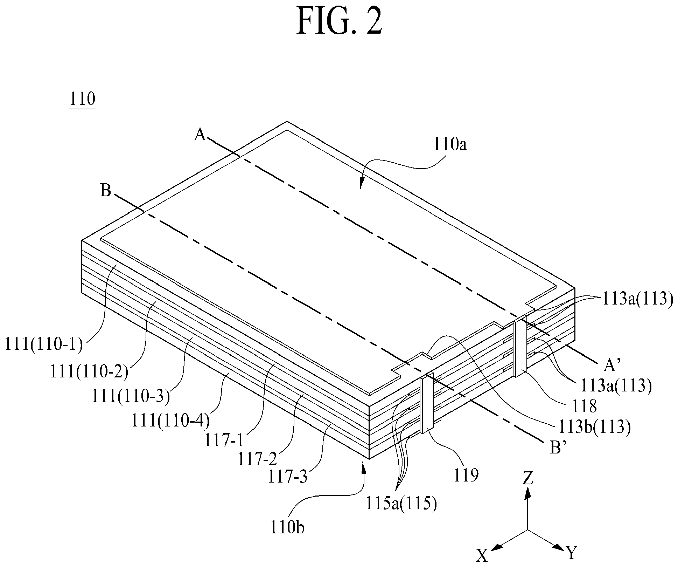

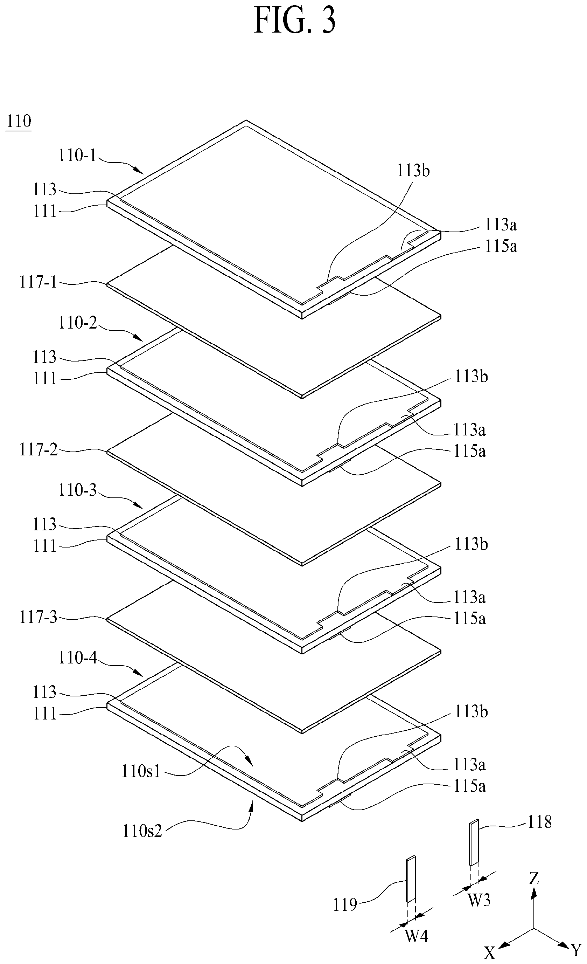

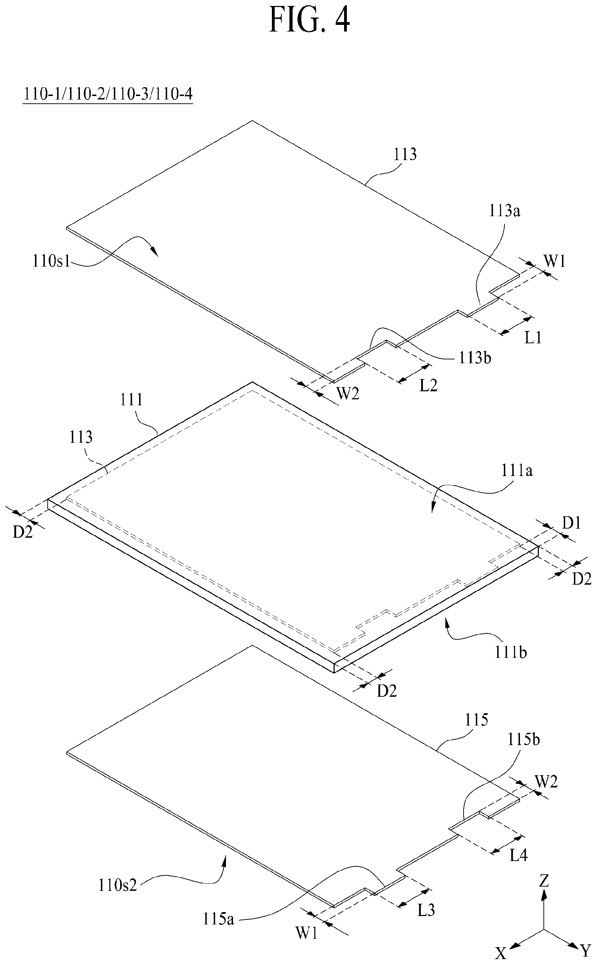

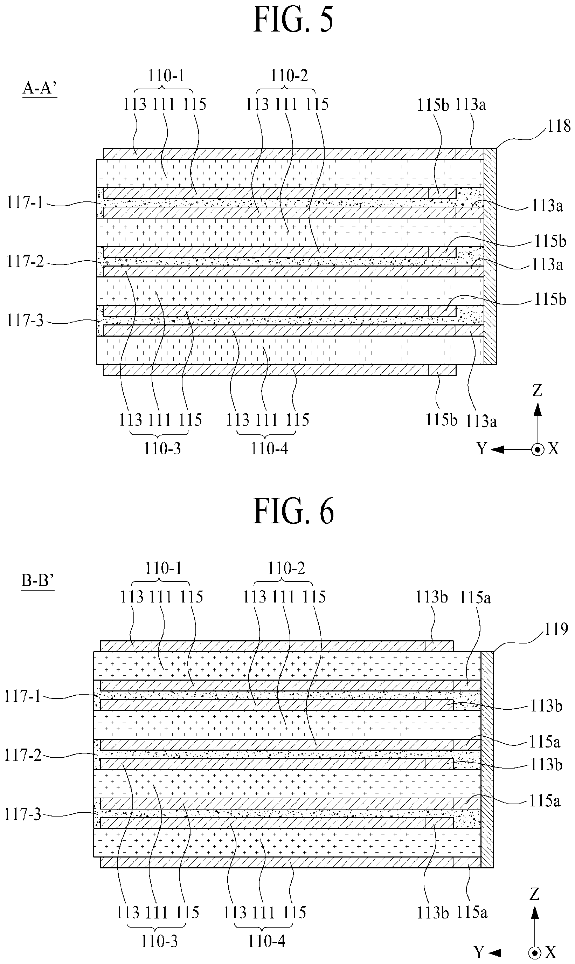

FIG. 1 illustrates a vibration apparatus according to an example of the present disclosure. FIG. 2 illustrates a vibration generating part illustrated in FIG. 1 according to an example of the present disclosure. FIG. 3 is an exploded perspective view of the vibration generating part illustrated in FIG. 2 according to an example of the present disclosure. FIG. 4 is an exploded perspective view illustrating a vibration part illustrated in FIGs. 2 and 3 according to an example of the present disclosure. FIG. 5 is a cross-sectional view taken along line A-A' illustrated in FIG. 2 according to an example of the present disclosure. FIG. 6 is a cross-sectional view taken along line B-B' illustrated in FIG. 2 according to an example of the present disclosure.

With reference to FIGs. 1 to 3, the vibration apparatus 100 according to an example of the present disclosure may include a vibration generating part 110.

The vibration generating part 110 may be configured to vibrate based on a driving signal (or a sound signal or a voice signal). For example, the vibration generating part 110 may include a first surface 110a and a second surface 110b opposite to the first surface 1 10a. In the vibration generating part 110, the first surface 101a may be an upper surface, a front surface, an uppermost electrode layer, an uppermost electrode part, or an uppermost electrode surface, but examples of the present disclosure are not limited thereto. The second surface 10b may be a lower surface, a back surface, a rear surface, a lowermost electrode layer, a lowermost electrode part, or a lowermost electrode surface, but examples of the present disclosure are not limited thereto.

The vibration generating part 110 according to an example of the present disclosure may include a plurality (or two or more) of vibration parts 110-1, 110-2, 110-3, and 110-4, and a plurality of insulating members 117-1, 117-2, 117-3, a first connection member 118, and a second connection member 119. In the following description, a plurality (or two or more) of vibration parts may be referred to as a plurality of vibration parts.

Each of the plurality of vibration parts 110-1, 110-2, 110-3, and 110-4 may be configured to vibrate based on the driving signal (or sound signal or voice signal). Each of the plurality of vibration parts 110-1, 110-2, 110-3, and 110-4 may be a piezoelectric vibration part, a displacement part, a piezoelectric device, or a vibration device, but examples of the present disclosure are not limited thereto. The vibration apparatus 100 according to an example of the present disclosure may include the plurality of vibration parts 110-1, 110-2, 110-3, and 110-4 which are overlapped with each other. The vibration apparatus 100 may include the plurality of vibration parts 110-1, 110-2, 110-3, and 110-4 which are overlapped or stacked (or piled up) to be displaced in a same direction.

The plurality of vibration parts 110-1, 110-2, 110-3, and 110-4 may be overlapped or stacked to be displaced (or driven) in the same direction. For example, the plurality of vibration parts 110-1, 110-2, 110-3, and 110-4 may contract or expand in a same driving direction (or a displacement direction) based on a vibration driving signal in a state where the plurality of vibration parts 110-1, 110-2, 110-3, and 110-4 are stacked or overlapped with each other, and thus, a displacement amount (or a bending force) or an amplitude displacement may increase or may be maximized. Therefore, the plurality of vibration parts 110-1, 110-2, 110-3, and 110-4 may increase (or maximize) a displacement amount (or a bending force) or an amplitude displacement of the vibration generating part 110 or the vibration apparatus 100, thereby enhancing a sound pressure level characteristic of a sound and a sound characteristic of a middle-low-pitched sound band generated based on a vibration of the vibration generating part 110 or the vibration apparatus 100. For example, the middle-low-pitched sound band may be 200Hz to 1kHz, but examples of the present disclosure are not limited thereto. For example, a high-pitched sound band may be 1kHz or more or 3kHz or more, but examples of the present disclosure are not limited thereto.

Each of the plurality of vibration parts 110-1, 110-2, 110-3, and 110-4 according to an example of the present disclosure may include a vibration layer 111, a first electrode layer 113, and a second electrode layer 115.

The vibration layer 111 may include a piezoelectric material (or an electroactive material) which includes a piezoelectric effect. For example, the piezoelectric material may have a characteristic in which, when pressure or twisting (or bending) is applied to a crystalline structure by an external force, a potential difference occurs due to dielectric polarization caused by a relative position change of a positive (+) ion and a negative (-) ion, and a vibration is generated by an electric field based on a reverse voltage applied thereto. For example, the vibration layer 111 may be referred to as a piezoelectric layer, a piezoelectric material layer, an electroactive layer, a piezoelectric material portion, an electroactive portion, a piezoelectric structure, a piezoelectric composite layer, a piezoelectric composite, or a piezoelectric ceramic composite, or the like, but examples of the present disclosure are not limited thereto.

The vibration layer 11 may be configured as a ceramic-based material capable of implementing a relatively strong vibration, or may be configured as a piezoelectric ceramic having a perovskite-based crystalline structure.

The piezoelectric ceramic may be configured as a single crystalline ceramic having a crystalline structure, or may be configured as a ceramic material having a polycrystalline structure or polycrystalline ceramic. A piezoelectric material including the single crystalline ceramic may include α-AlPO₄, α-SiO₂, LiNbO₃, Tb₂(MoO₄)₃, Li₂B₄O₇, or ZnO, but examples of the present disclosure are not limited thereto. A piezoelectric material including the polycrystalline ceramic may include a lead zirconate titanate (PZT)-based material, including lead (Pb), zirconium (Zr), and titanium (Ti), or may include a lead zirconate nickel niobate (PZNN)-based material, including lead (Pb), zirconium (Zr), nickel (Ni), and niobium (Nb), but examples of the present disclosure are not limited thereto. For example, the vibration layer 111 may include at least one or more of calcium titanate (CaTiO₃), barium titanate (BaTiO₃), and strontium titanate (SrTiO₃), without lead (Pb), but examples of the present disclosure are not limited thereto.

The vibration layer 111 according to an example of the present disclosure may include a piezoelectric sintered material (or piezoelectric ceramic) which is manufactured by sintering (or firing) a piezoelectric powder (or a ceramic powder) at a high sintering (or firing) temperature of 1,200 °C or more, but examples of the present disclosure are not limited thereto. For example, the piezoelectric sintered material may be manufactured by a high temperature sintering process performed on a piezoelectric powder.

With reference to FIGs. 2 to 4, the vibration layer 11 according to an example of the present may include a first surface and a second surface opposite to the first surface. For example, the first surface of the vibration layer 111 may be an upper surface or a front surface. The second surface of the vibration layer 111 may be a lower surface, a back surface, or a rear surface.

The first electrode layer 113 may be configured or coupled to the first surface of the vibration layer 111. The first electrode layer 113 may have a same size as the vibration layer 111, or may have a size which is smaller than the vibration layer 111. For example, the first electrode layer 113 of an uppermost vibration parts 110-1 of the plurality of vibration parts 110-1, 110-2, 110-3, and 110-4 may be an upper electrode layer, a front electrode layer, an uppermost surface electrode layer, or an uppermost electrode layer. In the following description, an uppermost vibration parts 110-1 may be referred to as a first vibration part 110-1.

The second electrode layer 115 may be configured or coupled to the second surface of the vibration layer 111. The second electrode layer 115 may have a same size as the vibration layer 111, or may have a size which is smaller than the vibration layer 111. For example, the second electrode layer 115 may have a different shape from the first electrode layer 115. For example, the second electrode layer 115 of a lowermost vibration parts 110-4 of the plurality of vibration parts 110-1, 110-2, 110-3, and 110-4 may be a lower electrode layer, a rear electrode layer, a lowermost surface electrode layer, or a lowermost electrode layer. In the following description, a lowermost vibration parts 110-4 may be referred to as a fourth vibration part 110-4.

According to an example of the present disclosure, to prevent electrical short circuit between the first electrode layer 113 and the second electrode layer 115, each of the first electrode layer 113 and the second electrode layer 115 may be formed at the other portion, except a periphery portion, of the vibration layer 111. For example, the first electrode layer 113 may be formed at an entire first surface, other than a periphery portion, of the vibration layer 111. For example, the second electrode layer 115 may be formed at an entire second surface, other than a periphery portion, of the vibration layer 111. For example, a lateral surface (or a sidewall) of the first electrode layer 113 may be spaced apart from a lateral surface (or a sidewall) of the vibration layer 111 to have a predetermined distances D1 and D2. A lateral surface (or a sidewall) of the second electrode layer 115 may be spaced apart from a lateral surface (or a sidewall) of the vibration layer 111 to have a predetermined distances D1 and D2.

With reference to FIG. 4, the distances D1 and D2 between a lateral surface (or an outer sidewall) of the vibration layer 111 and lateral surfaces (or outer sidewalls) of each of the first electrode layer 113 and the second electrode layer 115 may be adjusted based on a thickness of the vibration layer 111, or may be adjusted based on a thickness of the vibration layer 111 and a process error when forming the electrode layers 113 and 115. For example, the distances D1 and D2 between the lateral surface (or the outer sidewall) of the vibration layer 111 and the lateral surfaces (or the outer sidewalls) of each of the first electrode layer 113 and the second electrode layer 115 may be greater than the thickness of the vibration layer 111, or two or more times the thickness of the vibration layer 111. For example, the distances D1 and D2 between the lateral surface (or the outer sidewall) of the vibration layer 111 and the lateral surfaces (or the outer sidewalls) of each of the first electrode layer 113 and the second electrode layer 115 may be at least 0.4mm or more. For example, the distances D1 and D2 between the lateral surface of the vibration layer 111 and the lateral surface of each of the first electrode layer 113 and the second electrode layer 115 may be at least 1mm or more, but examples of the present disclosure are not limited thereto.

According to an example of the present disclosure, each of the first electrode layer 113 and the second electrode layer 115 may include a first long side and a second long side parallel to each other and a first short side and a second short side parallel to each other. For example, a first distance D1 between the lateral surface of the vibration layer 111 and the first short side of each of the first electrode layer 113 and the second electrode layer 115 may be greater than or equal to a second distance D2 between the lateral surface of the vibration layer 111 and each of the first long side, the second long side, and the second short side of each of the first electrode layer 113 and the second electrode layer 115. For example, the first distance D1 may be greater than the second distance D2. For example, the first distance D1 may be two or more times the second distance D2, but examples of the present disclosure are not limited thereto. For example, in each of the first electrode layer 113 and the second electrode layer 115, the first short side and the second short side may be parallel to a first direction X, the first long side and the second long side may be parallel to a second direction Y intersecting with the first direction X.

With reference to FIGs. 2 to 4, one or more of the first electrode layer 113 and the second electrode layer 115 according to an example of the present disclosure may include a transparent conductive material, a semitransparent conductive material, or an opaque conductive material. For example, the transparent conductive material or the semitransparent conductive material of one or more of the first electrode layer 113 and the second electrode layer 115 may include indium tin oxide (ITO) or indium zinc oxide (IZO), but examples of the present disclosure are not limited thereto. The opaque conductive material of one or more of the first electrode layer 113 and the second electrode layer 115 may include gold (Au), silver (Ag), platinum (Pt), palladium (Pd), molybdenum (Mo), magnesium (Mg), carbon, or silver (Ag) including glass frit, or the like, or may include an alloy thereof, but examples of the present disclosure are not limited thereto. For example, the carbon may be carbon black, ketjen black, carbon nanotube, and a carbon material including graphite, but examples of the present disclosure are not limited thereto.

According to an example of the present disclosure, to enhance an electrical characteristic and/or a vibration characteristic of the vibration layer 111, each of the first electrode layer 113 and the second electrode layer 115 may include silver (Ag) having a low resistivity. In the first electrode layer 113 and the second electrode layer 115 including silver (Ag) including glass frit, a content of the glass frit may be 1wt% to 12wt%, but examples of the present disclosure are not limited thereto. The glass frit may include PbO or Bi₂O₃-based material, but examples of the present disclosure are not limited thereto.

According to an example of the present disclosure, the vibration layer 111 of each of the plurality of vibration parts 110-1, 110-2, 110-3, and 110-4 may be polarized (or poled) by a certain voltage applied to the first electrode layer 113 and the second electrode layer 115 in a certain temperature atmosphere, or a temperature atmosphere that may be changed from a high temperature to a room temperature, but examples of the present disclosure are not limited thereto. For example, the vibration layer 111 may alternately and repeatedly contract or expand based on an inverse piezoelectric effect according to a driving signal applied to the first electrode layer 113 and the second electrode layer 115 from the outside to vibrate. For example, the vibration layer 111 may vibrate based on a vertical-direction vibration and/or a planar direction vibration by the driving signal applied to the first electrode layer 113 and the second electrode layer 115. Accordingly, the amount of displacement of the vibration generating part 110 may be increased or improved by contraction and/or expansion of the planar direction of the vibration layer 111.

With reference to FIGs. 2 to 4, each of the plurality of vibration parts 110-1, 110-2, 110-3, and 110-4 according to an example of the present disclosure may include a first surface 1 10s1 including a first pattern portion 113a and a second pattern portion 113b, and a second surface 110s2 including a third pattern portion 115a and a fourth pattern portion 115b.

In each of the plurality of vibration parts 110-1, 110-2, 110-3, and 110-4, the first pattern portion 113a and the second pattern portion 113b may be configured at one periphery portion (or a first periphery portion) of the first surface 110s1 of each of the plurality of vibration parts 110-1, 110-2, 110-3, and 110-4. The first pattern portion 113a and the second pattern portion 113b may be configured at the first electrode layer 113 of each of the plurality of vibration parts 110-1, 110-2, 110-3, and 110-4 to have different shapes or different structures. For example, in each of the plurality of vibration parts 110-1, 110-2, 110-3, and 110-4, the first pattern portion 113a and the second pattern portion 113b may be configured at one lateral surface (or a first short side) of the first electrode layer 113 to have different shapes or different structures.

In each of the plurality of vibration parts 110-1, 110-2, 110-3, and 110-4, the first pattern portion 113a may protrude or extend from the one lateral surface of the first electrode layer 113 to one lateral surface (or a first short side) of the vibration layer 111. The first pattern portion 113a may protrude or extend to the one lateral surface of the vibration layer 111 to have a tetragonal shape (or rectangular shape) from the one lateral surface of the first electrode layer 113. For example, an end lateral surface (or an outer sidewall) of the first pattern portion 113a may be aligned at the one lateral surface of the vibration layer 111. Therefore, with respect to a third direction Z which is a thickness direction of the vibration generating part 110, the first pattern portions 113a of the plurality of vibration parts 110-1, 110-2, 110-3, and 110-4 may overlap with each other. For example, the first pattern portion 113a may be a first protrusion pattern, a first protrusion portion, a first extension pattern, a first extension portion, a first contact pattern, or a first contact pattern portion, but examples of the present disclosure are not limited thereto. It is to be noted that although FIGs. 1 to 6 show that the second pattern portion 113b and the fourth pattern portion 115b are included, but embodiments of the present disclosure are not limited thereto. For example, the second pattern portion 113b and the fourth pattern portion 115b such as only the first pattern portion 113a and the third pattern portion 115a protrude from the electrode layers respectively so as to be connected to the connection members respectively.

According to an example of the present disclosure, the first pattern portion 113a may protrude or extend from the one lateral surface of the first electrode layer 113 to the one lateral surface of the vibration layer 111 to have a first length L1 parallel to the first direction X and a first width W1 parallel to the second direction Y. For example, the first width W1 of the first pattern portion 113a may be equal to the first distance D1. For example, the first length L1 of the first pattern portion 113a may be greater than a third width W3 of the first connection member 118 parallel to the first direction X. For example, the first length L1 of the first pattern portion 113a may be two or more times the third width W3 of the first connection member 118, but examples of the present disclosure are not limited thereto.

In each of the plurality of vibration parts 110-1, 110-2, 110-3, and 110-4, the second pattern portion 113b may be spaced apart from the first pattern portion 113a and may be configured (or formed) concavely from the one lateral surface of the first electrode layer 113. The second pattern portion 113b may be configured (or formed) concavely from the one lateral surface of the first electrode layer 113 to have a tetragonal shape (or rectangular shape). The one lateral surface of the first electrode layer 113 may be removed in a tetragonal shape (or rectangular shape), and thus, the second pattern portion 113b may be configured (or formed) concavely from the one lateral surface of the first electrode layer 113. Therefore, with respect to the third direction Z which is the thickness direction of the vibration generating part 110, the second pattern portions 113b of the plurality of vibration parts 110-1, 110-2, 110-3, and 110-4 may overlap with each other. For example, the second pattern portion 113b may be a first concave pattern, a first concave portion, a first recess pattern, a first groove pattern, a first groove pattern portion, a first electrode removal portion, a first contact prevention pattern, or a first contact prevention pattern portion, but examples of the present disclosure are not limited thereto.

According to an example of the present disclosure, the second pattern portion 113b may be configured (or formed) concavely from the one lateral surface of the first electrode layer 113 to have a second length L2 parallel to the first direction X and a second width W2 parallel to the second direction Y. For example, the second width W2 of the second pattern portion 113b may be greater than or equal to the first distance D1 or the first width W1. For example, the second width W2 of the second pattern portion 113b may be two or more times the first distance D1, or may be two or more times the first width W1, but examples of the present disclosure are not limited thereto. For example, the second length L2 of the second pattern portion 113b may be greater than a fourth width W4 of the second connection member 119 parallel to the first direction X. For example, the second length L2 of the second pattern portion 113b may be greater, which is two or more times the fourth width W4 of the second connection member 119, but examples of the present disclosure are not limited thereto. For example, the second length L2 of the second pattern portion 113b may be equal to the first length L1 of the first pattern portion 113a, but examples of the present disclosure are not limited thereto.

In each of the plurality of vibration parts 110-1, 110-2, 110-3, and 110-4, the third pattern portion 115a and the fourth pattern portion 115b may be configured at one periphery portion (or a first periphery portion) of the second surface 110s2 of each of the plurality of vibration parts 110-1, 110-2, 110-3, and 110-4. The third pattern portion 115a and the fourth pattern portion 115b may be configured at the second electrode layer 115 of each of the plurality of vibration parts 110-1, 110-2, 110-3, and 110-4 to have different shapes or different structures. For example, in each of the plurality of vibration parts 110-1, 110-2, 110-3, and 110-4, the third pattern portion 115a and the fourth pattern portion 115b may be configured at one lateral surface (or a first short side) of the second electrode layer 115 to have different shapes or different structures. For example, the third pattern portion 115a may have a same shape or a same structure as that of the first pattern portion 113a and may correspond to or overlap the second pattern portion 113b. For example, the fourth pattern portion 115b may have a same shape or a same structure as that of the second pattern portion 113b and may correspond to or overlap the first pattern portion 113a.

In each of the plurality of vibration parts 110-1, 110-2, 110-3, and 110-4, the third pattern portion 115a may protrude or extend from the one lateral surface of the second electrode layer 115 to one lateral surface (or a first short side) of the vibration layer 111. The third pattern portion 115a may protrude or extend to the one lateral surface of the vibration layer 111 to have a tetragonal shape (or rectangular shape) from the one lateral surface of the second electrode layer 115. For example, an end lateral surface (or an outer sidewall) of the third pattern portion 115a may be aligned at the one lateral surface of the vibration layer 111. Therefore, with respect to the third direction Z which is the thickness direction of the vibration generating part 110, the third pattern portions 115a of the plurality of vibration parts 110-1, 110-2, 110-3, and 110-4 may overlap with each other. For example, the third pattern portion 115a may be a second protrusion pattern, a second protrusion portion, a second extension pattern, a second extension portion, a second contact pattern, or a second contact pattern portion, but examples of the present disclosure are not limited thereto.

According to an example of the present disclosure, the third pattern portion 115a may protrude or extend from the one lateral surface of the second electrode layer 115 to the one lateral surface of the vibration layer 111 to have a third length L3 parallel to the first direction X and the first width W1 parallel to the second direction Y. For example, the third length L3 of the third pattern portion 115a may be equal to the first length L1 of the first pattern portion 113a, but examples of the present disclosure are not limited thereto. For example, the third length L3 of the third pattern portion 115a may be greater than a fourth width W4 of the second connection member 119, but examples of the present disclosure are not limited thereto. For example, the third length L3 of the third pattern portion 115a may be two or more times the fourth width W4 of the second connection member 119, but examples of the present disclosure are not limited thereto.

In each of the plurality of vibration parts 110-1, 110-2, 110-3, and 110-4, the fourth pattern portion 115b may be spaced apart from the third pattern portion 115a and may be configured (or formed) concavely from the one lateral surface of the second electrode layer 115. The fourth pattern portion 115b may be configured (or formed) concavely from the one lateral surface of the second electrode layer 115 to have a tetragonal shape (or rectangular shape). The one lateral surface of the second electrode layer 115 may be removed in a tetragonal shape (or rectangular shape), and thus, the fourth pattern portion 115b may be configured (or formed) concavely from the one lateral surface of the second electrode layer 115. Therefore, with respect to the third direction Z which is the thickness direction of the vibration generating part 110, the fourth pattern portions 115b of the plurality of vibration parts 110-1, 110-2, 110-3, and 110-4 may overlap with each other. For example, the fourth pattern portion 115b may be a second concave pattern, a second concave portion, a second recess pattern, a second groove pattern, a second groove pattern portion, a second electrode removal portion, a second contact prevention pattern, or a second contact prevention pattern portion, but examples of the present disclosure are not limited thereto.

According to an example of the present disclosure, the fourth pattern portion 115b may be configured (or formed) concavely from the one lateral surface of the second electrode layer 115 to have a fourth length L4 parallel to the first direction X and the second width W2 parallel to the second direction Y. For example, the fourth length L4 of the fourth pattern portion 115b may be equal to the second length L2 of the second pattern portion 113b, but examples of the present disclosure are not limited thereto. For example, the fourth length L4 of the fourth pattern portion 115b may be greater than the third width W3 of the first connection member 118, but examples of the present disclosure are not limited thereto. For example, the fourth length L4 of the fourth pattern portion 115b may be greater, which is two or more times the third width W3 of the first connection member 118, but examples of the present disclosure are not limited thereto. For example, the fourth length L4 of the fourth pattern portion 115b may be equal to the third length L3 of the third pattern portion 115a, but examples of the present disclosure are not limited thereto.

According to an example of the present disclosure, the first electrode layer 113 of each of the plurality of vibration parts 110-1, 110-2, 110-3, and 110-4 may be formed to include the first and second pattern portions 113a and 113b on the first surface 111a of a sintered vibration layer 111 and may be fired (or cured) by a firing process (or a curing process), but examples of the present disclosure are not limited thereto. The second electrode layer 115 of each of the plurality of vibration parts 110-1, 110-2, 110-3, and 110-4 may be formed to include the third and fourth pattern portions 115a and 115b on the second surface 111b of the sintered vibration layer 111 and may be fired (or cured) by a firing process (or a curing process), but examples of the present disclosure are not limited thereto. The first electrode layer 113 and the second electrode layer 115 may be fired (or cured) by a firing temperature (or a curing temperature) of 650 degrees C or less, but examples of the present disclosure are not limited thereto. Therefore, the first electrode layer 113 and the second electrode layer 115 may be fired (or cured) by a relatively low firing temperature (or curing temperature), and thus, the first electrode layer 113 and the second electrode layer 115 may include (or configured as) a low-price electrode material (or substance). For example, when the first electrode layer 113 and the second electrode layer 115 are configured as a low-price electrode material (or substance), the manufacturing cost of the plurality of vibration parts 110-1, 110-2, 110-3, and 110-4 or the vibration apparatus 100 may be reduced.

With reference to FIGs. 2 to 4, the plurality of insulation members 117-1, 117-2, and 117-3 may be configured to be electrically insulated (or separated or disconnected) from the plurality of vibration parts 110-1, 110-2, 110-3, and 110-4. The plurality of insulation members 117-1, 117-2, and 117-3 may be disposed (or interposed) or adhered between the plurality of vibration parts 110-1, 110-2, 110-3, and 110-4. For example, each of the plurality of insulation members 117-1, 117-2, and 117-3 may be disposed (or interposed) or adhered between a second electrode layer 115 of an upper vibration part and a first electrode layer 113 of a lower vibration part of two vibration parts vertically adjacent to each other among the plurality of vibration parts 110-1, 110-2, 110-3, and 110-4.

According to an example of the present disclosure, when the vibration apparatus 100 or the vibration generating part 110 includes first to fourth vibration parts 110-1, 110-2, 110-3, and 110-4 and first to third insulation members 117-1, 117-2, and 117-3, the first insulation member 117-1 may be disposed (or interposed) or adhered between a second electrode layer 115 of the first vibration part 110-1 and a first electrode layer 113 of the second vibration part 110-2, the second insulation member 117-2 may be disposed (or interposed) or adhered between a second electrode layer 115 of the second vibration part 110-2 and a first electrode layer 113 of the third vibration part 110-3, and the third insulation member 117-3 may be disposed (or interposed) or adhered between a second electrode layer 115 of the third vibration part 110-3 and a first electrode layer 113 of the fourth vibration part 110-4.

The plurality of vibration parts 110-1, 110-2, 110-3, and 110-4 may be vertically stacked by the plurality of insulation members 117-1, 117-2, and 117-3. The plurality of vibration parts 110-1, 110-2, 110-3, and 110-4 may be configured to be stacked or overlapped with corresponding insulation members 117-1, 117-2, and 117-3 therebetween. For example, the insulation members 117-1, 117-2, and 117-3 may be an inner insulation member, a middle insulation member, a middle adhesive member, a middle connection member, or a middle coupling member, but examples of the present disclosure are not limited thereto.

According to an example of the present disclosure, each of the plurality of insulation members 117-1, 117-2, and 117-3 may be configured to surround lateral surfaces (or outer sidewalls) of each of the second electrode layer 115 of the upper vibration part and the first electrode layer 113 of the lower vibration part of two vibration parts vertically adjacent to each other among the plurality of vibration parts 110-1, 110-2, 110-3, and 110-4. For example, the first insulation member 117-1 may be configured to cover or surround the other portion except the third pattern part 115a of the second electrode layer 115 at the first vibration part 110-1 and the first pattern portion 113a of the first electrode layer 113 at the second vibration part 110-2. The second insulation member 117-2 may be configured to cover or surround the other portion except the third pattern portion 115a of the second electrode layer 115 at the second vibration part 110-2 and the first pattern portion 113a of the first electrode layer 113 at the third vibration part 110-3. The third insulation member 117-3 may be configured to cover or surround the other portion except the third pattern portion 115a of the second electrode layer 115 at the third vibration portion 110-3 and the first pattern portion 113a of the first electrode layer 113 at the fourth vibration part 110-4.

Each of the plurality of insulation members 117-1, 117-2, and 117-3 may include an electrically insulating material which has adhesiveness. Each of the plurality of insulation members 117-1, 117-2, and 117-3 may include an adhesive material having electrical insulating characteristic. For example, the plurality of insulation members 117-1, 117-2, and 117-3 may be configured as an adhesive material including an adhesive layer which is good in adhesive force or attaching force with respect to each of the plurality of vibration parts 110-1, 110-2, 110-3, and 110-4 stacked vertically.

According to an example of the present disclosure, to electrically and completely insulate (or isolate or separate) between the plurality of vibration parts 110-1, 110-2, 110-3, and 110-4, each of the plurality of insulation members 117-1 to 117-3 may include a material having a volume resistance (or resistivity) which is higher than a volume resistance (or resistivity) of the vibration layer 111.

Each of the plurality of insulation members 117-1, 117-2, and 117-3 according to an example of the present disclosure may include a foam pad, a single-sided tape, a double-sided tape, a single-sided foam pad, a double-sided foam pad, a single-sided foam tape, a double-sided foam tape, an adhesive, an adhesive film, or a solution type adhesive, or the like, but examples of the present disclosure are not limited thereto. For example, an adhesive layer of the plurality of insulation members 117-1, 117-2, and 117-3 may include epoxy-based, acrylic-based, silicone-based, or urethane-based, but examples of the present disclosure are not limited thereto. The adhesive layer of each of the plurality of insulation members 117-1, 117-2, and 117-3 may include a urethane-based material (or substance) which relatively has a ductile characteristic than that of acrylic. Accordingly, in the vibration apparatus 100 or the vibration generating part 110 according to an example of the present disclosure, the vibration loss caused by displacement interference between the plurality of vibration parts 110-1, 110-2, 110-3, and 110-4 may be minimized or reduced, or each of the plurality of vibration parts 110-1, 110-2, 110-3, and 110-4 may be freely displaced.

Each of the plurality of insulation members 117-1, 117-2, and 117-3 according to another example of the present disclosure may include one or more of a thermo-curable adhesive, a photo-curable adhesive, a thermal bonding adhesive (or a hot melt adhesive or thermosetting adhesive), and PSA (pressure sensitive adhesive), OCA (optically cleared adhesive), and OCR (optically cleared resin), but examples of the present disclosure are not limited thereto. For example, each of the plurality of insulation members 117-1, 117-2, and 117-3 may include the thermal bonding adhesive (or hot melt adhesive). The thermal bonding adhesive may be a heat-active type or a thermo-curable type. For example, the insulation members 117-1, 117-2, and 117-3 including the thermal bonding adhesive may attach or couple two adjacent vibration parts 110-1, 110-2, 110-3, and 110-4 by heat and pressure. For example, the insulation members 117-1, 117-2, and 117-3 including the thermal bonding adhesive may minimize or reduce the loss of vibration of the vibration apparatus 100 or the vibration generating part 110.

According to an example of the present disclosure, the plurality of vibration parts 110-1, 110-2, 110-3, and 110-4 according to another example of the present disclosure may be integrated as one structure (or a component or one part) by a laminating process by the plurality of insulation members 117-1, 117-2, and 117-3. For example, the plurality of vibration parts 110-1, 110-2, 110-3, and 110-4 may be integrated as one structure (or a laminated piezoelectric element material or a layered piezoelectric element material) by a laminating process by a roller, but examples of the present disclosure are not limited thereto.

With reference to FIGs. 2, 3, and 5, the first connection member 118 may be electrically connected to the first pattern portion 113a of each of the plurality of vibration parts 110-1, 110-2, 110-3, and 110-4. The first connection member 118 may be configured to be electrically insulated from the fourth pattern portion 115b of each of the plurality of vibration parts 110-1, 110-2, 110-3, and 110-4. For example, the first connection member 118 may be configured at one lateral surface (or an outer sidewall) of the vibration generating part 110 and may be electrically connected to one lateral surface (or an outer sidewall) of the first pattern portion 113a and one lateral surface (or a first short side) of the vibration layer 111 of each of the plurality of vibration parts 110-1, 110-2, 110-3, and 110-4. The first connection member 118 may include a conductive material (or substance), to electrically connect the first pattern portions 113a at each of the plurality of vibration parts 110-1, 110-2, 110-3, and 110-4 with each other.

The first electrode layer 113 of each of the plurality of vibration parts 110-1, 110-2, 110-3, and 110-4 may be electrically or commonly connected to a corresponding first pattern portion 113a through (or by) the first connection member 118. Therefore, the first electrode layer 113 of each of the plurality of vibration parts 110-1, 110-2, 110-3, and 110-4 may receive a same driving signal (or sound signal or voice signal) through (or by) the first connection member 118 in common. The first connection member 118 may be electrically isolated (or insulated) from the second electrode layer 115 of each of the plurality of vibration parts 110-1, 110-2, 110-3, and 110-4. For example, the first connection member 118 may be electrically isolated (or insulated) from the second electrode layer 115 of each of the plurality of vibration parts 110-1, 110-2, 110-3, and 110-4 by the insulation members 117-1, 117-2, and 117-3.

With reference to FIGs. 2, 3, and 6, the second connection member 119 may be electrically connected to the third pattern portion 115a of each of the plurality of vibration parts 110-1, 110-2, 110-3, and 110-4. The second connection member 119 may be configured to be electrically isolated (or insulated) from the second pattern portion 113b of each of the plurality of vibration parts 110-1, 110-2, 110-3, and 110-4. For example, the second connection member 119 may be configured at one lateral surface (or an outer sidewall) of the vibration generating part 110 spaced apart from the first connection member 118 and may be electrically connected to one lateral surface (or an outer sidewall) of the third pattern portion 115a and the one lateral surface (or the first short side) of the vibration layer 111 of each of the plurality of vibration parts 110-1, 110-2, 110-3, and 110-4. The second connection member 119 may include a conductive material (or substance), to electrically connect the third pattern portions 115a at the plurality of vibration parts 110-1, 110-2, 110-3, and 110-4 with each other.

The second electrode layer 115 of each of the plurality of vibration parts 110-1, 110-2, 110-3, and 110-4 may be electrically or commonly connected to a corresponding third pattern portion 115a through (or by) the second connection member 119. Therefore, the second electrode layer 115 of each of the plurality of vibration parts 110-1, 110-2, 110-3, and 110-4 may receive a same driving signal (or sound signal or voice signal) through (or by) the second connection member 119 in common. The second connection member 119 may be electrically isolated (or insulated) from the first electrode layer 113 of each of the plurality of vibration parts 110-1, 110-2, 110-3, and 110-4. For example, the second connection member 119 may be electrically isolated (or insulated) from the first electrode layer 113 of each of the plurality of vibration parts 110-1, 110-2, 110-3, and 110-4 by the insulation members 117-1, 117-2, and 117-3.

According to an example of the present disclosure, each of the first connection member 118 and the second connection member 119 may include a thermos-curable electrode material, a photo-curable (or ultraviolet (UV)-curable) electrode material, or a conductive adhesive. For example, the conductive adhesive may include a conductive epoxy resin, a conductive acrylic resin, a conductive silicone resin, or a conductive urethane resin, but examples of the present disclosure are not limited thereto. For example, the first connection member 117 and the second connection member 119 may be a conductive single-sided tape, a conductive single-sided adhesive pad, a conductive single-sided cushion tape, a conductive double-sided tape, a conductive double-sided adhesive pad, or a conductive double-sided cushion tape, but examples of the present disclosure are not limited thereto.

According to an example of the present disclosure, the vibration layer 111 of each of the plurality of vibration parts 110-1, 110-2, 110-3, and 110-4 may be simultaneously polarized (or poled) by a voltage applied to the first electrode layer 113 of each of the plurality of vibration parts 110-1, 110-2, 110-3, and 110-4 through (or by) the first connection member 118 in common and a voltage applied to the second electrode layer 115 of each of the plurality of vibration parts 110-1, 110-2, 110-3, and 110-4 through (or by) the second connection member 119 in common, at a temperature atmosphere which is changed from a certain temperature atmosphere or a high temperature to a room temperature, but examples of the present disclosure are not limited thereto. The first electrode layer 113 and the second electrode layer 115 of each of the plurality of vibration parts 110-1, 110-2, 110-3, and 110-4 may be spaced apart from the one lateral surface (or the outer sidewall) of the vibration layer 111 by the first distance D1 and the second distance D2, and thus, in a polarization process (or a poling process), electrical short circuit between the first electrode layer 113 and the second electrode layer 115 may be prevented or reduced.

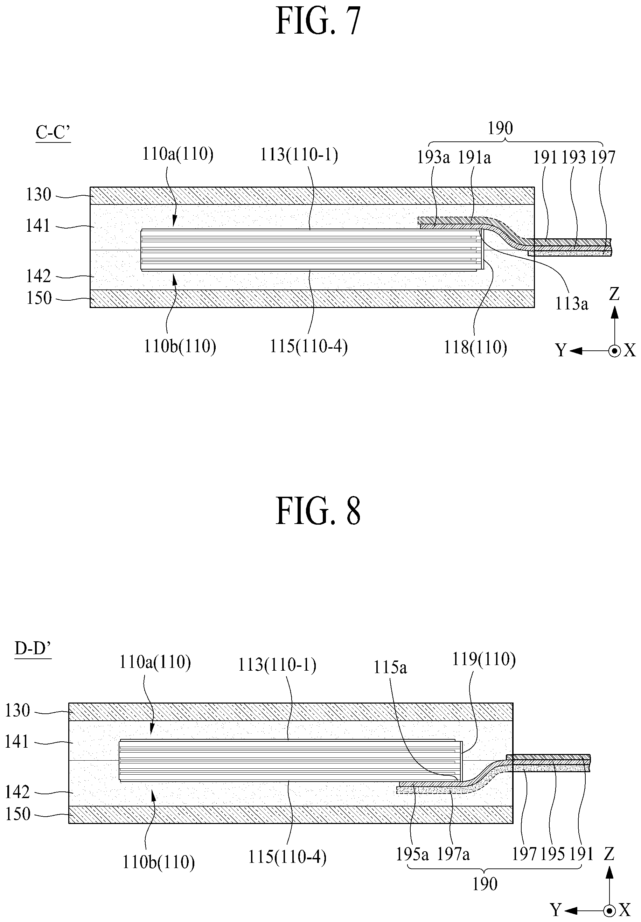

FIG. 7 is a cross-sectional view taken along line C-C' illustrated in FIG. 1 according to an example of the present disclosure. FIG. 8 is a cross-sectional view taken along line D-D' illustrated in FIG. 1 according to an example of the present disclosure.

With reference to FIGs. 1, 7, and 8, the vibration apparatus 100 according to an example of the present disclosure may further include a first cover member 130 and a second cover member 150.

The vibration generating part 110 may be disposed between the first cover member 130 and the second cover member 150. The first cover member 130 may be disposed at a first surface 110a of the vibration generating part 110. For example, the first cover member 130 may be configured to cover the first surface 110a of the vibration generating part 110. The first cover member 130 may be configured to cover the first vibration part 110-1 or the first electrode layer 13 of the first vibration part 110-1 of the plurality of vibration parts 110-1, 110-2, 110-3, and 110-4. For example, the first cover member 130 may be configured to have a significantly greater size than the vibration generating part 110 or the first surface 110a of the vibration generating part 110. Therefore, the first cover member 130 may protect the first surface 110a of the vibration generating part 110, or may protect the first electrode layer 113 of the first vibration part 110-1.

The second cover member 150 may be disposed at the second surface 110b of the vibration generating part 110. For example, the second cover member 150 may be configured to cover the second surface 110b of the vibration generating part 110. The second cover member 150 may be configured to cover the fourth vibration part 110-4 or the first electrode layer 13 of the fourth vibration part 110-4 of the plurality of vibration parts 110-1, 110-2, 110-3, and 110-4. For example, the second cover member 150 may be configured to have a significantly greater size than the vibration generating part 110 or the second surface 110b of the vibration generating part 110, or may be configured to have a same size as the first cover member 130. Therefore, the second cover member 150 may protect the second surface 110b of the vibration generating part 110, or may protect the second electrode layer 115 of the fourth vibration part 110-4.

Each of the first cover member 130 and the second cover member 150 according to an example of the present disclosure may each include one or more material of plastic, fiber, cloth, paper, leather, rubber, carbon, and wood, but examples of the present disclosure are not limited thereto. For example, each of the first cover member 130 and the second cover member 150 may include a same material or a different material. For example, each of the first cover member 130 and the second cover member 150 may be a polyimide (PI) film, a polyethylene terephthalate (PET) film, or a polyethylene naphthalate (PEN) film, but examples of the present disclosure are not limited thereto.

One or more of the first cover member 130 and the second cover member 150 according to an example of the present disclosure may include an adhesive member. For example, one or more of the first cover member 130 and the second cover member 150 may include adhesive layers 141 and 142 which is coupled or attached to the vibration generating part 110. For example, the adhesive layers 141 and 142 may include an electrical insulation material which has adhesiveness and is capable of compression and decompression. For example, the first cover member 130 may include an adhesive layer 141 which is coupled or attached to the first surface 110a of the vibration generating part 110 or the first electrode layer 113 of the first vibration part 110-1.

The first cover member 130 may be connected or coupled to the first surface 110a of the vibration generating part 110 or the first electrode layer 113 of the first vibration part 110-1 by a first adhesive layer 141. For example, the first cover member 130 may be connected or coupled to the first surface 110a of the vibration generating part 110 or the first electrode layer 113 of the first vibration part 110-1 by a film laminating process using the first adhesive layer 141.

The second cover member 150 may be connected or coupled to the second surface 110b of the vibration generating part 110 or the second electrode layer 115 of the fourth vibration part 110-4 by a second adhesive layer 142. For example, the second cover member 150 may be connected or coupled to the second surface 110b of the vibration generating part 110 or the second electrode layer 115 of the fourth vibration part 110-4 by a film laminating process using the second adhesive layer 142.

The first adhesive layer 141 may be disposed or filled between the first cover member 130 and the first surface 110a of the vibration generating part 110. The second adhesive layer 142 may be disposed or filled between the second cover member 150 and the second surface 110b of the vibration generating part 110. Accordingly, the vibration generating part 110 may be surrounded by the first adhesive layer 141 and the second adhesive layer 142 at a region between the first cover member 130 and the second cover member 150. For example, the first adhesive layer 141 and the second adhesive layer 142 may be configured as one adhesive layer at a region between the first cover member 130 and the second cover member 150, and thus, the vibration generating part 110 may be built-in or embedded between the first adhesive layer 141 and the second adhesive layer 142.

Each of the first adhesive layer 141 and the second adhesive layer 142 according to an example of the present disclosure may include an electrical insulation material which has adhesiveness and is capable of compression and decompression. For example, each of the first adhesive layer 141 and the second adhesive layer 142 may include an epoxy resin, an acrylic resin, a silicone resin, or a urethane resin, but examples of the present disclosure are not limited thereto.

With reference to FIGs. 1, 2, 7, and 8, the vibration apparatus 100 according to an example of the present disclosure may further include a signal supply member 190.

The signal supply member 190 may be configured to be electrically connected to the vibration generating part 110 at one side of the vibration generating part 110. The signal supply member 190 may be configured to be electrically connected to the first connection member 118 and the second connection member 119 at one side of the vibration generating part 110. The signal supply member 190 may be configured to be electrically connected to the first surface 110a and the second surface 110b of the vibration generating part 110 at one side of the vibration generating part 110. The signal supply member 190 may be configured to be electrically connected to the first surface 110a and the second surface 110b of the vibration generating part 110, between the first cover member 130 and the second cover member 150. The signal supply member 190 may be configured to be electrically connected to the electrode layer at the first surface 110a of the vibration generating part 110 and the electrode layer at the second surface 110b of the vibration generating part 110. The signal supply member 190 may be configured to be electrically connected to the first electrode layer 113 of the first vibration part 110-1 of the vibration generating part 110 and the second electrode layer 115 of the fourth vibration part 110-4 of the vibration generating part 110.

A portion of the signal supply member 190 may be disposed at or inserted (or accommodated) into a portion between one periphery portion of the first cover member 130 and one periphery portion of the second cover member 150. The one periphery portion of the first cover member 130 and the one periphery portion of the second cover member 150 may accommodate a portion of the signal supply member 190, or may vertically cover the portion of the signal supply member 190. Accordingly, the signal supply member 190 may be integrated with the vibration generating part 110. For example, the vibration apparatus 100 according to the first example of the present disclosure may be a vibration apparatus which is integrated with the signal supply member 190. The portion of the signal supply member 190 may be inserted (or accommodated) and fixed between the first cover member 130 and the second cover member 150, and thus, a contact defect between the vibration generating part 110 and the signal supply member 190 caused by the movement of the signal supply member 190 may be prevented or reduced. For example, the signal supply member 190 may be a signal cable, a cable member, a flexible cable, a flexible printed circuit cable, a flexible flat cable, a single-sided flexible printed circuit, a single-sided flexible printed circuit board, a flexible multilayer printed circuit, or a flexible multilayer printed circuit board, but examples of the present disclosure are not limited thereto.

The signal supply member 190 according to an example of the present disclosure may include a base member (or base film) 191 and a plurality of signal lines 193 and 195. For example, the signal supply member 190 may include a base member 191, a first signal line 193, a second signal line 195, and an insulation film 197.

The base member 191 may include a transparent or opaque plastic material. For example, the base member 191 may be a flexible film, a base insulation film, or a base member. The base film 191 may have a certain width along a first direction X and may extend long along a second direction Y intersecting with the first direction X.

Each of the first and second signal lines (or a plurality of signal lines) 193 and 195 may be disposed at a first surface of the base member 191 in parallel with the second direction Y and may be spaced apart from or electrically separated from one another along the first direction X. Each of the first and second signal lines 193 and 195 may be disposed in parallel to each other at the first surface of the base member 191. For example, each of the first and second signal lines 193 and 195 may be implemented in a line shape through (or by) patterning of a metal layer (or a conductive layer) which is formed or deposited at the first surface of the base member 191.

The insulation film 197 may be disposed at the first surface of the base member 191 to cover each of the first and second signal lines 193 and 195. Each of the first and second signal lines (or a plurality of signal lines) 193 and 195 may be disposed between the base member 191 and the insulation film 197. The insulation film 197 may be a protection film, a cover layer film, a cover film, or a cover insulation film, but examples of the present disclosure are not limited thereto.

The first signal line 193 may be disposed between the first cover member 130 and the vibration generating part 110 and may be electrically connected to the first connection member 118 and the first pattern portion 113a at the first vibration part 110-1 of the vibration generating part 110. The end portion (or one side) 193a of the first signal line 193 may be electrically connected to the first surface 110a of the vibration generating part 110, between the first surface 110a of the vibration generating part 110 and the first cover member 130. The end portion (or one side) 193a of the first signal line 193 may be electrically connected to the first electrode layer 113 of the first vibration part 110-1 of the vibration generating part 110, between the first surface 110a of the vibration generating part 110 and the first cover member 130. The end portion (or one side) 193a of the first signal line 193 may be electrically connected to a portion of the first electrode layer 113 of the first vibration part 110-1 and the first pattern portion 113a. The end portion (or one side) 193a of the first signal line 193 may be electrically connected to the portion of the first electrode layer 113 of the first vibration part 110-1, the first pattern portion 113a, and an upper surface of the first connection member 118. Accordingly, a driving signal (or a first driving signal) supplied from a vibration driving circuit may be supplied to the first electrode layer 113 of the first vibration part 110-1 of the vibration generating part 110 through (or by) the first signal line 193 and may be commonly supplied to the first electrode layer 113 of each of the other vibration part 110-1, 110-2, and 110-3 of the vibration generating part 110 through (or by) the first connection member 118. For example, the end portion (or one side) 193a of the first signal line 193 may be a first electrode connection portion or a first electrode contact portion.

The second signal line 195 may be disposed between the second cover member 150 and the vibration generating part 110 and may be electrically connected to the second connection member 119 and the third pattern portion 115a at the fourth vibration part 110-4 of the vibration generating part 110. The end portion (or one side) 195a of the second signal line 195 may be electrically connected to the second surface 110b of the vibration generating part 110, between the second surface 110b of the vibration generating part 110 and the second cover member 150. The end portion (or one side) 195a of the second signal line 195 may be electrically connected to the second electrode layer 115 of the fourth vibration part 110-4 of the vibration generating part 110, between the second surface 110b of the vibration generating part 110 and the second cover member 150. The end portion (or one side) 195a of the second signal line 195 may be electrically connected to a portion of the second electrode layer 115 of the fourth vibration part 110-4 and the third pattern portion 115a. The end portion (or one side) 195a of the second signal line 195 may be electrically connected to the portion of the second electrode layer 115 of the fourth vibration part 110-4, the third pattern portion 115a, and an upper surface of the second connection member 119. Accordingly, a driving signal (or a second driving signal) supplied from a vibration driving circuit may be supplied to the second electrode layer 115 of the fourth vibration part 110-4 of the vibration generating part 110 through (or by) the second signal line 195 and may be commonly supplied to the second electrode layer 115 of each of the other vibration part 110-1, 110-2, and 110-3 of the vibration generating part 110 through (or by) the second connection member 119. For example, the end portion (or one side) 195a of the second signal line 195 may be a second electrode connection portion or a second electrode contact portion.

According to another example of the present disclosure, the end portion 193a of the first signal line 193 may not covered by the insulation film 197 and may be supported by an extension portion 191a of the base film 191, but examples of the present disclosure are not limited thereto. For example, the extension portion 191a of the base film 191 illustrated by a dotted line in FIG. 7 may be removed. For example, the end portion 193a of the first signal line 193 may protrude or extend to have a certain length from the end portion of the base film 191 without being supported or covered by the base film 191 and the insulation film 197. Accordingly, the end portion 193a of the first signal line 193 may be bent. For example, the end portion (or one side) 193a of the first signal line 193 which is not supported by the base film 191 and the insulation film 197 may be a first protrusion line, a first protrusion electrode, a first conductive protrusion line, a first flexible protrusion line, or a first flexible protrusion electrode, but examples of the present disclosure are not limited thereto.

According to another example of the present disclosure, the end portion (or one side) 195a of the second signal line 195 may not covered by the base film 191 and may be supported by an extension portion 197a of the insulation film 197, but examples of the present disclosure are not limited thereto. For example, the extension portion 197a of the insulation film 197 illustrated by a dotted line in FIG. 7 may be removed. For example, the end portion (or one side) 195a of the second signal line 195 may protrude or extend to have a certain length from the end portion (or one side) of the insulation film 197 without being supported or covered by the base film 191 and the insulation film 197. Accordingly, the end portion (or one side) 195a of the second signal line 195 may be bent. For example, the end portion (or one side) 195a of the second signal line 195 which is not supported by the base film 191 and the insulation film 197 may be a second protrusion line, a second protrusion electrode, a second conductive protrusion line, a second flexible protrusion line, or a second flexible protrusion electrode, but examples of the present disclosure are not limited thereto.

With reference to FIGs. 2, 7, and 8, the plurality of vibration parts 110-1 to 110-4 configured at the vibration generating part 110 may be displaced (or vibrated) in the same direction by a first driving signal applied to a corresponding first electrode layer 113 through (or by) the first signal line 193 and the first connection member 118 in common and a second driving signal applied to a corresponding second electrode layer 115 through (or by) the second signal line 195 and the second connection member 119 in common, and thus, a vibration width (or displacement width) of the vibration generating part 110 may be maximized, thereby enhancing a sound pressure level.

The vibration apparatus 100 according to an example of the present disclosure may include the plurality of vibration parts 110-1 to 110-4 which are stacked or overlap to be displaced in the same direction, thereby enhancing a sound pressure level characteristic of a sound and a sound characteristic of a middle-low pitched sound band generated based on a vibration of the vibration generating part 110 or the vibration apparatus 100. A soldering process for an electrical connection between the vibration generating part 110 and the signal supply member 190 may not be needed, and thus, a manufacturing process and a structure of the vibration apparatus 100 may be simplified. The vibration apparatus 100 with the signal supply member 190 integrated therein may be provided, and thus, the signal supply member 190 and the vibration generating part 110 may be configured as one part, thereby realizing a uni-materialization effect. Because the electrode layers 113 and 115 of each of the plurality of vibration parts 110-1 to 110-4 include a low-price electrode material, the manufacturing cost of the vibration apparatus 100 may decrease, and a process yield rate may increase.

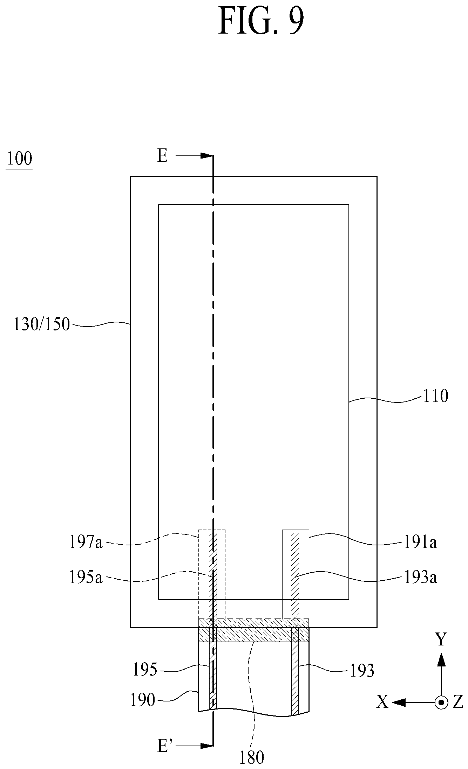

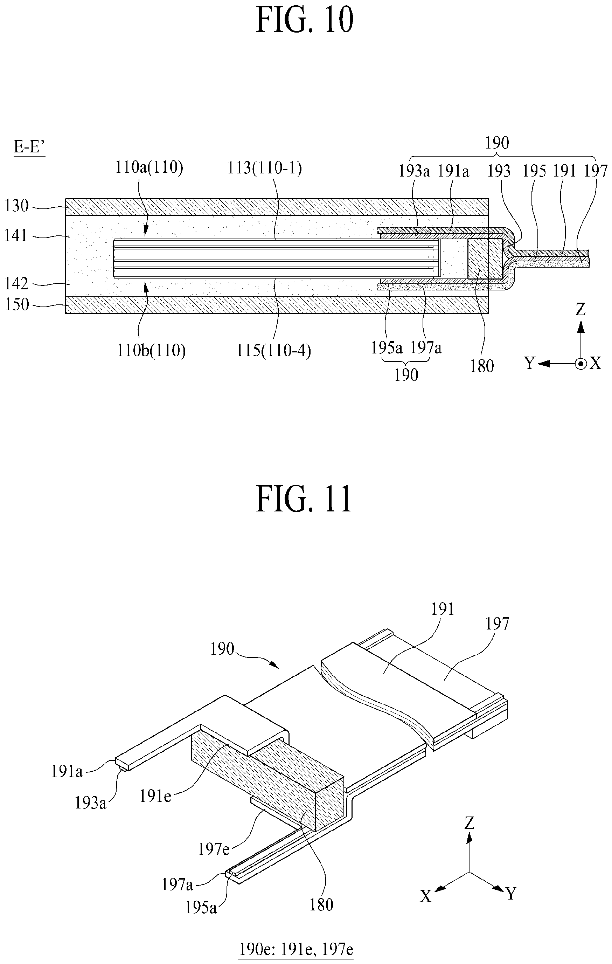

FIG. 9 illustrates a vibration apparatus according to another example of the present disclosure. FIG. 10 is a cross-sectional view as a cross-sectional surface taken along line E-E' illustrated in FIG. 9 according to an example of the present disclosure is seen from a side. FIG. 11 is a perspective view illustrating a pad member and a signal supply member illustrated in FIGs. 9 and 10 according to an example of the present disclosure. FIGs. 9 to 11 illustrate an example where a pad member is additionally configured at the vibration apparatus according to an example of the present disclosure illustrated in FIGs. 1 to 8. In the following description, therefore, a pad member and relevant elements will be only described, the other elements may be referred to by same reference numerals as FIGs. 1 to 8, and repeated descriptions may be omitted or may be briefly provided.

With reference to FIGs. 9 to 11, a vibration apparatus 100 according to another example of the present disclosure may further include a pad member 180.

The inventors of the present disclosure have recognized that a crack occurs in a vibration generating part 110, in (or during) a film laminating process of integrating a first adhesive layer 141, a second adhesive layer 142, a first cover member 130, a second cover member 150, and a first signal line 193 and a second signal line 195 of a signal supply member 190 as one body. The inventors of the present disclosure have recognized that a relatively large load is applied to a center portion of the vibration generating part 110 due to a thickness of the first adhesive layer 141, a thickness of the second adhesive layer 142, and a thickness of the vibration generating part 110 including a plurality of vibration parts 110-1 to 110-4 which are vertically stacked, in (or during) a film laminating process, and thus, a crack occurs in the vibration generating part 110 due to a position difference of a contact region between the vibration generating part 110 and each of the first signal line 193a and the second signal line 195.

The pad member 180 may be configured to prevent, reduce, or minimize the damage or crack of the vibration generating part 110, in (or during) a film laminating process. For example, the pad member 180 may be formed to absorb or decrease a load applied to a center portion of the vibration generating part 110 in (or during) a film laminating process. For example, the pad member 180 may be a step height compensation member, a supporting member, a middle member, an intermediate member, or a buffer member, but examples of the present disclosure are not limited thereto.

The pad member 180 according to an example of the present disclosure may be disposed (or configured) at the signal supply member 190 to be disposed (or accommodated) between the first cover member 130 and the second cover member 150. For example, at least a portion of the pad member 180 may be disposed between the first cover member 130 and the second cover member 150. For example, the pad member 180 may be disposed (or configured) at a portion of the signal supply member 190 disposed (or accommodated) between the first cover member 130 and the second cover member 150. For example, the pad member 180 may be disposed (or configured) at an end portion 190e of the signal supply member 190 disposed (or accommodated) between the first cover member 130 and the second cover member 150.

The pad member 180 according to an example of the present disclosure may be disposed (or interposed) between a base film 191 of the signal supply member 190 and an insulation film 197. The pad member 180 may be disposed (or interposed) between an end portion (or one side) 191e of the base film 191 and an end portion (or one side) 197e of the insulation film 197.

According to an example of the present disclosure, the end portion (or one side) 191e of the base film 191 and the end portion (or one side) 197e of the insulation film 197 may be disposed to be staggered with the pad member 180 therebetween. For example, a partial region (or one half region), including the first signal line 193 and an extension portion 191a, of the end portion (or one side) 191e of the base film 191 may be disposed on a first surface (or an upper surface) of the pad member 180. A partial region (or one half region), including the second signal line 195 and an extension portion 197a, of the end portion 197e of the insulation film 197 may be disposed on a second surface (or a lower surface) of the pad member 180.

According to an example of the present disclosure, the other region (or the other half region), except the partial region (or one half region), of the end portion (or one side) 191e of the base film 191 may be removed from the base film 191 so that the first signal line 193 and the extension portion 191a of the base film 191 may be disposed on the first surface of the pad member 180. For example, the other region (or the other half region), including a region overlapping the second signal line 195, of the end portion (or one side) 191e of the base film 191 may be removed. For example, the other region (or the other half region), except the partial region (or one half region), of the end portion (or one side) 197e of the insulation film 197 may be removed from the insulation film 197 so that the second signal line 195 and the extension portion 197a of the insulation film 197 may be disposed on the second surface of the pad member 180. For example, the other region (or the other half region), including a region overlapping the first signal line 193, of the end portion (or one side) 197e of the insulation film 197 may be removed.

According to an example of the present disclosure, the pad member 180 may be configured to have a thickness corresponding to the thickness of the vibration generating part 110. For example, an end portion (or one side) 190e of the signal supply member 190 where the pad member 180 is disposed (or interposed) may have a same thickness as that of the vibration generating part 110.

According to an example of the present disclosure, a portion of the pad member 180 or a portion of the end portion (or one side) 190e of the signal supply member 190 where the pad member 180 is disposed (or interposed) may be disposed (or accommodated) between the first cover member 130 and the second cover member 150. The other portion of the pad member 180 or the other portion of the end portion (or one side) 190e of the signal supply member 190 where the pad member 180 is disposed (or interposed) may be exposed at the outside.

The vibration apparatus 100 according to another example of the present disclosure may have a same effect as that of the vibration apparatus 100 described above with reference to FIGs. 1 to 8 and may further include the pad member 180, thereby preventing, reducing, or minimizing the damage or crack of the vibration generating part 110 caused by a position difference of a contact region between the vibration generating part 110 and each of the first and second signal lines 193 and 195 in (during) a film laminating process.

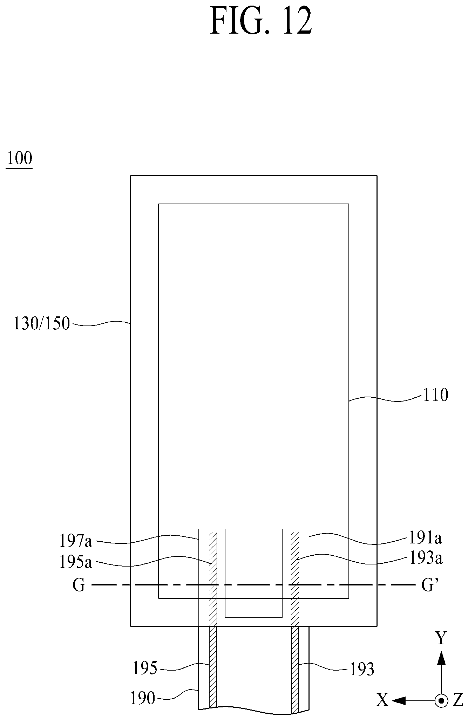

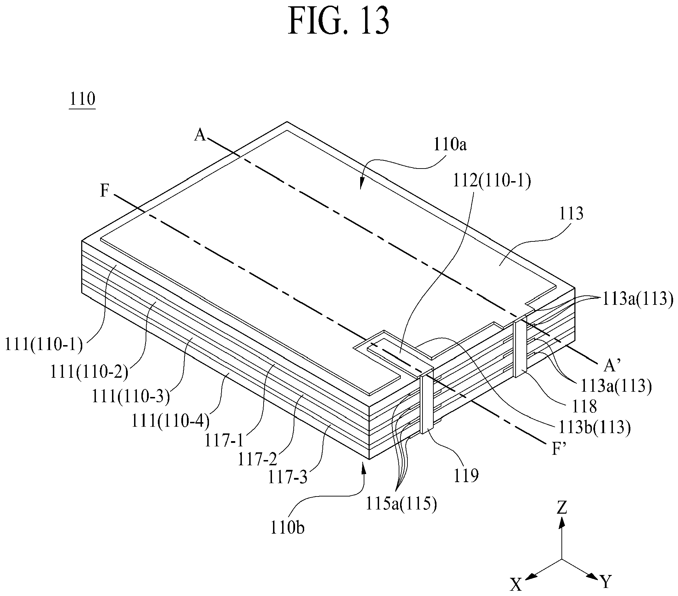

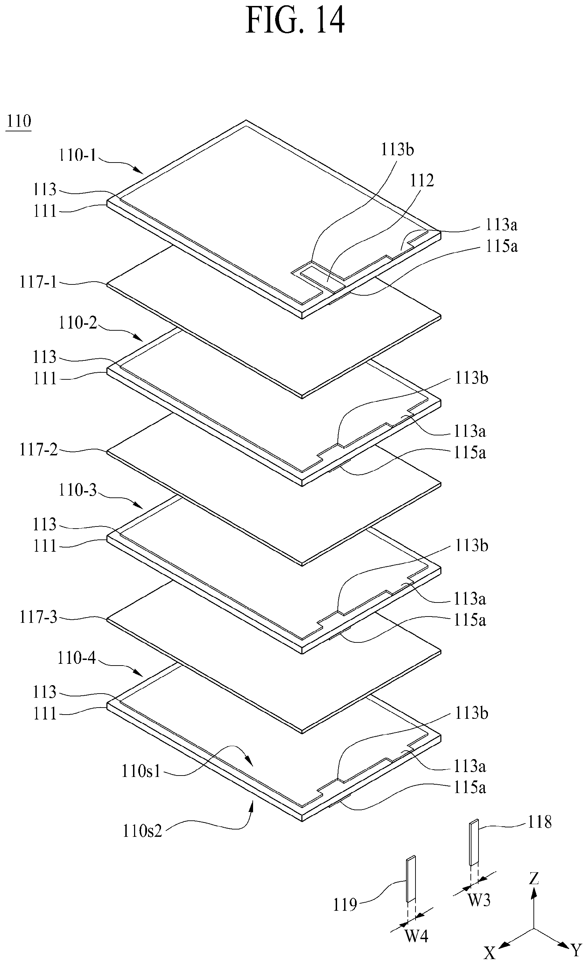

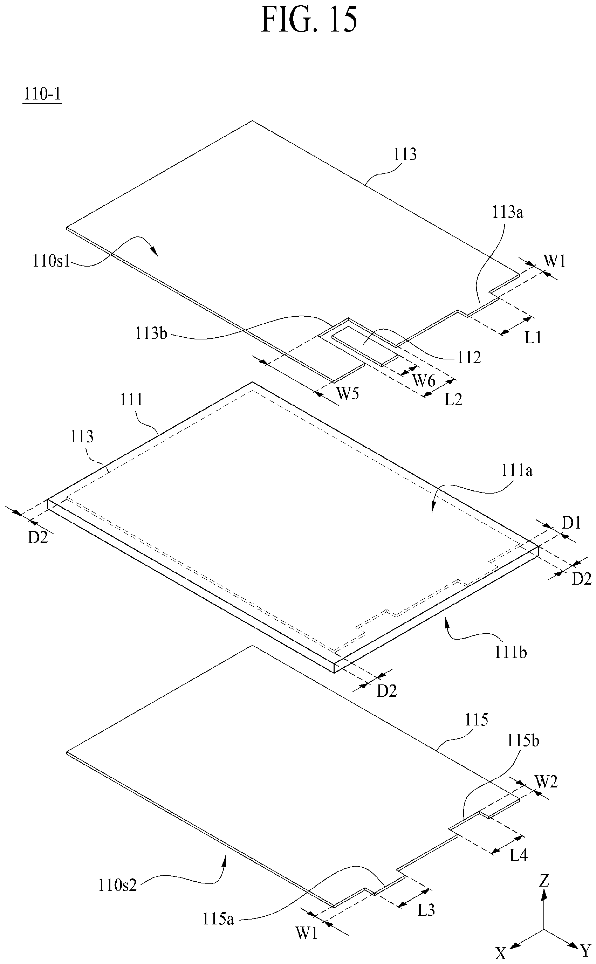

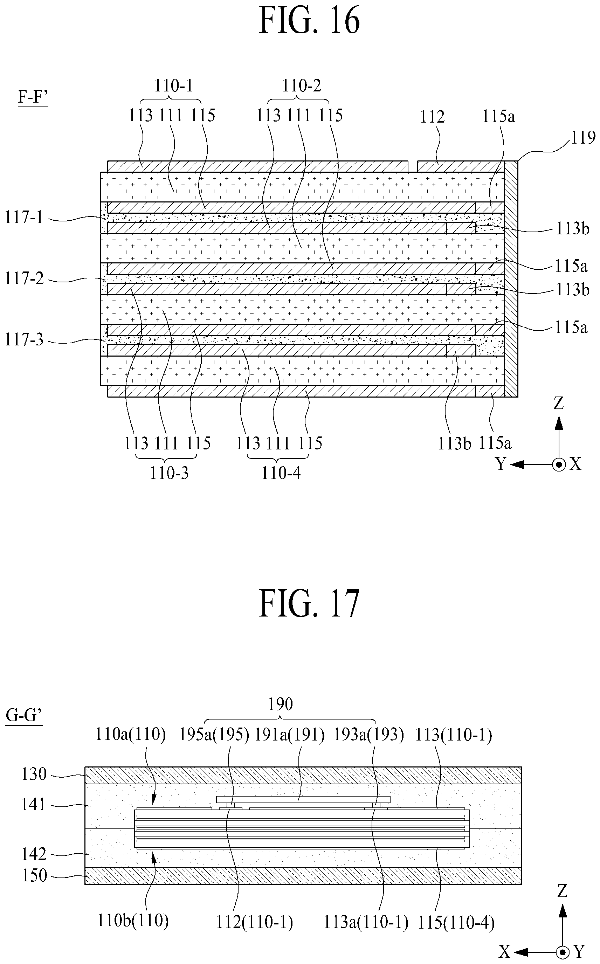

FIG. 12 illustrates a vibration apparatus according to another example of the present disclosure. FIG. 13 illustrates a vibration generating part illustrated in FIG. 12 according to another example of the present disclosure. FIG. 14 is an exploded perspective view of the vibration generating part illustrated in FIG. 13 according to another example of the present disclosure. FIG. 15 is an exploded perspective view illustrating a vibration part illustrated in FIGs. 13 and 14 according to another example of the present disclosure. FIG. 16 is a cross-sectional view taken along line F-F' illustrated in FIG. 13 according to another example of the present disclosure. FIG. 17 is a cross-sectional view taken along line G-G' illustrated in FIG. 12 according to another example of the present disclosure. FIGs. 12 to 17 illustrate an example where a connection pattern is additionally configured at the vibration apparatus illustrated in FIGs. 1 to 8 according to an example of the present disclosure. Hereinafter, a vibration apparatus 100 according to another example of the present disclosure will be described on elements which differ from the vibration apparatus 100 according to an example of the present disclosure.

With reference to FIGs. 5 and 12 to 15, a vibration apparatus 100 or a vibration generating part 110 according to another example of the present disclosure may further include a connection pattern 112.

The connection pattern 112 may be configured at the first surface 110a of the vibration generating part 110. The connection pattern 112 may be configured at the first surface 110a of the vibration generating part 110 to be electrically connected to the second connection member 119.

The connection pattern 112 may be at an uppermost electrode layer of the vibration generating part 110 and may be configured to be electrically disconnected (or separated or isolated) from the uppermost electrode layer. For example, the connection pattern 112 may be at the first vibration part 110-1 of the plurality of vibration parts 110-1, 110-2, 110-3, and 110-4 at the vibration generating part 110. For example, the connection pattern 112 may be at the first surface 111a of the vibration layer 111 at the first vibration part 110-1 and may be configured to be electrically disconnected (or separated or isolated) from the first electrode layer 113.

The connection pattern 112 may be configured in (or within) the second pattern portion 113b at the first electrode layer 113 of the first vibration part 110-1. For example, the second pattern portion 113b may be configured (or formed) concavely from the one lateral surface of the first electrode layer 113 to have the second length L2 parallel to the first direction X and a fifth width W5 parallel to the second direction Y. For example, the fifth width W5 of the second pattern portion 113b may be three or more times the first distance D1 or may be three or more times the first width W1, but examples of the present disclosure are not limited thereto. For example, the fifth width W5 of the second pattern portion 113b may be three or more times the first distance D1 or may be three or more times the first width W1, to secure a size (or area) of the connection pattern 112, but examples of the present disclosure are not limited thereto.

The connection pattern 112 according to an example of the present disclosure may be configured in an island shape on the first surface 111a of the vibration layer 111 at the first vibration part 110-1. The connection pattern 112 may be configured in an island shape in (or within) the second pattern portion 113b at the first electrode layer 113 of the first vibration part 110-1. The connection pattern 112 may be configured (or disposed) in (or within) the second pattern portion 113b and may extend to the one lateral surface of the vibration layer 111. For example, an end lateral surface (or an outer sidewall) of the connection pattern 112 may be aligned at the one lateral surface of the vibration layer 111. For example, the connection pattern 112 may be a connection pattern portion, a third contact pattern, or a third contact pattern portion, but examples of the present disclosure are not limited thereto.

The connection pattern 112 according to an example of the present disclosure may be configured (or formed) to have a tetragonal shape (or a rectangular shape) or a line shape, which has a sixth width W6 parallel to the first direction X and a length parallel to the second direction Y. For example, the sixth width W6 of the connection pattern 112 may be smaller than the second length L2 of the second pattern portion 113b, to electrically isolate (or insulate) the connection pattern 112 from the first electrode layer 113, but examples of the present disclosure are not limited thereto. The connection pattern 112 may be inserted (or accommodated) into the second pattern portion 113b and may protrude to one side of the second pattern portion 113b. Therefore, with respect to the third direction Z which is the thickness direction of the vibration generating part 110, the connection pattern 112 may overlap the third pattern portion 115a protruding from the second electrode layer 115 of each of the plurality of second to fourth vibration parts 110-2, 110-3, and 110-4.

With reference to FIGs. 13 to 16, the second connection member 119 may be configured to be electrically connected to the third pattern portion 115a of each of the plurality of vibration parts 110-1, 110-2, 110-3, and 110-4 and electrically connected to the connection pattern 112. For example, the second connection member 119 may be electrically isolated (or insulated) from the second pattern portion 113b of each of the plurality of vibration parts 110-1, 110-2, 110-3, and 110-4. For example, the second connection member 119 may be configured at one lateral surface (or an outer sidewall) spaced apart from the first connection member 118, electrically connected to one lateral surface (or an outer sidewall) of the third pattern portion 115a and one lateral surface (or a first short side) of each of the plurality of vibration parts 110-1, 110-2, 110-3, and 110-4, and electrically connected to one lateral surface (or an outer sidewall) of the connection pattern 112. Accordingly, the third pattern portion 115a and the connection pattern 112 of each of the plurality of vibration parts 110-1, 110-2, 110-3, and 110-4 may be electrically connected to each other by the second connection member 119.

With reference to FIGs. 12, 13, and 17, the vibration apparatus 100 according to another example of the present disclosure may further include a signal supply member 190.

The signal supply member 190 may be configured to be electrically connected to the vibration generating part 110 at one side of the vibration generating part 110. The signal supply member 190 may be configured to be electrically connected to the first connection member 118 and the second connection member 119 at one side of the vibration generating part 110. The signal supply member 190 may be disposed (or configured) on the first surface 110a of the vibration generating part 110. The signal supply member 190 may be disposed (or configured) between the first cover member 130 and the first surface 110a of the vibration generating part 110. The signal supply member 190 may be disposed (or configured) between the first cover member 130 and an electrode layer (or an uppermost electrode layer) of the vibration generating part 110. The signal supply member 190 may be configured to be electrically connected to the connection pattern 112 and the electrode layer (or an uppermost electrode layer) at the first surface 110a of the vibration generating part 110, between the first cover member 130 and the first surface 110a of the vibration generating part 110. The signal supply member 190 may be configured to be electrically connected to the connection pattern 112 and the first electrode layer (113) of the first vibration part 110-1 of the vibration generating part 110. Except for that the signal supply member 190 is electrically connected to the connection pattern 112 and the first electrode layer 113 of the first vibration part 110-1, the signal supply member 190 may be substantially a same as the signal supply member 190 described above with reference to FIGs. 1, 7, and 8, and thus, repeated descriptions thereof may be omitted or will be briefly given.

A portion of the signal supply member 190 may be disposed at or inserted (or accommodated) into a portion between one periphery portion of the first cover member 130 and one periphery portion of the second cover member 150.

The signal supply member 190 may include a base member 191, a first signal line 193, a second signal line 195, and an insulation film 197. Except for that the second signal line 195 is electrically connected to the connection pattern 112, the signal supply member 190 may be substantially a same as the signal supply member 190 described above with reference to FIGs. 1, 7, and 8, and thus, repeated descriptions thereof may be omitted or will be briefly given.

Each of end portions (or one side) 193a and 195a of the first signal line 193 and the second signal line 195 of the signal supply member 190 may be electrically connected to the vibration generating part 110 in a same direction. For example, each of end portions (or one side) 193a and 195a of the first signal line 193 and the second signal line 195 of the signal supply member 190 may be electrically connected to the vibration generating part 110 with being disposed to face the first surface 110a (or an uppermost electrode layer) of the vibration generating part 110. Accordingly, the first signal line 193 and the second signal line 195 of the signal supply member 190 may be electrically connected to the vibration generating part 110 in the same direction, and thus, a structure and a manufacturing process of the signal supply member 190 may be simplified.

The end portion (or one side) 193a of the first signal line 193 may be electrically connected to the first surface 110a of the vibration generating part 110, between the first surface 110a of the vibration generating part 110 and the first cover member 130. The end portion (or one side) 193a of the first signal line 193 may be electrically connected to the first electrode layer 113 of the first vibration part 110-1 of the vibration generating part 110, between the first surface 110a of the vibration generating part 110 and the first cover member 130. The end portion (or one side) 193a of the first signal line 193 may be electrically connected to a portion of the first electrode layer 113 of the first vibration part 110-1 and the first pattern portion 113a. The end portion (or one side) 193a of the first signal line 193 may be electrically connected to the portion of the first electrode layer 113 of the first vibration part 110-1, the first pattern portion 113a, and an upper surface of the first connection member 118. Accordingly, a driving signal (or a first driving signal) supplied from a vibration driving circuit may be supplied to the first electrode layer 113 of the first vibration part 110-1 of the vibration generating part 110 through (or by) the first signal line 193 and may be commonly supplied to the first electrode layer 113 of each of the other vibration part 110-1, 110-2, and 110-3 of the vibration generating part 110 through (or by) the first connection member 118.

The end portion (or one side) 195a of the second signal line 195 may be electrically connected to the connection pattern 112 between the first surface 110a of the vibration generating part 110 and the first cover member 130. The end portion (or one side) 195a of the second signal line 195 may be electrically connected to the connection pattern 112 and an upper surface of the second connection member 119. Accordingly, a driving signal (or a second driving signal) supplied from a vibration driving circuit may be supplied to the connection pattern 112 through (or by) the second signal line 195 and may be commonly supplied to the second electrode layer 115 of each of the other vibration parts 110-1, 110-2, 110-3, and 110-4 of the vibration generating part 110 through (or by) the connection pattern 112 and the second connection member 119.

The vibration apparatus 100 according to another example of the present disclosure may have a same effect as that of the vibration apparatus 100 described above with reference to FIGs. 1 to 8 and may further include the connection pattern 112, and thus, the first signal line 193 and the second signal line 195 of the signal supply member 190 may be electrically connected to the vibration generating part 110 in the same direction, thereby simplifying a structure and a manufacturing process of the signal supply member 190.

According to the vibration apparatus 100 according to another example of the present disclosure, the first signal line 193 and the second signal line 195 of the signal supply member 190 may be disposed together between the first cover member 130 and the first surface 110a of the vibration generating part 110 and may thus prevent or reduce the damage or crack of the vibration generating part 110 occurring in (during) a film laminating process.

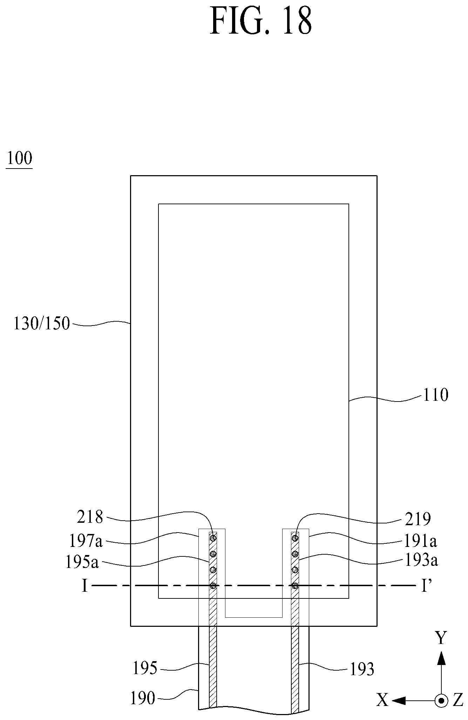

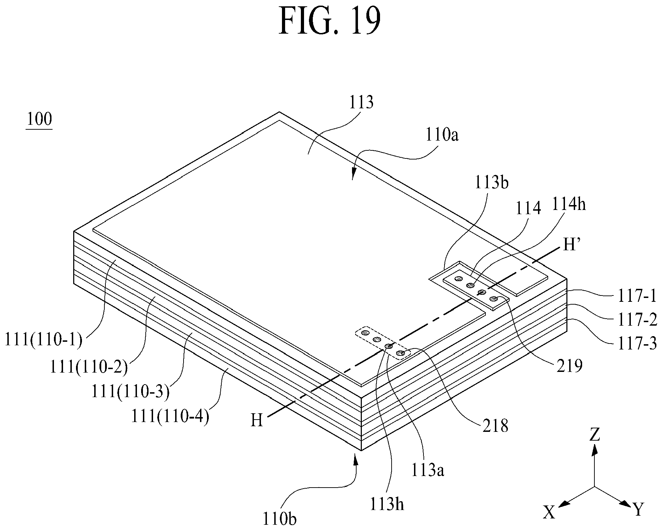

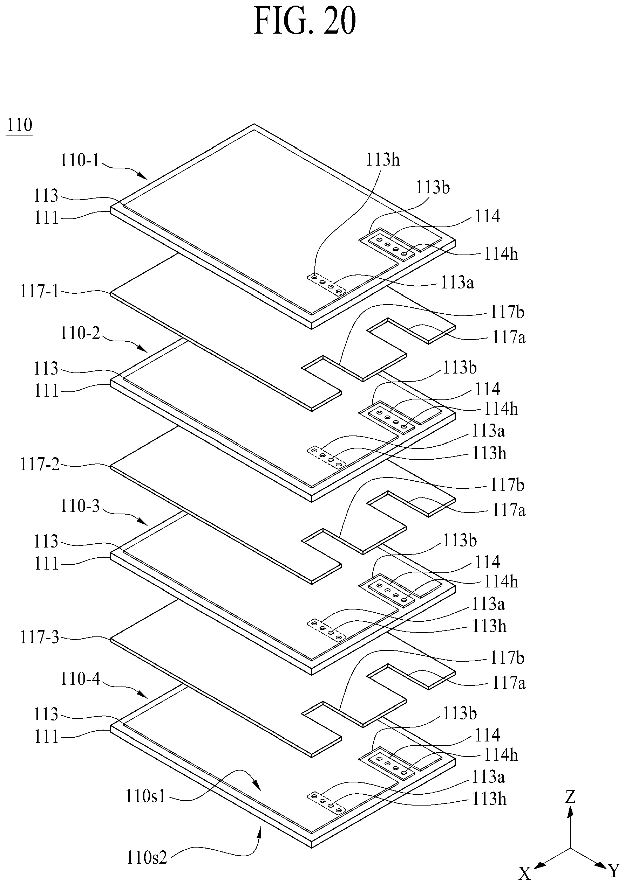

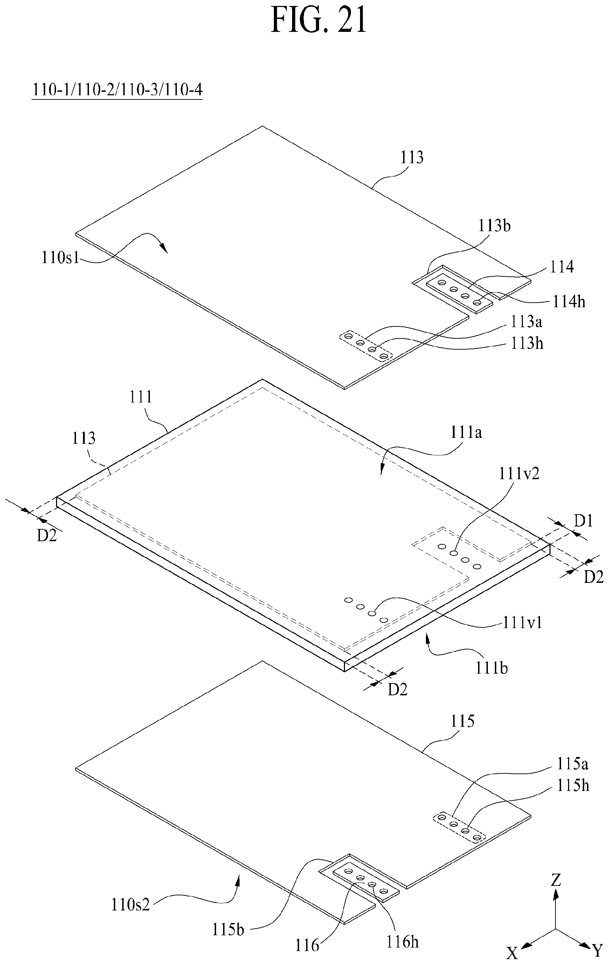

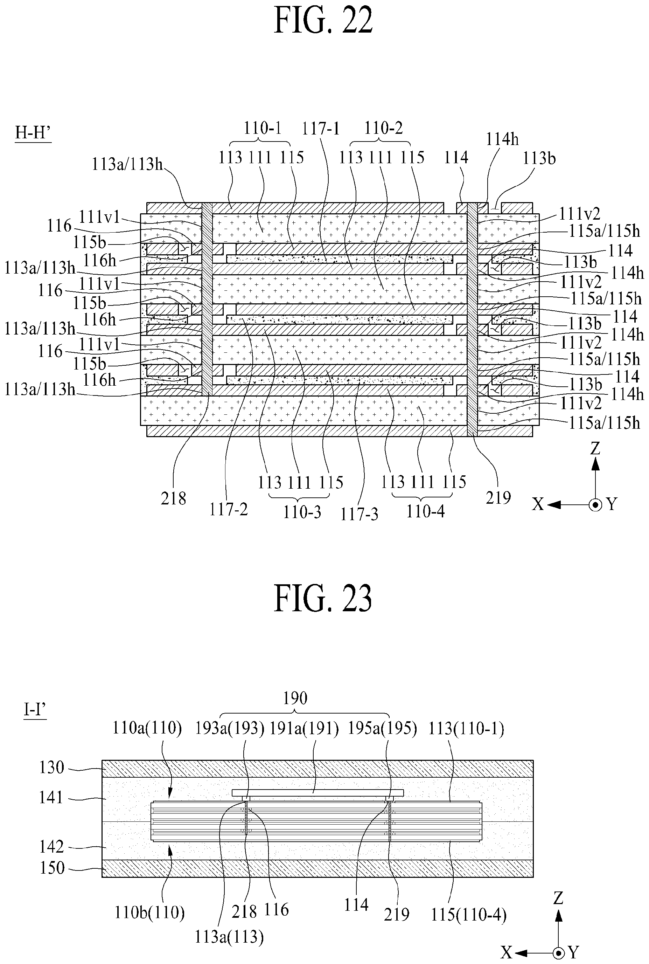

FIG. 18 illustrates a vibration apparatus according to another example of the present disclosure. FIG. 19 illustrates a vibration generating part illustrated in FIG. 18 according to another example of the present disclosure. FIG. 20 is an exploded perspective view of the vibration generating part illustrated in FIG. 19 according to another example of the present disclosure. FIG. 21 is an exploded perspective view illustrating a vibration part illustrated in FIGs. 19 and 20 according to another example of the present disclosure. FIG. 22 is a cross-sectional view taken along line H-H' illustrated in FIG. 19 according to another example of the present disclosure. FIG. 23 is a cross-sectional view taken along line I-I' illustrated in FIG. 18 according to another example of the present disclosure. FIGs. 18 to 23 illustrate an example implemented by modifying the plurality of vibration apparatus and the first and second connection member illustrated in FIGs. 1 to 8 according to an example of the present disclosure. Hereinafter, a vibration apparatus 100 according to another example of the present disclosure will be described on elements which differ from the vibration apparatus 100 according to an example of the present disclosure.

With reference to FIGs. 18 to 21, a vibration apparatus 100 according to another example of the present disclosure may include a vibration generating part 110.

The vibration generating part 110 may include a plurality of vibration parts 110-1, 110-2, 110-3, and 110-4 which are stacked and a plurality of insulation members 117-1, 117-2, and 117-3 between the plurality of vibration parts 110-1, 110-2, 110-3, and 110-4.

Each of the plurality of vibration parts 110-1, 110-2, 110-3, and 110-4 may include a first surface 110s1 including a first pattern portion 113a and a second pattern portion 113b, and a second surface 110s2 including a third pattern portion 115a and a fourth pattern portion 115b. Except for that each of the plurality of vibration parts 110-1, 110-2, 110-3, and 110-4 includes the first pattern portion 113a, the second pattern portion 113b, the third pattern portion 115a, and the fourth pattern portion 115b, the plurality of vibration parts 110-1, 110-2, 110-3, and 110-4 may be substantially a same as the plurality of vibration parts 110-1, 110-2, 110-3, and 110-4 described above with reference to FIGs. 1 to 4, and thus, repeated descriptions thereof may be omitted or will be briefly given.

In each of the plurality of vibration parts 110-1, 110-2, 110-3, and 110-4, the first pattern portion 113a and the second pattern portion 113b may be configured at one periphery portion (or a first periphery portion) of the first surface 110s1 of each of the plurality of vibration parts 110-1, 110-2, 110-3, and 110-4. The first pattern portion 113a and the second pattern portion 113b may be configured at a first electrode layer 113 of each of the plurality of vibration parts 110-1, 110-2, 110-3, and 110-4 to have different shapes or different structures.

In each of the plurality of vibration parts 110-1, 110-2, 110-3, and 110-4, the first pattern portion 113a may be configured at one side of the first electrode layer 113. The first pattern portion 113a may be configured at one side of the first electrode layer 113 adjacent to one lateral surface of a vibration layer 111. The first pattern portion 113a according to an example of the present disclosure may include one or more first holes 113h which are configured to pass through (or via) the first electrode layer 113 along a third direction Z parallel to a thickness direction of the vibration generating part 110. With respect to the third direction Z, the one or more first holes 113h configured in the first pattern portion 113a of each of the plurality of vibration parts 110-1, 110-2, 110-3, and 110-4 may overlap each other. For example, the first pattern portion 113a may be a first hole pattern portion, a first contact pattern, or a first contact pattern portion, but examples of the present disclosure are not limited thereto.

In each of the plurality of vibration parts 110-1, 110-2, 110-3, and 110-4, the second pattern portion 113b may be spaced apart from the first pattern portion 113a and may be configured (or formed) concavely from one lateral surface of the first electrode layer 113. The second pattern portion 113b may be configured (or formed) concavely from the one lateral surface of the first electrode layer 113 to have a tetragonal shape (or rectangular shape). The one lateral surface of the first electrode layer 113 may be removed in a tetragonal shape (or rectangular shape), and thus, the second pattern portion 113b may be configured (or formed) concavely from the one lateral surface of the first electrode layer 113. Therefore, with respect to the third direction Z, the second pattern portions 113b of the plurality of vibration parts 110-1, 110-2, 110-3, and 110-4 may overlap each other. For example, the second pattern portion 113b may be a first concave pattern, a first concave portion, a first recess pattern, a first groove pattern, a first groove pattern portion, a first electrode removal portion, a first contact prevention pattern, or a first contact prevention pattern portion, but examples of the present disclosure are not limited thereto.

In each of the plurality of vibration parts 110-1, 110-2, 110-3, and 110-4, the third pattern portion 115a and the fourth pattern portion 115b may be configured at one periphery portion (or a first periphery portion) of the second surface 110s2 of each of the plurality of vibration parts 110-1, 110-2, 110-3, and 110-4. The third pattern portion 115a and the fourth pattern portion 115b may be configured at the second electrode layer 115 of each of the plurality of vibration parts 110-1, 110-2, 110-3, and 110-4 to have different shapes or different structures. For example, the third pattern portion 115a may have a same shape or a same structure as that of the first pattern portion 113a and may correspond to or overlap the second pattern portion 113b.

In each of the plurality of vibration parts 110-1, 110-2, 110-3, and 110-4, the third pattern portion 115a may be configured at one side of the second electrode layer 115. The third pattern portion 115a may be configured at one side of the second electrode layer 115 adjacent to one lateral surface of a vibration layer 111. The third pattern portion 115a according to an example of the present disclosure may include one or more second holes 115h which are configured to pass through (or via) the second electrode layer 115 along the third direction Z. With respect to the third direction Z, the one or more second holes 115h configured in the third pattern portion 115a of each of the plurality of vibration parts 110-1, 110-2, 110-3, and 110-4 may overlap each other. For example, the third pattern portion 115a may be a second hole pattern portion, a second contact pattern, or a second contact pattern portion, but examples of the present disclosure are not limited thereto.

In each of the plurality of vibration parts 110-1, 110-2, 110-3, and 110-4, the fourth pattern portion 115b may be spaced apart from the third pattern portion 115a and may be configured (or formed) concavely from one lateral surface of the second electrode layer 115. The fourth pattern portion 115b may be configured (or formed) concavely from the one lateral surface of the second electrode layer 115 to have a tetragonal shape (or rectangular shape). The one lateral surface of the second electrode layer 115 may be removed in a tetragonal shape (or rectangular shape), and thus, the fourth pattern portion 115b may be configured (or formed) concavely from the one lateral surface of the second electrode layer 115. Therefore, with respect to the third direction Z, the fourth pattern portions 115b of each of the plurality of vibration parts 110-1, 110-2, 110-3, and 110-4 may overlap each other. For example, the fourth pattern portion 115b may be a second concave pattern, a second concave portion, a second recess pattern, a second groove pattern, a second groove pattern portion, a second electrode removal portion, a second contact prevention pattern, or a second contact prevention pattern portion, but examples of the present disclosure are not limited thereto.

With reference to FIGs. 19 to 21, a vibration apparatus 100 or a vibration generating part 110 according to another example of the present disclosure may further include a first connection pattern 114 and a second connection pattern 116 which are configured at each of the plurality of vibration parts 110-1, 110-2, 110-3, and 110-4. For example, each of the plurality of vibration parts 110-1, 110-2, 110-3, and 110-4 may further include a first connection pattern 114 and a second connection pattern 116.

The first connection pattern 114 may be configured at a first surface 110s1 of each of the plurality of vibration parts 110-1, 110-2, 110-3, and 110-4. The first connection pattern 114 may be configured at a first surface 110s1 of each of the plurality of vibration parts 110-1, 110-2, 110-3, and 110-4 to be electrically disconnected (or separated or isolated) from the first electrode layer 113 of each of the plurality of vibration parts 110-1, 110-2, 110-3, and 110-4.

In each of the plurality of vibration parts 110-1, 110-2, 110-3, and 110-4, the first connection pattern 114 may be configured on a first surface 111a of the vibration layer 111 to be electrically disconnected (or separated or isolated) from the first electrode layer 113. The first connection pattern 114 may be configured in (within) the second pattern portion 113b at the first electrode layer 113. For example, the first connection pattern 114 may be configured in an island shape in (or within) the second pattern portion 113b, but examples of the present disclosure are not limited thereto. For example, the first connection pattern 114 may be configured (or formed) to have a tetragonal shape (or a rectangular shape) or a line shape in (or within) the second pattern portion 113b. With respect to the third direction Z, the first connection patterns 114 of each of the plurality of vibration parts 110-1, 110-2, 110-3, and 110-4 may overlap each other. For example, the first connection pattern 114 may be a first connection pattern portion, a third contact pattern, or a third contact pattern portion, but examples of the present disclosure are not limited thereto.

The second pattern portion 113b or the first connection pattern 114 at each of the plurality of vibration parts 110-1, 110-2, 110-3, and 110-4 may include one or more first through holes 114h. The one or more first through holes 114h may be configured to pass through (or via) the first connection pattern 114 along the third direction Z. For example, the one or more first through holes 114h may be a third hole. For example, the second pattern portion 113b or the first connection pattern 114 including the one or more first through holes 114h may be a third hole pattern, a third hole pattern portion, a third contact pattern, or a third contact pattern portion, but examples of the present disclosure are not limited thereto.

The second connection pattern 116 may be configured at a second surface 110s2 of each of the plurality of vibration parts 110-1, 110-2, 110-3, and 110-4. The second connection pattern 116 may be configured at the second surface 110s2 of each of the plurality of vibration parts 110-1, 110-2, 110-3, and 110-4 to be electrically disconnected (or separated or isolated) from the second electrode layer 115 of each of the plurality of vibration parts 110-1, 110-2, 110-3, and 110-4.

In each of the plurality of vibration parts 110-1, 110-2, 110-3, and 110-4, the second connection pattern 116 may be configured on a second surface 11 1b of the vibration layer 111 to be electrically disconnected (or separated or isolated) from the second electrode layer 115. The second connection pattern 116 may be configured in (within) the fourth pattern portion 115b at the second electrode layer 115. For example, the second connection pattern 116 may be configured in an island shape in (or within) the fourth pattern portion 115b, but examples of the present disclosure are not limited thereto. For example, the second connection pattern 116 may be configured (or formed) to have a tetragonal shape (or a rectangular shape) or a line shape in (or within) the fourth pattern portion 115b. With respect to the third direction Z, the second connection patterns 116 of each of the plurality of vibration parts 110-1, 110-2, 110-3, and 110-4 may overlap each other. For example, the second connection pattern 116 may be a second connection pattern portion, a fourth contact pattern, or a fourth contact pattern portion, but examples of the present disclosure are not limited thereto.

The fourth pattern portion 115b or the second connection pattern 116 at each of the plurality of vibration parts 110-1, 110-2, 110-3, and 110-4 may include one or more second through holes 116h. The one or more second through holes 116h may be configured to pass through (or via) the second connection pattern 116 along the third direction Z. For example, the one or more second through holes 116h may be a fourth hole. For example, the fourth pattern portion 115b or the second connection pattern 116 including the one or more second through holes 116h may be a fourth hole pattern, a fourth hole pattern portion, a fourth contact pattern, or a fourth contact pattern portion, but examples of the present disclosure are not limited thereto.

The vibration apparatus 100 or the vibration generating part 110 according to another example of the present disclosure may further include one or more first via holes 111v1 and one or more second via holes 111v2, which are configured at a vibration layer 111 of each of the plurality of vibration parts 110-1, 110-2, 110-3, and 110-4. For example, each of the plurality of vibration parts 110-1, 110-2, 110-3, and 110-4 may further include one or more first via holes 11 1v1 and one or more second via holes 11 1v2, which are configured at the vibration layer 111.

In each of the plurality of vibration parts 110-1, 110-2, 110-3, and 110-4, the one or more first via holes 111v1 may be configured at the vibration layer 111 between the one or more first holes 113h and the one or more second through holes (or fourth holes) 116h. The one or more first via holes 111v1 may be configured at the vibration layer 111 to overlap the one or more first holes 113h and the one or more second through holes 116h. The one or more first via holes 111v1 may be configured to pass through (or via) the vibration layer 111 along the third direction Z. Accordingly, the one or more first holes 113h, the one or more second through holes 116h, and the one or more first via holes 111v1 may be connected to (or communicated with) each other along the third direction Z.

In each of the plurality of vibration parts 110-1, 110-2, 110-3, and 110-4, the one or more second via holes 111v2 may be configured at the vibration layer 111 between the one or more second holes 115h and the one or more first through holes (or third holes) 114h. The one or more second via holes 111v2 may be configured at the vibration layer 111 to overlap the one or more second holes 115h and the one or more first through holes 114h. The one or more second via holes 111v2 may be configured to pass through (or via) the vibration layer 111 along the third direction Z. Accordingly, the one or more second holes 115h, the one or more first through holes 114h, and the one or more second via holes 111v2 may be connected to (or communicated with) each other along the third direction Z.

According to an example of the present disclosure, the vibration layer 111 of each of the plurality of vibration parts 110-1, 110-2, 110-3, and 110-4 may have a same polarization direction (or a same poling direction). For example, the vibration layer 111 of each of the plurality of vibration parts 110-1, 110-2, 110-3, and 110-4 may have a polarization direction (or a poling direction) from the first electrode layer 113 toward the second electrode layer 115. For example, the polarization directions (or the poling directions) of the vibration layer 111 at each of the plurality of vibration parts 110-1, 110-2, 110-3, and 110-4 may be the same.

Each of the plurality of insulation members 117-1, 117-2, and 117-3 according to an example of the present disclosure may be disposed (or interposed) between two vibration parts vertically adjacent to each other among the plurality of vibration parts 110-1, 110-2, 110-3, and 110-4 and may be disposed (or interposed) between a second electrode layer 115 of an upper vibration part and a first electrode layer 113 of a lower vibration part of two vibration parts vertically adjacent to each other among the plurality of vibration parts 110-1, 110-2, 110-3, and 110-4. Accordingly, when the vibration layer 111 of each of the plurality of vibration parts 110-1, 110-2, 110-3, and 110-4 has a same polarization direction (or a same poling direction), each of the plurality of insulation members 117-1, 117-2, and 117-3 may prevent or reduce an electrical connection (or short circuit) between electrode layers 113 and 115 of two vibration parts vertically adjacent to each other among the plurality of vibration parts 110-1, 110-2, 110-3, and 110-4.

According to an example of the present disclosure, a first insulation member 117-1 of the plurality of insulation members 117-1, 117-2, and 117-3 may be disposed (or interposed) between the first and second vibration parts 110-1 and 110-2 vertically adjacent to each other among the plurality of vibration parts 110-1, 110-2, 110-3, and 110-4 and may be disposed (or interposed) between the second electrode layer 115 of the first vibration part 110-1 and the first electrode layer 113 of the second vibration part 110-2. A second insulation member 117-2 of the plurality of insulation members 117-1, 117-2, and 117-3 may be disposed (or interposed) between the second and third vibration parts 110-2 and 110-3 vertically adjacent to each other among the plurality of vibration parts 110-1, 110-2, 110-3, and 110-4 and may be disposed (or interposed) between the second electrode layer 115 of the second vibration part 110-2 and the first electrode layer 113 of the third vibration part 110-3. A third insulation member 117-3 of the plurality of insulation members 117-1, 117-2, and 117-3 may be disposed (or interposed) between the third and fourth vibration parts 110-3 and 110-4 vertically adjacent to each other among the plurality of vibration parts 110-1, 110-2, 110-3, and 110-4 and may be disposed (or interposed) between the second electrode layer 115 of the third vibration part 110-3 and the first electrode layer 113 of the fourth vibration part 110-4.

Each of the plurality of insulation members 117-1, 117-2, and 117-3 according to an example of the present disclosure may include a fifth pattern portion 117a and a sixth pattern portion 117b.

The fifth pattern portion 117a may be configured (or formed) concavely from one lateral surface of a corresponding insulation member of the insulation members 117-1, 117-2, and 117-3. The fifth pattern portion 117a may be configured to overlap the first connection pattern 114 and have a same shape as that of the second pattern portion 113b. For example, one lateral surface of a corresponding insulation member of the insulation members 117-1, 117-2, and 117-3 may be removed in a tetragonal shape, and thus, the fifth pattern portion 117a may be configured concavely from the one lateral surface of the corresponding insulation member of the insulation members 117-1, 117-2, and 117-3. Thus, with respect to the third direction Z, the fifth pattern portion 117a of each of the plurality of the insulation members 117-1, 117-2, and 117-3 may overlap each other. For example, the fifth pattern portion 117a may be a third concave pattern, a third concave portion, a third recess pattern, a third groove pattern, a third groove pattern portion, a first removal pattern, a first removal pattern portion, a first through pattern, a first through pattern portion, a third contact prevention pattern, or a third contact prevention pattern portion, but examples of the present disclosure are not limited thereto.

The sixth pattern portion 117b may be configured (or formed) concavely from one lateral surface of a corresponding insulation member of the insulation members 117-1, 117-2, and 117-3 to be spaced apart from the fifth pattern portion 117a. The sixth pattern portion 117b may be configured to overlap the second connection pattern 116 and have a same shape as that of the fourth pattern portion 115b. For example, one lateral surface of a corresponding insulation member of the insulation members 117-1, 117-2, and 117-3 may be removed in a tetragonal shape, and thus, the sixth pattern portion 117b may be configured concavely from the one lateral surface of the corresponding insulation member of the insulation members 117-1, 117-2, and 117-3. Thus, with respect to the third direction Z, the sixth pattern portion 117b of each of the plurality of the insulation members 117-1, 117-2, and 117-3 may overlap each other. For example, the sixth pattern portion 117b may be a fourth concave pattern, a fourth concave portion, a fourth recess pattern, a fourth groove pattern, a fourth groove pattern portion, a second removal pattern, a second removal pattern portion, a second through pattern, a second through pattern portion, a fourth contact prevention pattern, or a fourth contact prevention pattern portion, but examples of the present disclosure are not limited thereto.

With reference to FIGs. 18, 19, and 22, the vibration apparatus 100 or the vibration generating part 110 according to another example of the present disclosure may further include a first connection member 218 and a second connection member 219.

The first connection member 218 may pass through (or via) the vibration layer 111 of each of the plurality of vibration parts 110-1, 110-2, 110-3, and 110-4 and may be electrically connected to the first pattern portion 113a of each of the plurality of vibration parts 110-1, 110-2, 110-3, and 110-4. The first connection member 218 may pass through (or via) the vibration layer 111 of each of the plurality of vibration parts 110-1, 110-2, 110-3, and 110-4 and the plurality of insulation members 117-1, 117-2, and 117-3 and may be electrically connected to the first pattern portion 113a and the fourth pattern portion 115b (or the second connection pattern 116) of each of the plurality of vibration parts 110-1, 110-2, 110-3, and 110-4. For example, the first connection member 218 may pass through (or via) the plurality of vibration parts 110-1, 110-2, 110-3, and 110-4 and may be electrically connected to the first electrode layer 113 of each of the plurality of vibration parts 110-1, 110-2, 110-3, and 110-4 through (or by) the first pattern portion 113a of each of the plurality of vibration parts 110-1, 110-2, 110-3, and 110-4. For example, the first connection member 218 may be commonly connected to the first electrode layer 113 of each of the plurality of vibration parts 110-1, 110-2, 110-3, and 110-4 through (or by) the first pattern portion 113a and the fourth pattern portion 115b (or the second connection pattern 116).

According to an example of the present disclosure, the first connection member 218 may pass through (or via) the vibration layer 111 of each of the plurality of vibration parts 110-1, 110-2, 110-3, and 110-4 and the plurality of insulation members 117-1, 117-2, and 117-3 and may be filled in one or more first holes 113h, one or more first via holes 111v1, and one or more second through holes 116h, and thus, may be electrically or commonly connected to the first electrode layer 113 of each of the plurality of vibration parts 110-1, 110-2, 110-3, and 110-4. Accordingly, the first electrode layer 113 of each of the plurality of vibration parts 110-1, 110-2, 110-3, and 110-4 may receive a same driving signal (or sound signal or voice signal) through (or by) the first connection member 218, the first pattern portion 113a, and the fourth pattern portion 115b (or the second connection pattern 116) in common.

The second connection member 219 may pass through (or via) the plurality of vibration parts 110-1, 110-2, 110-3, and 110-4 and may be electrically connected to the third pattern portion 115a of each of the plurality of vibration parts 110-1, 110-2, 110-3, and 110-4. The second connection member 219 may pass through (or via) the vibration layer 111 of each of the plurality of vibration parts 110-1, 110-2, 110-3, and 110-4 and the plurality of insulation members 117-1, 117-2, and 117-3 and may be electrically connected to the third pattern portion 115a and a second pattern portion 113b (or the first connection pattern 114) of each of the plurality of vibration parts 110-1, 110-2, 110-3, and 110-4. For example, the second connection member 219 may pass through (or via) the plurality of vibration parts 110-1, 110-2, 110-3, and 110-4 and may be electrically connected to the second electrode layer 115 of each of the plurality of vibration parts 110-1, 110-2, 110-3, and 110-4 through (or by) the third pattern portion 115a of each of the plurality of vibration parts 110-1, 110-2, 110-3, and 110-4. For example, the second connection member 219 may be commonly connected to the second electrode layer 115 of each of the plurality of vibration parts 110-1, 110-2, 110-3, and 110-4 through (or by) the third pattern portion 115a and the second pattern portion 113b (or the first connection pattern 114).

According to an example of the present disclosure, the second connection member 219 may pass through (or via) the vibration layer 111 of each of the plurality of vibration parts 110-1, 110-2, 110-3, and 110-4 and the plurality of insulation members 117-1, 117-2, and 117-3 and may be filled in one or more first through holes 114h, one or more second via holes 111v2, and one or more second holes 115h, and thus, may be electrically or commonly connected to the second electrode layer 115 of each of the plurality of vibration parts 110-1, 110-2, 110-3, and 110-4. Accordingly, the second electrode layer 115 of each of the plurality of vibration parts 110-1, 110-2, 110-3, and 110-4 may receive a same driving signal (or sound signal or voice signal) through (or by) the second connection member 219, the third pattern portion 115a, and the second pattern portion 113b (or the first connection pattern 114) in common.

Each of the first connection member 118 and the second connection member 119 according to an example of the present disclosure may be configured as a conductive material or a conductive adhesive. For example, the conductive material of each of the first and second connection members 218 and 219 may include a thermos-curable electrode material, a photo-curable (or ultraviolet (UV)-curable) electrode material, or a solution-type electrode material, but examples of the present disclosure are not limited thereto. For example, the electrode material of each of the first and second connection members 218 and 219 may include silver (Ag), nickel (Ni), an Ag alloy, or a Ni alloy, but examples of the present disclosure are not limited thereto. For example, each of the first and second connection members 218 and 219 may include a silver (Ag) paste. For example, the conductive adhesive may include a conductive epoxy resin, a conductive acrylic resin, a conductive silicone resin, or a conductive urethane resin, but examples of the present disclosure are not limited thereto.

With reference to FIGs. 18, 22, and 23, the vibration apparatus 100 according to another example of the present disclosure may further include a signal supply member 190.

The signal supply member 190 may be configured to be electrically connected to the vibration generating part 110 at one side of the vibration generating part 110. The signal supply member 190 may be configured to be electrically connected to the first connection member 118 and the second connection member 119 at one side of the vibration generating part 110. The signal supply member 190 may be disposed (or configured) on the first surface 110a of the vibration generating part 110. The signal supply member 190 may be disposed (or configured) between the first cover member 130 and the first surface 110a of the vibration generating part 110. The signal supply member 190 may be disposed (or configured) between the first cover member 130 and an electrode layer (or an uppermost electrode layer) of the vibration generating part 110. The signal supply member 190 may be configured to be electrically connected to the first connection pattern 114 and the electrode layer (or an uppermost electrode layer) at the first surface 110a of the vibration generating part 110, between the first cover member 130 and the first surface 110a of the vibration generating part 110. The signal supply member 190 may be configured to be electrically connected to the first connection pattern 114 and the first pattern portion 113a of the first electrode layer (113) at the first vibration part 110-1 of the vibration generating part 110. Except for that the first electrode layer 113 of the first vibration part 110-1 is electrically connected to the first pattern portion 113a and the first connection pattern 114, the signal supply member 190 may be substantially a same as the signal supply member 190 described above with reference to FIGs. 12, 13, and 17, and thus, repeated descriptions thereof may be omitted or will be briefly given.

A portion of the signal supply member 190 may be disposed at or inserted (or accommodated) into a portion between one periphery portion of the first cover member 130 and one periphery portion of the second cover member 150.

The signal supply member 190 may include a base member 191, a first signal line 193, a second signal line 195, and an insulation film 197. Except for that the first signal line 193 is electrically connected to the first pattern portion 113a and the second signal line 195 is electrically connected to the first connection pattern 114, the signal supply member 190 may be substantially a same as the signal supply member 190 described above with reference to FIGs. 12, 13, and 17, and thus, repeated descriptions thereof may be omitted or will be briefly given.

Each of end portions (or one side) 193a and 195a of the first signal line 193 and the second signal line 195 of the signal supply member 190 may be electrically connected to the vibration generating part 110 in a same direction. Accordingly, the first signal line 193 and the second signal line 195 of the signal supply member 190 may be electrically connected to the vibration generating part 110 in the same direction, and thus, a structure and a manufacturing process of the signal supply member 190 may be simplified.

The end portion (or one side) 193a of the first signal line 193 may be electrically connected to the first surface 110a of the vibration generating part 110, between the first surface 110a of the vibration generating part 110 and the first cover member 130. The end portion (or one side) 193a of the first signal line 193 may be electrically connected to the first pattern portion 113a of the first vibration part 110-1 of the vibration generating part 110, between the first surface 110a of the vibration generating part 110 and the first cover member 130. The end portion (or one side) 193a of the first signal line 193 may be electrically connected to a portion of the first electrode layer 113 of the first vibration part 110-1 and the first pattern portion 113a. The end portion (or one side) 193a of the first signal line 193 may be electrically connected to a portion of the first electrode layer 113 of the first vibration part 110-1, the first pattern portion 113a, and an upper surface of the first connection member 218 filled in the one or more first holes 113h at the first pattern portion 113a. Accordingly, a driving signal (or a first driving signal) supplied from a vibration driving circuit may be supplied to the first electrode layer 113 of the first vibration part 110-1 of the vibration generating part 110 through (or by) the first signal line 193 and may be commonly supplied to the first electrode layer 113 of each of the other vibration part 110-2, 110-3, and 110-4 of the vibration generating part 110 through (or by) the first connection member 118.

The end portion (or one side) 195a of the second signal line 195 may be electrically connected to the first connection pattern 114 in (within) the second pattern portion 113b of the first vibration part 110-1, between the first surface 110a of the vibration generating part 110 and the first cover member 130. The end portion (or one side) 195a of the second signal line 195 may be electrically connected to the first connection pattern 114 and an upper surface of the second connection member 219 filled in the one or more second holes 114h at the first connection pattern 114. Accordingly, a driving signal (or a second driving signal) supplied from a vibration driving circuit may be supplied to the first connection pattern 114 through (or by) the second signal line 195 and may be commonly supplied to the second electrode layer 115 of each of the plurality of vibration parts 110-1, 110-2, 110-3, and 110-4 of the vibration generating part 110 through (or by) the first connection pattern 114 and the second connection member 119.

The vibration apparatus 100 according to another example of the present disclosure may have substantially a same effect as that of the vibration apparatus 100 described above with reference to FIGs. 11 to 17.

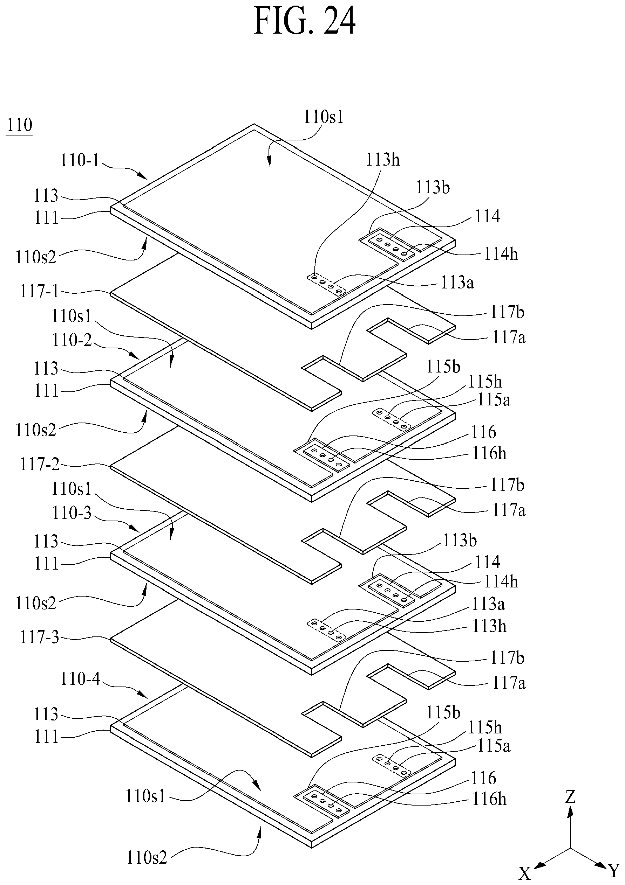

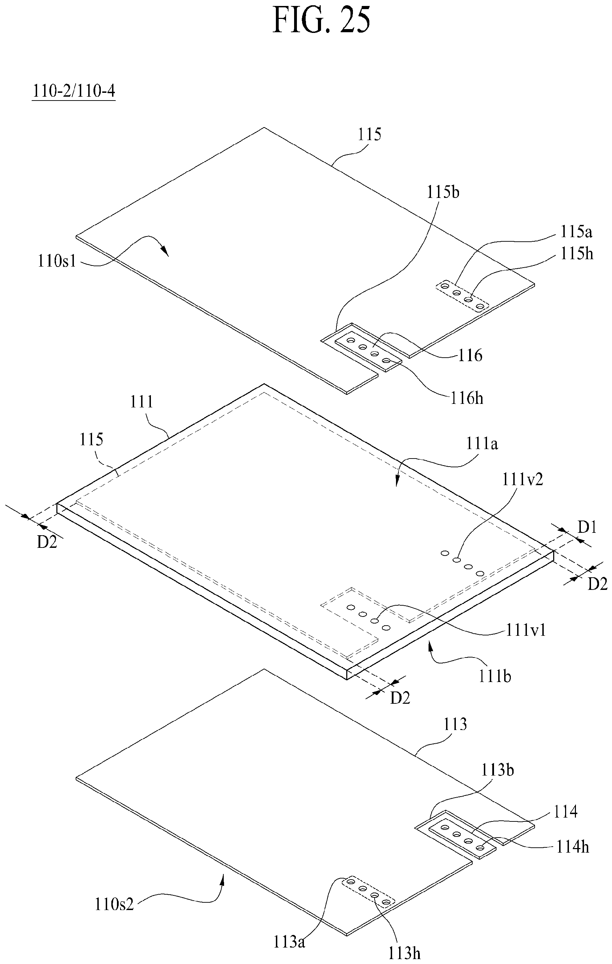

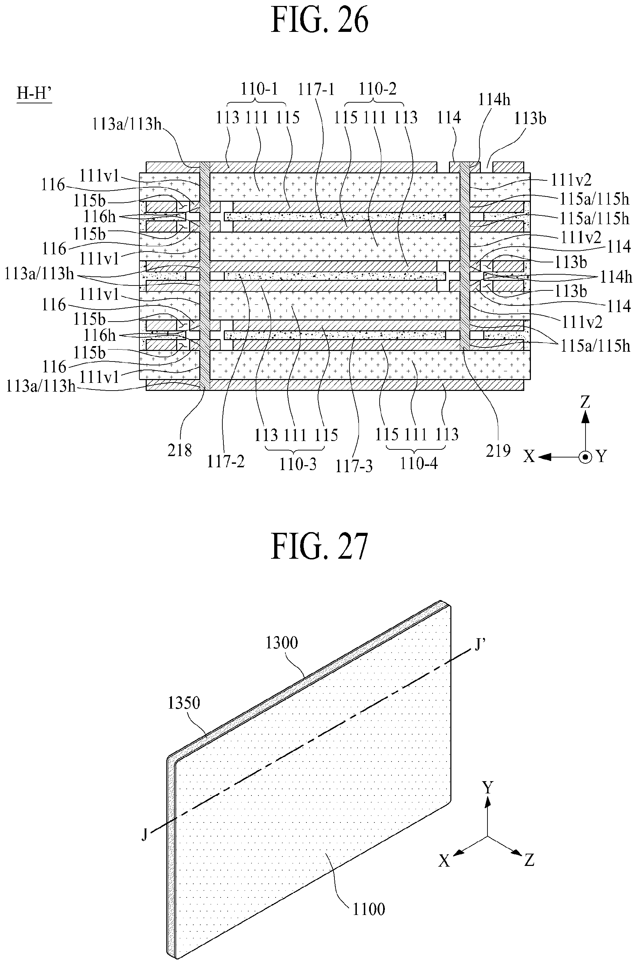

FIG. 24 is another exploded perspective view of the vibration generating part illustrated in FIG. 19 according to another example of the present disclosure. FIG. 25 is an exploded perspective view illustrating a vibration part illustrated in FIG. 24 according to another example of the present disclosure. FIG. 26 is another cross-sectional view taken along line H-H' illustrated in FIG. 19 according to another example of the present disclosure. FIGs. 24 to 26 illustrate an example implemented by modifying a stack structure of a plurality of vibration parts, in the vibration apparatus 100 according to another example of the present disclosure described above with reference to FIGs. 18 to 23. Hereinafter, a vibration apparatus 100 according to another example of the present disclosure will be described on elements which differ from the vibration apparatus 100 according to an example of the present disclosure.

With reference to FIGs. 24 to 26, in a vibration generating part 110 of a vibration apparatus 100 according to another example of the present disclosure, partial portions of vibration layers 111 of a plurality of vibration parts 110-1, 110-2, 110-3, and 110-4 which are vertically stacked may be configured to have different polarization directions (or poling directions). For example, in the plurality of vibration parts 110-1 to 110-4, the vibration layer 111 of each of even-numbered vibration parts 110-2 and 110-4 may have a polarization direction (or a poling direction) which differ from that of the vibration layer 111 of each of odd-numbered vibration parts 110-1 and 110-3. For example, the vibration layers 111 of the even-numbered vibration parts 110-2 and 110-4 may have a same polarization direction (or a same poling direction), and the vibration layers 111 of the odd-numbered vibration parts 110-1 and 110-3 may have different polarization directions (or different poling directions). The vibration layers 111 of the odd-numbered vibration parts 110-1 and 110-3 may have a polarization direction (or a poling direction) toward the second electrode layer 115 from the first electrode layer 113. The vibration layers 111 of the even-numbered vibration parts 110-2 and 110-4 may have a polarization direction (or a poling direction) toward the first electrode layer 113 from the second electrode layer 115. Accordingly, the vibration layers 111 of the even-numbered vibration parts 110-2 and 110-4 and the vibration layers 111 of the odd-numbered vibration parts 110-1 and 110-3 may have polarization directions (or poling directions) opposite to each other.

According to an example of the present disclosure, the second electrode layers 115 of the odd-numbered vibration parts 110-1 and 110-3 may face the second electrode layers 115 of the even-numbered vibration parts 110-2 and 110-4 disposed thereon, and the first electrode layers 113 of the odd-numbered vibration parts 110-1 and 110-3 may face the first electrode layers 113 of the even-numbered vibration parts 110-2 and 110-4 disposed thereunder. For example, the second electrode layer 115 of the second vibration part 110-2 may face the second electrode layer 115 of the first vibration part 110-1, and the first electrode layers 113 of the second vibration part 110-2 may face the first electrode layer 113 of the third vibration part 110-3. The second electrode layer 115 of the fourth vibration part 110-4 may face the second electrode layer 115 of the third vibration part 110-3, and the first electrode layer 113 of the fourth vibration par 110-4 may be a lowermost electrode layer of the vibration generating part 110.

Each of the odd-numbered vibration parts 110-1 and 110-3 of the plurality of vibration parts 110-1, 110-2, 110-3, and 110-4 or first and third vibration parts 110-1 and 110-3 may include a vibration layer 111, a first electrode layer 113, a second electrode layer 115, a first pattern portion 113a, a second pattern portion 113b, a third pattern portion 115a, a fourth pattern portion 115b, a first connection pattern 114, and a second connection pattern 116. Each of the first and third vibration parts 110-1 and 110-3 may be substantially a same as that of the first and third vibration parts 110-1 and 110-3 described above with reference to FIGs. 18 to 23, and thus, repeated descriptions thereof may be omitted or will be briefly given.

Each of the even-numbered vibration parts 110-2 and 110-4 of the plurality of vibration parts 110-1, 110-2, 110-3, and 110-4 or second and fourth vibration parts 110-2 and 110-4 may include a vibration layer 111, a first electrode layer 113, a second electrode layer 115, a first pattern portion 113a, a second pattern portion 113b, a third pattern portion 115a, a fourth pattern portion 115b, a first connection pattern 114, and a second connection pattern 116. In each of the even-numbered vibration parts 110-2 and 110-4 or the second and fourth vibration parts 110-2 and 110-4, except for positions, each of the first electrode layer 113, the second electrode layer 115, the first pattern portion 113a, the second pattern portion 113b, the third pattern portion 115a, the fourth pattern portion 115b, the first connection pattern 114, and the second connection pattern 116 may be substantially the same as the odd-numbered vibration parts 110-1 and 110-3 or first and third vibration parts 110-1 and 110-3, and thus, repeated descriptions thereof may be omitted or will be briefly given.

In each of the even-numbered vibration parts 110-2 and 110-4 or second and fourth vibration parts 110-2 and 110-4, the first electrode layer 113 may be configured at a second surface 111b of the vibration layer 111, and the second electrode layer 115 may be configured at a first surface 111a of the vibration layer 111.

In each of the even-numbered vibration parts 110-2 and 110-4 or second and fourth vibration parts 110-2 and 110-4, the first pattern portion 113a may be configured at one side of the first electrode layer 113 to overlap or correspond to the first pattern portion 113a of the odd-numbered vibration parts 110-1 and 110-3. The second pattern portion 113b may be configured at one side of the first electrode layer 113 to overlap or correspond to the second pattern portion 113b of the odd-numbered vibration parts 110-1 and 110-3. The first connection pattern 114 may be configured in (within) the second pattern portion 113b to overlap or correspond to the first connection pattern 114 of the odd-numbered vibration parts 110-1 and 110-3. The first pattern portion 113a may include one or more first holes 113h, and the first connection pattern 114 may include one or more first through holes 114h.

In each of the even-numbered vibration parts 110-2 and 110-4 or second and fourth vibration parts 110-2 and 110-4, the third pattern portion 115a may be configured at one side of the second electrode layer 115 to overlap or correspond to the second pattern portion 113b of the odd-numbered vibration parts 110-1 and 110-3. The fourth pattern portion 115b may be configured at one side of the second electrode layer 115 to overlap or correspond to the first pattern portion 113a of the odd-numbered vibration parts 110-1 and 110-3. The second connection pattern 116 may be configured in (within) the fourth pattern portion 115b to overlap or correspond to the second connection pattern 116 of the odd-numbered vibration parts 110-1 and 110-3. The third pattern portion 115a may include one or more second holes 115h, and the second connection pattern 116 may include one or more second through holes 116h.

The vibration layer 11 of each of the even-numbered vibration parts 110-2 and 110-4 or second and fourth vibration parts 110-2 and 110-4 may further include one or more first via holes 111v1 and one or more second via holes 11 1v2.

In each of the even-numbered vibration parts 110-2 and 110-4 or second and fourth vibration parts 110-2 and 110-4, the one or more first via holes 111v1 may be configured at the vibration layer 111 between the one or more first holes 113h and the one or more second through holes (or fourth holes) 116h. The one or more first via holes 111v1 may be configured at the vibration layer 111 to overlap the one or more first holes 113h and the one or more second through holes 116h. Accordingly, the one or more first holes 113h, the one or more second through holes 116h, and the one or more first via holes 111v1 may be connected to (or communicated with) each other along a third direction Z.

In each of the even-numbered vibration parts 110-2 and 110-4 or second and fourth vibration parts 110-2 and 110-4, the one or more second via holes 111v2 may be configured at the vibration layer 111 between the one or more second holes 115h and the one or more first through holes (or third holes) 114h. The one or more second via holes 111v2 may be configured at the vibration layer 111 to overlap the one or more second holes 115h and the one or more first through holes 114h. Accordingly, the one or more second holes 115h, the one or more first through holes 114h, and the one or more second via holes 111v2 may be connected to (or communicated with) each other along the third direction Z.

Each of the plurality of insulation members 117-1, 117-2, and 117-3 according to an example of the present disclosure may be disposed (or interposed) between two vibration parts vertically adjacent to each other among the plurality of vibration parts 110-1, 110-2, 110-3, and 110-4. For example, some of the plurality of insulation members 117-1, 117-2, and 117-3 may be disposed (or interposed) between a second electrode layer 115 of an upper vibration part and a second electrode layer 115 of a lower vibration part of two vibration parts vertically adjacent to each other. The other of the plurality of insulation members 117-1, 117-2, and 117-3 may be disposed (or interposed) between a first electrode layer 113 of the upper vibration part and a first electrode layer 113 of the lower vibration part of the two vibration parts vertically adjacent to each other. For example, the first insulation member 117-1 may be disposed between the second electrode layer 115 of the first vibration part 110-1 and the second electrode layer 115 of the second vibration part 110-2. The second insulation member 117-2 may be disposed between the first electrode layer 113 of the second vibration part 110-2 and the first electrode layer 113 of the third vibration part 110-3. The third insulation member 117-3 may be disposed between the second electrode layer 115 of the third vibration part 110-3 and the second electrode layer 115 of the fourth vibration part 110-4. Accordingly, each of the plurality of insulation members 117-1, 117-2, and 117-3 may be disposed between the same electrode layers of two vibration parts vertically adjacent to each other among the plurality of vibration parts 110-1, 110-2, 110-3, and 110-4, and thus, an electrical connection (or short circuit) between electrode layers 113 and 115 of two vibration parts vertically adjacent to each other may be prevented or reduced.

Each of the plurality of insulation members 117-1, 117-2, and 117-3 according to an example of the present disclosure may include a fifth pattern portion 117a and a sixth pattern portion 117b, and the fifth pattern portion 117a and the sixth pattern portion 117b may be a same as the descriptions of FIG. 24, and thus, repeated descriptions thereof may be omitted or may be briefly provided.

The vibration apparatus 100 or the vibration generating part 110 according to another example of the present disclosure may further include a first connection member 218 and a second connection member 219, and the first connection member 218 and the second connection member 219 may be a same as the descriptions of FIG. 22, and thus, repeated descriptions thereof may be omitted or will be briefly given below.

The first connection member 218 may pass through (or via) the plurality of vibration parts 110-1, 110-2, 110-3, and 110-4 and may be electrically connected to the first electrode layer 113 of each of the plurality of vibration parts 110-1, 110-2, 110-3, and 110-4 through (or by) the first pattern portion 113a of each of the plurality of vibration parts 110-1, 110-2, 110-3, and 110-4. For example, the first connection member 218 may be commonly connected to the first electrode layer 113 of each of the plurality of vibration parts 110-1, 110-2, 110-3, and 110-4 through (or by) the first pattern portion 113a and the fourth pattern portion 115b (or the second connection pattern 116). Therefore, the first electrode layer 113 of each of the plurality of vibration parts 110-1, 110-2, 110-3, and 110-4 may receive a same driving signal (or sound signal or voice signal) through (or by) the first connection member 118, the first pattern portion 113a, and the fourth pattern portion 115b (or the second connection pattern 116) in common.

The second connection member 219 may pass through (or via) the plurality of vibration parts 110-1, 110-2, 110-3, and 110-4 and may be electrically connected to the second electrode layer 115 of each of the plurality of vibration parts 110-1, 110-2, 110-3, and 110-4 through (or by) the third pattern portion 115a of each of the plurality of vibration parts 110-1, 110-2, 110-3, and 110-4. For example, the second connection member 219 may be commonly connected to the second electrode layer 115 of each of the plurality of vibration parts 110-1, 110-2, 110-3, and 110-4 through (or by) the third pattern portion 115a and the second pattern portion 113b (or the first connection pattern 114). Therefore, the second electrode layer 115 of each of the plurality of vibration parts 110-1, 110-2, 110-3, and 110-4 may receive a same driving signal (or sound signal or voice signal) through (or by) the second connection member 119, the third pattern portion 115a, and the second pattern portion 113b (or the first connection pattern 114) in common.

The vibration apparatus 100 according to another example of the present disclosure may further include the signal supply member 190 which is configured to be electrically connected to the vibration generating part 110 at one side of the vibration generating part 110, and this may be as described above with reference to FIGs. 18, 22, and 23, and thus, repeated descriptions thereof may be omitted or may be briefly provided.

The vibration apparatus 100 according to another example of the present disclosure may have a same effect as that of the vibration apparatus 100 described above with reference to FIGs. 18 to 23, and each of the plurality of insulation members 117-1, 117-2, and 117-3 may be disposed between the same electrode layers of two vibration parts 110-1, 110-2, 110-3, and 110-4 vertically adjacent to each other, and thus, an electrical connection (or short circuit) between electrode layers 113 and 115 of two vibration parts vertically adjacent to each other may be prevented or reduced.

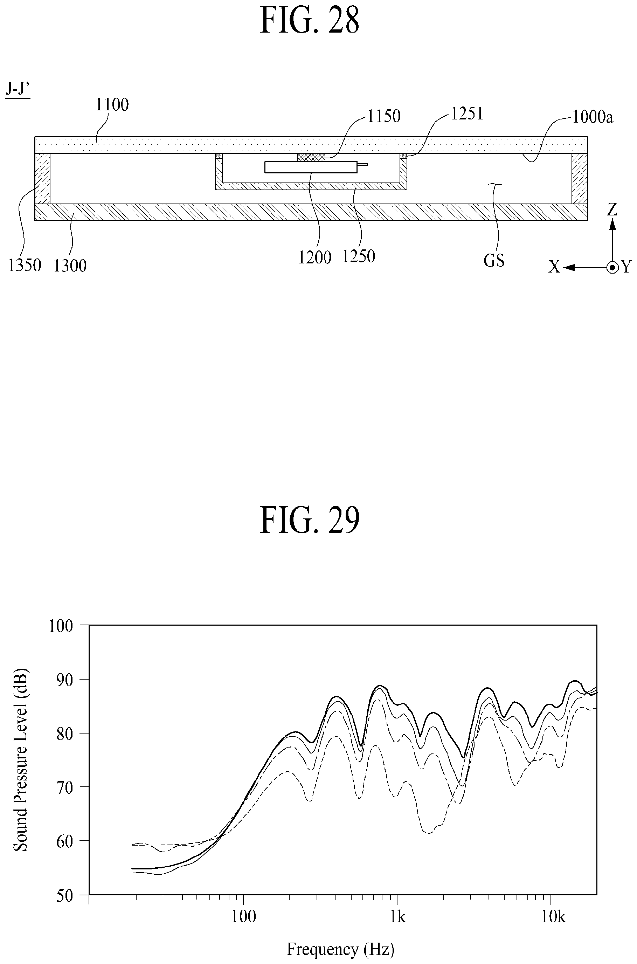

FIG. 27 illustrates an apparatus according to an example of the present disclosure. FIG. 28 is a cross-sectional view taken along line J-J' illustrated in FIG. 27 according to an example of the present disclosure.

With reference to FIGs. 27 and 28, the apparatus according to an example of the present disclosure may include a passive vibration member 1100 and one or more vibration generating apparatuses 1200.

The "apparatus" according to an example of the present disclosure may be applied to implement a display apparatus, a sound apparatus, a sound output apparatus, a sound generating apparatus, a sound bar, a sound system, a sound apparatus for vehicular apparatuses, a sound output apparatus for vehicular apparatuses, or a sound bar for vehicular apparatuses, an analog signage, or a digital signage (such as an advertising signboard, a poster, or a noticeboard, or the like), or the like, but examples of the present disclosure are not limited thereto. For example, the vehicular apparatuses may include one or more seats and one or more glass windows. For example, the vehicular apparatuses may include a vehicle, a train, a ship, or an aircraft, but embodiments of the present disclosure are not limited thereto.

The display apparatus may include a display panel which includes a plurality of pixels for implementing a black/white or color image, and a driver for driving the display panel. For example, the display panel may be a liquid crystal display panel, an organic light emitting display panel, a light emitting diode display panel, an electrophoresis display panel, an electro-wetting display panel, a micro light emitting diode display panel, or a quantum dot light emitting display panel, or the like, but examples of the present disclosure are not limited thereto. For example, in the organic light emitting display panel, a pixel may include an organic light emitting device such as an organic light emitting layer or the like, and the pixel may be a subpixel which implements any one of a plurality of colors configuring a color image. Accordingly, the "apparatus" according to an example of the present disclosure may include a set electronic apparatus or a set device (or a set apparatus) such as a notebook computer, a television, a computer monitor, an equipment apparatus including an automotive apparatus or another type apparatus for vehicles, or a mobile electronic apparatus such as a smartphone or an electronic pad, or the like, which is a complete product (or a final product) including the display panel such as the liquid crystal display panel or the organic light emitting display panel, or the like.

The analog signage may be an advertising signboard, a poster, a noticeboard, or the like. The analog signage may include signage content such as a sentence, a picture, and a sign, or the like. The signage content may be disposed at the passive vibration member 1100 of the apparatus to be visible. For example, the signage content may be directly attached on the passive vibration member 1100 and the signage content may be printed or the like on a medium such as paper, and the medium may be attached on the passive vibration member 1100.

The passive vibration member 1100 may vibrate based on driving (or vibration) of the one or more vibration generating apparatuses 1200. For example, the passive vibration member 1100 may generate one or more of a vibration and a sound based on driving of the one or more vibration generating apparatuses 1200.

The passive vibration member 1100 according to an example of the present disclosure may be a display panel including a display part (or a screen) including a plurality of pixels which implement a black/white or color image. Therefore, the passive vibration member 1100 may generate one or more of a vibration and a sound based on driving of the one or more vibration generating apparatuses 1200. For example, the passive vibration member 1100 may vibrate based on driving of the vibration generating apparatus 1200 while displaying an image on the display area, thereby generating or outputting a sound synchronized with the image in the display area. For example, the passive vibration member 1100 may be a vibration object, a display member, a display panel, a signage panel, a passive vibration plate, a front cover, a front member, a vibration panel, a sound panel, a passive vibration panel, a sound output plate, a sound vibration plate, or an image screen, or the like, but examples of the present disclosure are not limited thereto.

The passive vibration member 1100 according to another example of the present disclosure may be a vibration plate which includes a metal material or a nonmetal material or a composite nonmetal material having a material characteristic suitable for being vibrated by the one or more vibration generating apparatuses 1200 to output sound. For example, the passive vibration member 1100 may include a vibration plate including one or more materials of metal, plastic, wood, paper, fiber, cloth, leather, glass, rubber, carbon and mirror. For example, the paper may be cone paper for speakers. For example, the cone paper may be pulp or foamed plastic, or the like, but examples of the present disclosure are not limited thereto.

The passive vibration member 1100 according to another example of the present disclosure may include a display panel including a pixel which displays an image, or may include a non-display panel. For example, the passive vibration member 1100 may include one or more of a display panel including a pixel displaying an image, a screen panel on which an image is to be projected from a display apparatus, a lighting panel, a signage panel, a vehicular interior material, a vehicular exterior material, a vehicular glass window, a vehicular seat interior material, a building ceiling material, a building exterior material, a building interior material, a building glass window, an aircraft interior material, an aircraft glass window, and a mirror, but examples of the present disclosure are not limited thereto. For example, the non-display panel may be a light emitting diode lighting panel (or apparatus), an organic light emitting lighting panel (or apparatus), or an inorganic light emitting lighting panel (or apparatus), but examples of the present disclosure are not limited thereto.

The one or more vibration generating apparatuses 1200 may be configured to vibrate the passive vibration member 1100. The one or more vibration generating apparatuses 1200 may be configured to be connected to a rear surface 1000a of the passive vibration member 1100 by a supporting member 1150. Accordingly, the one or more vibration generating apparatuses 1200 may vibrate the passive vibration member 1100 to generate or output one or more of a vibration and a sound based on a vibration of the passive vibration member 1100.

The one or more vibration generating apparatuses 1200 may include one or more of the vibration apparatus described above with reference to FIGs. 1 to 26. Accordingly, descriptions of the vibration apparatus described above with reference to FIGs. 1 to 26 may be included in descriptions of the vibration generating apparatus 1200 illustrated in FIGs. 27 and 28, and thus, like reference numerals refer to like elements, and repeated descriptions may be omitted or may be briefly provided.

The supporting member 1150 may be disposed between the vibration generating apparatus 1200 and the passive vibration member 1100. The supporting member 1150 may be disposed between at least a portion of the vibration generating apparatus 1200 and the passive vibration member 1100. The supporting member 1150 according to an example of the present disclosure may be connected between the passive vibration member 1100 and a center portion, except a periphery portion, of the vibration generating apparatus 1200.

According to an example of the present disclosure, the supporting member 1150 may be connected between the passive vibration member 1100 and the center portion of the vibration generating apparatus 1200 based on a partial attachment scheme (or a partial bonding scheme). The center portion (or a central portion) of the vibration generating apparatus 1200 may be a center of a vibration, and thus, a vibration of the vibration generating apparatus 1200 may be effectively transferred to the passive vibration member 1100 through (or by) the supporting member 1150. A periphery portion of the vibration generating apparatus 1200 may be spaced apart from each of the supporting member 1150 and the passive vibration member 1100 and lifted without being connected to the supporting member 1150 and/or the passive vibration member 1100, and thus, in a flexural vibration (or a bending vibration) of the vibration generating apparatus 1200, a vibration of a periphery portion of the vibration generating apparatus 1200 may be prevented (or reduced) by the supporting member 1150 and/or the passive vibration member 1100, whereby a vibration amplitude (or a displacement amplitude) of the vibration generating apparatus 1200 may increase. Accordingly, a vibration amplitude (or a displacement amplitude) of the passive vibration member 1100 based on a vibration of the vibration generating apparatus 1200 may increase, and thus, a sound characteristic and/or a sound pressure level characteristic of a sound band including a low-pitched sound band generated based on a vibration of the passive vibration member 1100 may be more enhanced.

The supporting member 1150 according to another example of the present disclosure may be connected to or attached on an entire front surface of each of the one or more vibration generating apparatuses 1200 and the rear surface 1000a of the passive vibration member 1100 based on an entire surface attachment scheme (or an entire surface bonding scheme).

The supporting member 1150 according to an example of the present disclosure may be configured as a material including an adhesive layer which is good in adhesive force or attaching force with respect to each of the one or more vibration generating apparatuses 1200 and a rear surface of the display panel or a rear surface 1000a of the passive vibration member 1100. For example, the supporting member 1150 may include a foam pad, a double-sided tape, a double-sided foam tape, or an adhesive, or the like, but examples of the present disclosure are not limited thereto. For example, the adhesive layer of the supporting member 1150 may include epoxy, acrylic, silicone, or urethane, but examples of the present disclosure are not limited thereto. For example, the adhesive layer of the supporting member 1150 may include an acrylic-based material (or substance) having a characteristic where an adhesive force is relatively better and hardness is higher than urethane. Accordingly, the transmission efficiency of a vibration transmitted from the one or more vibration generating apparatuses 1200 to the passive vibration member 1100 may be increased. For example, the supporting member 1150 may be a supporting part, a transmission member, a vibration transmission member, a panel connection member, or a panel coupling member.

The apparatus according to an example of the present disclosure may further include a rear member 1300 and a coupling member 1350.

The rear member 1300 may be disposed at the rear surface 1000a of the passive vibration member 1100. The rear member 1300 may be disposed at the rear surface 1000a of the passive vibration member 1100 to cover the one or more vibration generating apparatuses 1200. The rear member 1300 may be disposed at the rear surface 1000a of the passive vibration member 1100 to cover all of the rear surface 1000a of the passive vibration member 1100 and the one or more vibration generating apparatuses 1200. For example, the rear member 1300 may have a same size as the passive vibration member 1100. For example, the rear member 1300 may cover an entire rear surface of the passive vibration member 1100 with a gap space GS and the one or more vibration generating apparatuses 1200 therebetween. The gap space GS may be provided by the coupling member 1350 disposed between the passive vibration member 1100 and the rear member 1300 facing each other. The gap space GS may be referred to as an air gap, an accommodating space, a vibration space, or a sound sounding box, but examples of the present disclosure are not limited thereto.

The rear member 1300 may include any one material of a glass material, a metal material, and a plastic material, but examples of the present disclosure are not limited thereto. For example, the rear member 1300 may include a stacked structure in which one or more of a glass material, a plastic material, and a metal material is stacked thereof, but examples of the present disclosure are not limited thereto.

Each of the passive vibration member 1100 and the rear member 1300 may have a square shape or a rectangular shape, but examples of the present disclosure are not limited thereto. For example, each of the passive vibration member 1100 and the rear member 1300 may have a polygonal shape, a non-polygonal shape, a circular shape, or an oval shape. For example, when the apparatus according to an example of the present disclosure is applied to a sound apparatus or a sound bar, each of the passive vibration member 1100 and the rear member 1300 may have a rectangular shape where a length of a long side is twice or more times longer than a short side, but examples of the present disclosure are not limited thereto.

The coupling member 1350 may be configured to be connected between a rear periphery portion of the passive vibration member 1100 and a front periphery portion of the rear member 1300, and thus, the gap space GS may be provided between the passive vibration member 1100 and the rear member 1300 facing each other.

The coupling member 1350 according to an example of the present disclosure may include an elastic material which has adhesive properties and is capable of compression and decompression. For example, the coupling member 1350 may include a double-sided tape, a single-sided tape, a double-sided foam tape, or a double-sided adhesive foam pad, but examples of the present disclosure are not limited thereto. For example, the coupling member 1350 may include an elastic pad such as a rubber pad or a silicone pad, or the like, which has adhesive properties and is capable of compression and decompression. For example, the coupling member 1350 may be formed by elastomer.

The rear member 1300 according to another example of the present disclosure may further include a sidewall part which supports a rear periphery portion of the passive vibration member 1100. The sidewall part of the rear member 1300 may protrude or be bent toward the rear periphery portion of the passive vibration member 1100 from the front periphery portion of the rear member 1300, and thus, the gap space GS may be provided between the passive vibration member 1100 and the rear member 1300. For example, the coupling member 1350 may be configured to be connected between the sidewall part of the rear member 1300 and the rear periphery portion of the passive vibration member 1100. Accordingly, the rear member 1300 may cover the one or more vibration generating apparatuses 1200 and may support the rear surface 1000a of the passive vibration member 1100. For example, the rear member 1300 may cover the one or more vibration generating apparatuses 1200 and may support the rear periphery portion of the passive vibration member 1100.

According to another example of the present disclosure, the passive vibration member 1100 may further include a sidewall part which is connected to a front periphery portion of the rear member 1300. The sidewall part of the passive vibration member 1100 may protrude or be bent toward the front periphery portion of the rear member 1300 from the rear periphery portion of the passive vibration member 1100, and thus, the gap space GS may be provided between the passive vibration member 1100 and the rear member 1300. A stiffness of the passive vibration member 1100 may be increased based on the sidewall part. For example, the coupling member 1350 may be configured to be connected between the sidewall part of the passive vibration member 1100 and the front periphery portion of the rear member 1300. Accordingly, the rear member 1300 may cover the one or more vibration generating apparatuses 1200 and may support the rear surface 1000a of the passive vibration member 1100. For example, the rear member 1300 may cover the one or more vibration generating apparatuses 1200 and may support the rear periphery portion of the passive vibration member 1100.

The apparatus according to an example of the present disclosure may further include one or more enclosure 1250.

The enclosure 1250 may be connected or coupled to the rear periphery portion of the passive vibration member 1100 to individually cover the one or more vibration generating apparatuses 1200. For example, the enclosure 1250 may be connected or coupled to the rear surface 1000a of the passive vibration member 1100 by an adhesive member 1251. The enclosure 1250 may configure a closed space which covers or surrounds the one or more vibration generating apparatuses 1200 at the rear surface 1000a of the passive vibration member 1100. For example, the enclosure 1250 may be a case, an outer case, a case member, a housing member, a cabinet, a closed member, a closed cap, a closed box, or a sound box, but examples of the present disclosure are not limited thereto. The closed space may be an air gap, a vibration space, a sound space, or a sound sounding box, but examples of the present disclosure are not limited thereto.

The enclosure 1250 may include one or more materials of a metal material, a nonmetal material, and a composite nonmetal material. For example, the enclosure 1250 may include one or more materials of a metal, plastic, carbon, and wood, but examples of the present disclosure are not limited thereto.

The enclosure 1250 according to an example of the present disclosure may maintain an impedance component based on air acting on the passive vibration member 1100 when the passive vibration member 1100 or the vibration generating apparatus 1200 is vibrating. For example, air around the passive vibration member 1100 may resist a vibration of the passive vibration member 1100 and may act as an impedance component having a reactance component and a resistance based on a frequency. Therefore, the enclosure 1250 may configure a closed space which surrounds the one or more vibration generating apparatuses 1200, in the rear surface 1000a of the passive vibration member 1100, and thus, may maintain an impedance component (or an air impedance or an elastic impedance) acting on the passive vibration member 1100 based on air, thereby enhancing a sound characteristic and/or a sound pressure level characteristic of a sound band including the low-pitched sound band and enhancing the quality of a sound of a high-pitched sound band.

The adhesive member 1251 may be configured to minimize, reduce, or prevent vibration of the vibration member 1100 from being transferred to the enclosure 1250. The adhesive member 1251 may include a material characteristic suitable for blocking a vibration. For example, the adhesive member 1251 may include a material having elasticity. For example, the adhesive member 1251 may include a material having elasticity for vibration absorption (or impact absorption). The adhesive member 1251 according to an example of the present disclosure may be configured as polyurethane material or polyolefin material, but examples of the present disclosure are not limited thereto. For example, the adhesive member 1251 may include one or more of an adhesive, a double-sided tape, a double-sided foam tape, a double-sided foam pad, and a double-sided cushion tape, but examples of the present disclosure are not limited thereto.

FIG. 29 illustrates a sound output characteristic of a vibration apparatus according to an example of the present disclosure and a sound output characteristic of a vibration apparatus according to an experimental example. In FIG. 29, the abscissa axis represents a frequency in hertz (Hz), and the ordinate axis represents a sound pressure level (SPL) in decibels (dB).

The sound output characteristic may be measured by sound analysis equipment. The sound analysis equipment may include a control PC, a sound card for transmitting and receiving sound, an amplifier for amplifying and transmitting the sound generated from the sound card to the sound apparatus, and a microphone for collecting the sound generated in the apparatus based on driving of the vibration apparatus. The sound collected by the microphone is input to the control PC through the sound card, and the sound is checked in a control program to analyze the sound of the apparatus.

The sound output characteristic has been measured in an anechoic chamber, which is closed in all directions. When measuring, an applied frequency signal is applied as a sine sweep within a range of 20Hz to 20kHz, and 1/3 octave smoothing has been performed on a measurement result. A separation distance between the apparatus and the microphone is adjusted to be 30cm. However, a measurement method of the sound output characteristic may be not limited thereto.

In FIG. 29, a dotted line represents a sound output characteristic of a vibration apparatus according to an experimental example including one vibration part. A dash-single dotted line represents a sound output characteristic of a vibration apparatus including two vibration parts which are vertically stacked. A solid line represents a sound output characteristic of a vibration apparatus including three vibration parts which are vertically stacked. A thick solid line represents a sound output characteristic of a vibration apparatus including four vibration parts which are vertically stacked.

As seen in FIG. 29, it may be seen that a sound pressure level increases as the number of vertically stacked vibration parts increases. For example, it may be seen that the vibration apparatus according to the experimental example including one vibration part has an average sound pressure level of about 72.85dB within a frequency range of 150Hz to 8kHz as in the dotted line, and as in the thick solid line, the vibration apparatus including four vibration parts vertically stacked has an average sound pressure level of about 83.17dB within a frequency range of 150Hz to 8kHz. Accordingly, comparing with the vibration apparatus according to the experimental example, in the vibration apparatus according to an example of the present disclosure, as the number of vertically stacked vibration parts increases, a sound pressure level of about 10dB may be enhanced.

A vibration apparatus and an apparatus including the same according to an example of the present disclosure will be described below.

A vibration apparatus according to one or more examples of the present disclosure may comprise a vibration generating part. The vibration generating part may comprise a plurality of vibration parts each including a first surface including a first pattern portion and a second surface including a third pattern portion, the plurality of vibration parts being stacked on each other, a first connection member electrically connected to the first pattern portion of each of the plurality of vibration parts, and a second connection member electrically connected to the third pattern portion of each of the plurality of vibration parts.

According to one or more examples of the present disclosure, the first surface of each of the plurality of vibration parts may further include a second pattern portion having a different shape from that of the first pattern portion, and the second surface of each of the plurality of vibration parts may further include a fourth pattern portion having a different shape from that of the third pattern portion.

According to one or more examples of the present disclosure, the first connection member may be electrically disconnected (or separated or isolated) from the fourth pattern portion of each of the plurality of vibration parts. The second connection member may be electrically disconnected (or separated or isolated) from the second pattern portion of each of the plurality of vibration parts.

According to one or more examples of the present disclosure, each of the plurality of vibration parts may comprise a vibration layer including a piezoelectric material, a first electrode layer at a first surface of the vibration layer, the first electrode layer including the first pattern portion and the second pattern portion, and a second electrode layer at a second surface opposite to the first surface of the vibration layer, the second electrode layer including the third pattern portion and the fourth pattern portion.

According to one or more examples of the present disclosure, each of a lateral surface of the first electrode layer and a lateral surface of the second electrode layer may be spaced apart from a lateral surface of the vibration layer. The first pattern portion and the second pattern portion may be configured at one lateral surface of the first electrode layer. The third pattern portion and the fourth pattern portion may be configured at one lateral surface of the second electrode layer.

According to one or more examples of the present disclosure, a distance between the lateral surface of the first electrode layer and the lateral surface of the vibration layer may be greater than a thickness of the vibration layer or is two or more times the thickness of the vibration layer. A distance between the lateral surface of the second electrode layer and the lateral surface of the vibration layer may be greater than the thickness of the vibration layer or may be two or more times the thickness of the vibration layer.

According to one or more examples of the present disclosure, the first pattern portion may protrude from one lateral surface of the first electrode layer to one lateral surface of the vibration layer. The second pattern portion may be spaced apart from the first pattern portion and may be configured concavely from one lateral surface of the first electrode layer.

According to one or more examples of the present disclosure, an end lateral surface of the first pattern portion may be aligned at the one lateral surface of the vibration layer.

According to one or more examples of the present disclosure, the third pattern portion may protrude from the one lateral surface of the second electrode layer to one lateral surface of the vibration layer to correspond to the first pattern portion. The fourth pattern portion may be spaced apart from the third pattern portion and may be configured concavely from the one lateral surface of the second electrode layer to correspond to the second pattern portion.

According to one or more examples of the present disclosure, an end lateral surface of the third pattern portion may be aligned at the one lateral surface of the vibration layer.

According to one or more examples of the present disclosure, the vibration apparatus may further comprise a first cover member and a second cover member. The vibration generating part may be disposed between the first cover member and the second cover member.

According to one or more examples of the present disclosure, the first connection member may be configured at one lateral surface of the vibration generating part and may be connected to one lateral surface of the first pattern portion and one lateral surface of the vibration layer of each of the plurality of vibration parts. The second connection member may be configured at one lateral surface of the vibration generating part and may be connected to one lateral surface of the third pattern portion and one lateral surface of the vibration layer of each of the plurality of vibration parts.

According to one or more examples of the present disclosure, the vibration apparatus may further comprise a signal supply member electrically connected to the vibration generating part. The signal supply member may comprise a first signal line electrically connected to the first pattern portion and the first connection member, and a second signal line electrically connected to the third pattern portion and the second connection member.

According to one or more examples of the present disclosure, the vibration apparatus may further comprise a first cover member and a second cover member. The vibration generating part may be disposed between the first cover member and the second cover member. A portion of the signal supply member may be accommodated between the first cover member and the second cover member.

According to one or more examples of the present disclosure, the first signal line may be disposed between the first cover member and the vibration generating part. The second signal line may be disposed between the second cover member and the vibration generating part.

According to one or more examples of the present disclosure, the vibration apparatus may further comprise a pad member configured at the signal supply member. The signal supply member may further comprise a base film and an insulation film. The first signal line and the second signal line may be disposed between the base film and the insulation film. The pad member may be disposed between the base film and the insulation film. A portion of the pad member may be accommodated between the first cover member and the second cover member.

According to one or more examples of the present disclosure, a first vibration part of the plurality of vibration parts may further comprise a connection pattern at a first surface of the vibration layer and electrically disconnected (or separated or isolated) from the first electrode layer. The connection pattern may be electrically connected to the second connection member.

According to one or more examples of the present disclosure, each of a lateral surface of the first electrode layer and a lateral surface of the second electrode layer may be spaced apart from a lateral surface of the vibration layer. The first pattern portion may protrude from one lateral surface of the first electrode layer to one lateral surface of the vibration layer. The second pattern portion may be spaced apart from the first pattern portion and may be configured concavely from one lateral surface of the first electrode layer. The connection pattern may be configured in the second pattern portion and may extend to one lateral surface of the vibration layer.

According to one or more examples of the present disclosure, the connection pattern may be configured as an island shape on the first surface of the vibration layer of the first vibration part and may be aligned at the one lateral surface of the vibration layer.

According to one or more examples of the present disclosure, the third pattern portion may protrude from the one lateral surface of the second electrode layer to one lateral surface of the vibration layer to correspond to the first pattern portion. The fourth pattern portion may be spaced apart from the third pattern portion and may be configured concavely from the one lateral surface of the second electrode layer to correspond to the second pattern portion.

According to one or more examples of the present disclosure, the first connection member may be configured at one lateral surface of the vibration generating part and may be connected to one lateral surface of the first pattern portion and one lateral surface of the vibration layer of each of the plurality of vibration parts. The second connection member may be configured at one lateral surface of the vibration generating part, may be connected to one lateral surface of the third pattern portion and one lateral surface of the vibration layer of each of the plurality of vibration parts, and may be connected to the connection pattern.

According to one or more examples of the present disclosure, the vibration apparatus may further comprise a signal supply member electrically connected to the vibration generating part. The signal supply member may comprise a first signal line electrically connected to the first connection member, and a second signal line electrically connected to the second connection member.

According to one or more examples of the present disclosure, the vibration apparatus may further comprise a first cover member and a second cover member. The vibration generating part may be disposed between the first cover member and the second cover member. A portion of the signal supply member may be accommodated between the first cover member and the second cover member.

According to one or more examples of the present disclosure, the vibration apparatus may further comprise a first cover member and a second cover member. The vibration generating part may be disposed between the first cover member and the second cover member. The first signal line and the second signal line may be disposed between the first cover member and the vibration generating part.

According to one or more examples of the present disclosure, the first connection member may pass through the plurality of vibration parts and may be electrically connected to the first pattern portion of each of the plurality of vibration parts. The second connection member may pass through the plurality of vibration parts and may be electrically connected to the third pattern portion of each of the plurality of vibration parts.

According to one or more examples of the present disclosure, the first connection member may pass through the vibration layer of each of the plurality of vibration parts and a plurality of insulation members between the plurality of vibration parts and may be electrically connected to the first pattern portion of each of the plurality of vibration parts and overlap with the fourth pattern portion of each of the plurality of vibration parts. The second connection member may pass through the vibration layer of each of the plurality of vibration parts and the plurality of insulation members and may be electrically connected to the third pattern portion of each of the plurality of vibration parts and overlap with the second pattern portion of each of the plurality of vibration parts.

According to one or more examples of the present disclosure, each of the plurality of vibration parts may comprise a first connection pattern disposed at a first surface of the vibration layer and electrically disconnected (or separated or isolated) from the first electrode layer, and a second connection pattern disposed at a second surface of the vibration layer and electrically disconnected (or separated or isolated) from the second electrode layer. The first pattern portion may comprise a first hole configured at the first electrode layer. The second pattern portion may comprise a second hole configured at the first connection pattern. The third pattern portion may comprise a third hole configured at the second electrode layer. The fourth pattern portion may comprise a fourth hole configured at the second connection pattern.

According to one or more examples of the present disclosure, the first connection member may be electrically connected to the second connection pattern of each of the plurality of vibration parts, and the second connection member may be electrically connected to the first connection pattern of each of the plurality of vibration parts.

According to one or more examples of the present disclosure, each of the plurality of insulation members may comprise a fifth pattern portion overlapping the first connection pattern, and a sixth pattern portion overlapping the second connection pattern.

According to one or more examples of the present disclosure, vibration layers of the plurality of vibration parts may have a same poling direction. Each of the plurality of insulation members may be disposed between two vibration parts vertically adjacent to each other among the plurality of vibration parts and may be disposed between a second electrode layer of an upper vibration part and a first electrode layer of a lower vibration part of the two vibration parts vertically adjacent to each other.

According to one or more examples of the present disclosure, some of vibration layers of the plurality of vibration parts may have different poling directions. Each of the plurality of insulation members may be disposed between two vibration parts vertically adjacent to each other among the plurality of vibration parts. Some of the plurality of insulation members may be disposed between a second electrode layer of an upper vibration part and a second electrode layer of a lower vibration part of the two vibration parts vertically adjacent to each other. The other of the plurality of insulation members may be disposed between a first electrode layer of the upper vibration part and a first electrode layer of the lower vibration part of the two vibration parts vertically adjacent to each other.

According to one or more examples of the present disclosure, the vibration layer of each of the plurality of vibration parts may comprise a first via hole between the first hole and the fourth hole, and a second via hole between the second hole and the third hole. The first connection member may be disposed at the first hole, the fourth hole, and the first via hole to pass through the vibration layers of the plurality of vibration parts and the plurality of insulation members. The second connection member may be disposed at the second hole, the third hole, and the second via hole to pass through the vibration layers of the plurality of vibration parts and the plurality of insulation members.

According to one or more examples of the present disclosure, the vibration apparatus may further comprise a signal supply member electrically connected to the vibration generating part. The signal supply member may comprise a first signal line electrically connected to the first connection member, and a second signal line electrically connected to the second connection member.

According to one or more examples of the present disclosure, the vibration apparatus may further comprise a first cover member and a second cover member. The vibration generating part may be disposed between the first cover member and the second cover member. A portion of the signal supply member may be accommodated between the first cover member and the second cover member.

According to one or more examples of the present disclosure, the vibration apparatus may further comprise a first cover member and a second cover member. The vibration generating part may be disposed between the first cover member and the second cover member. The first signal line and the second signal line may be disposed between the first cover member and the vibration generating part.

An apparatus according to one or more examples of the present disclosure may comprise a passive vibration member, and one or more vibration generating apparatuses configured to vibrate the passive vibration member. The one or more vibration generating apparatuses comprise a vibration apparatus. The vibration apparatus may comprise a vibration generating part. The vibration generating part may comprise a plurality of vibration parts each including a first surface including a first pattern portion and a second surface including a third pattern portion, the plurality of vibration parts being stacked on each other, a first connection member electrically connected to the first pattern portion of each of the plurality of vibration parts, and a second connection member electrically connected to the third pattern portion of each of the plurality of vibration parts.

According to one or more examples of the present disclosure, an apparatus may further comprise an enclosure disposed at a rear surface of the passive vibration member and configured to cover the one or more vibration generating apparatuses.

According to one or more examples of the present disclosure, the passive vibration member may comprise one or more of a vibration plate, a display panel including a pixel configured to display an image, a screen panel on which an image is to be projected from a display apparatus, a light emitting diode lighting panel, an organic light emitting lighting panel, an inorganic light emitting lighting panel, a signage panel, a vehicular interior material, a vehicular exterior material, a vehicular glass window, a vehicular seat interior material, a vehicular ceiling material, a building ceiling material, a building interior material, a building glass window, an aircraft interior material, an aircraft glass window, and a mirror. The vibration plate may comprise one or more material of a metal, plastic, wood, paper, fiber, cloth, leather, glass, rubber, carbon, and mirror.

According to one or more examples of the present disclosure, the apparatus may further include an enclosure coupled to a rear surface of the passive vibration member to form a closed space covering the one or more vibration generating apparatuses.

According to one or more examples of the present disclosure, the apparatus may further include a rear member disposed at the rear surface of the passive vibration member to cover the enclosure.

A vibration apparatus according to one or more examples of the present disclosure may be applied to or included in a vibration apparatus disposed at an apparatus or a display apparatus. The apparatus or the display apparatus according to one or more examples of the present disclosure may be applied to or included in mobile apparatuses, video phones, smart watches, watch phones, wearable apparatuses, foldable apparatuses, rollable apparatuses, bendable apparatuses, flexible apparatuses, curved apparatuses, sliding apparatuses, variable apparatuses, electronic organizers, electronic books, portable multimedia players (PMPs), personal digital assistants (PDAs), MP3 players, mobile medical devices, desktop personal computers (PCs), laptop PCs, netbook computers, workstations, navigation apparatuses, automotive navigation apparatuses, automotive display apparatuses, automotive apparatuses, theatre apparatuses, theatre display apparatuses, TVs, wall paper display apparatuses, signage apparatuses, game machines, notebook computers, monitors, cameras, camcorders, and home appliances, or the like. Further, the vibration apparatus according to one or more examples of the present disclosure may be applied to or included in an organic light-emitting lighting apparatus or an inorganic light-emitting lighting apparatus. When the vibration apparatus is applied to or included in the lighting apparatuses, the lighting apparatuses may act as lighting and a speaker. In addition, when the vibration apparatus according to one or more examples of the present disclosure is applied to or included in the mobile apparatuses, or the like, the sound apparatus may be one or more of a speaker, a receiver, and a haptic device, but examples of the present disclosure are not limited thereto.

Further examples are set out on the clauses below:
1. A vibration apparatus, comprising: a vibration generating part,
   wherein the vibration generating part comprises: a plurality of vibration parts each including a first surface including a first pattern portion and a second surface including a third pattern portion, the plurality of vibration parts being stacked on each other;
   a first connection member electrically connected to the first pattern portion of each of the plurality of vibration parts; and
   a second connection member electrically connected to the third pattern portion of each of the plurality of vibration parts.
2. The vibration apparatus of clause 1, wherein the first surface of each of the plurality of vibration parts further includes a second pattern portion having a different shape from that of the first pattern portion, and the second surface of each of the plurality of vibration parts further includes a fourth pattern portion having a different shape from that of the third pattern portion.
3. The vibration apparatus of clause 2, wherein the first connection member is electrically separated from the fourth pattern portion of each of the plurality of vibration parts, and wherein the second connection member is electrically separated from the second pattern portion of each of the plurality of vibration parts.
4. The vibration apparatus of clause 1 or 2, wherein each of the plurality of vibration parts comprises: a vibration layer including a piezoelectric material;
   a first electrode layer at a first surface of the vibration layer, the first electrode layer including the first pattern portion and the second pattern portion; and
   a second electrode layer at a second surface opposite to the first surface of the vibration layer, the second electrode layer including the third pattern portion and the fourth pattern portion.
5. The vibration apparatus of clause 4, wherein each of a lateral surface of the first electrode layer and a lateral surface of the second electrode layer is spaced apart from a lateral surface of the vibration layer,
   wherein the first pattern portion and the second pattern portion are configured at one lateral surface of the first electrode layer, and
   wherein the third pattern portion and the fourth pattern portion are configured at one lateral surface of the second electrode layer.
6. The vibration apparatus of clause 6, wherein a distance between the lateral surface of the first electrode layer and the lateral surface of the vibration layer is greater than a thickness of the vibration layer or is two or more times the thickness of the vibration layer, and wherein a distance between the lateral surface of the second electrode layer and the lateral surface of the vibration layer is greater than the thickness of the vibration layer or is two or more times the thickness of the vibration layer.
7. The vibration apparatus of clause 4 or 5, wherein the first pattern portion protrudes from one lateral surface of the first electrode layer to one lateral surface of the vibration layer, and wherein the second pattern portion is spaced apart from the first pattern portion and is configured concavely from one lateral surface of the first electrode layer.
8. The vibration apparatus of clause 7, wherein an end lateral surface of the first pattern portion is aligned at the one lateral surface of the vibration layer.
9. The vibration apparatus of any one of clauses 5-7, wherein the third pattern portion protrudes from the one lateral surface of the second electrode layer to one lateral surface of the vibration layer to correspond to the first pattern portion, and wherein the fourth pattern portion is spaced apart from the third pattern portion and is configured concavely from the one lateral surface of the second electrode layer to correspond to the second pattern portion.
10. The vibration apparatus of clause 9, wherein an end lateral surface of the third pattern portion is aligned at the one lateral surface of the vibration layer.
11. The vibration apparatus of any one of the preceding clauses, further comprising a first cover member and a second cover member, wherein the vibration generating part is disposed between the first cover member and the second cover member.
12. The vibration apparatus of any one of clauses 4-10, wherein the first connection member is configured at one lateral surface of the vibration generating part and is connected to one lateral surface of the first pattern portion and one lateral surface of the vibration layer of each of the plurality of vibration parts, and wherein the second connection member is configured at one lateral surface of the vibration generating part and is connected to one lateral surface of the third pattern portion and one lateral surface of the vibration layer of each of the plurality of vibration parts.
13. The vibration apparatus of clause 12, further comprising a signal supply member electrically connected to the vibration generating part,
   wherein the signal supply member comprises: a first signal line electrically connected to the first pattern portion and the first connection member; and
   a second signal line electrically connected to the third pattern portion and the second connection member.
14. The vibration apparatus of clause 13, further comprising a first cover member and a second cover member, wherein the vibration generating part is disposed between the first cover member and the second cover member, and
   wherein a portion of the signal supply member is accommodated between the first cover member and the second cover member.
15. The vibration apparatus of clause 14, wherein the first signal line is disposed between the first cover member and the vibration generating part, and wherein the second signal line is disposed between the second cover member and the vibration generating part.
16. The vibration apparatus of clause 15, further comprising a pad member configured at the signal supply member, wherein the signal supply member further comprises a base film and an insulation film, wherein the first signal line and the second signal line are disposed between the base film and the insulation film, wherein the pad member is disposed between the base film and the insulation film, and wherein a portion of the pad member is accommodated between the first cover member and the second cover member.
17. The vibration apparatus of any one of clauses 4-16, wherein a first vibration part of the plurality of vibration parts further comprises a connection pattern at a first surface of the vibration layer and electrically separated from the first electrode layer, and wherein the connection pattern is electrically connected to the second connection member.
18. The vibration apparatus of clause 17, wherein each of a lateral surface of the first electrode layer and a lateral surface of the second electrode layer is spaced apart from a lateral surface of the vibration layer,
   wherein the first pattern portion protrudes from one lateral surface of the first electrode layer to one lateral surface of the vibration layer,
   wherein the second pattern portion is spaced apart from the first pattern portion and is configured concavely from one lateral surface of the first electrode layer, and wherein the connection pattern is configured in the second pattern portion and extends to one lateral surface of the vibration layer.
19. The vibration apparatus of clause 18, wherein the connection pattern is configured as an island shape on the first surface of the vibration layer of the first vibration part and aligned at the one lateral surface of the vibration layer.
20. The vibration apparatus of clause 17, wherein the third pattern portion protrudes from the one lateral surface of the second electrode layer to one lateral surface of the vibration layer to correspond to the first pattern portion, and wherein the fourth pattern portion is spaced apart from the third pattern portion and is configured concavely from the one lateral surface of the second electrode layer to correspond to the second pattern portion.
21. The vibration apparatus of clause 17, wherein the first connection member is configured at one lateral surface of the vibration generating part and is connected to one lateral surface of the first pattern portion and one lateral surface of the vibration layer of each of the plurality of vibration parts, and wherein the second connection member is configured at one lateral surface of the vibration generating part, is connected to one lateral surface of the third pattern portion and one lateral surface of the vibration layer of each of the plurality of vibration parts, and is connected to the connection pattern.
22. The vibration apparatus of clause 21, further comprising a signal supply member electrically connected to the vibration generating part,
   wherein the signal supply member comprises: a first signal line electrically connected to the first connection member; and a second signal line electrically connected to the second connection member.
23. The vibration apparatus of clause 22, further comprising a first cover member and a second cover member, wherein the vibration generating part is disposed between the first cover member and the second cover member, and
   wherein a portion of the signal supply member is accommodated between the first cover member and the second cover member.
24. The vibration apparatus of clause 22, further comprising a first cover member and a second cover member, wherein the vibration generating part is disposed between the first cover member and the second cover member, and
   wherein the first signal line and the second signal line are disposed between the first cover member and the vibration generating part.
25. The vibration apparatus of any one of the preceding clauses, wherein the first connection member passes through the plurality of vibration parts and is electrically connected to the first pattern portion of each of the plurality of vibration parts, and wherein the second connection member passes through the plurality of vibration parts and is electrically connected to the third pattern portion of each of the plurality of vibration parts.
26. The vibration apparatus of clause 4, wherein the first connection member passes through the vibration layer of each of the plurality of vibration parts and a plurality of insulation members between the plurality of vibration parts and is electrically connected to the first pattern portion of each of the plurality of vibration parts and overlaps with the fourth pattern portion of each of the plurality of vibration parts, and wherein the second connection member passes through the vibration layer of each of the plurality of vibration parts and the plurality of insulation members and is electrically connected to the third pattern portion of each of the plurality of vibration parts and overlaps with the second pattern portion of each of the plurality of vibration parts.
27. The vibration apparatus of clause 26, wherein each of the plurality of vibration parts comprises: a first connection pattern disposed at a first surface of the vibration layer and electrically separated from the first electrode layer; and a second connection pattern disposed at a second surface of the vibration layer and electrically separated from the second electrode layer,
   wherein the first pattern portion comprises a first hole configured at the first electrode layer, wherein the second pattern portion comprises a second hole configured at the first connection pattern, wherein the third pattern portion comprises a third hole configured at the second electrode layer, and
   wherein the fourth pattern portion comprises a fourth hole configured at the second connection pattern.
28. The vibration apparatus of clause 27, wherein the first connection member is electrically connected to the second connection pattern of each of the plurality of vibration parts, and
   wherein the second connection member is electrically connected to the first connection pattern of each of the plurality of vibration parts.
29. The vibration apparatus of clause 27, wherein each of the plurality of insulation members comprises: a fifth pattern portion overlapping the first connection pattern; and a sixth pattern portion overlapping the second connection pattern.
30. The vibration apparatus of any one of clause 27-29, wherein vibration layers of the plurality of vibration parts have a same poling direction, and
   wherein each of the plurality of insulation members is disposed between two vibration parts vertically adjacent to each other among the plurality of vibration parts and is disposed between a second electrode layer of an upper vibration part and a first electrode layer of a lower vibration part of the two vibration parts vertically adjacent to each other.
31. The vibration apparatus of any one of clauses 27-30, wherein some of vibration layers of the plurality of vibration parts have different poling directions,
   wherein each of the plurality of insulation members is disposed between two vibration parts vertically adjacent to each other among the plurality of vibration parts, wherein some of the plurality of insulation members are disposed between a second electrode layer of an upper vibration part and a second electrode layer of a lower vibration part of the two vibration parts vertically adjacent to each other, and wherein the other of the plurality of insulation members are disposed between a first electrode layer of the upper vibration part and a first electrode layer of the lower vibration part of the two vibration parts vertically adjacent to each other.
32. The vibration apparatus of any one of clauses 27-31, wherein the vibration layer of each of the plurality of vibration parts comprises: a first via hole between the first hole and the fourth hole; and a second via hole between the second hole and the third hole, wherein the first connection member is disposed at the first hole, the fourth hole, and the first via hole to pass through the vibration layers of the plurality of vibration parts and the plurality of insulation members, and
   wherein the second connection member is disposed at the second hole, the third hole, and the second via hole to pass through the vibration layers of the plurality of vibration parts and the plurality of insulation members.
33. The vibration apparatus of clause 32, further comprising a signal supply member electrically connected to the vibration generating part, wherein the signal supply member comprises: a first signal line electrically connected to the first connection member; and a second signal line electrically connected to the second connection member.
34. The vibration apparatus of clause 33, further comprising a first cover member and a second cover member, wherein the vibration generating part is disposed between the first cover member and the second cover member, and
   wherein a portion of the signal supply member is accommodated between the first cover member and the second cover member.
35. The vibration apparatus of clause 33, further comprising a first cover member and a second cover member, wherein the vibration generating part is disposed between the first cover member and the second cover member, and
   wherein the first signal line and the second signal line are disposed between the first cover member and the vibration generating part.
36. An apparatus, comprising: a passive vibration member; and
   one or more vibration generating apparatuses configured to vibrate the passive vibration member, wherein the one or more vibration generating apparatuses comprise the vibration apparatus of any one of clauses 1 to 35.
37. The apparatus of clause 36, further comprising an enclosure disposed at a rear surface of the passive vibration member and configured to cover the one or more vibration generating apparatuses.
38. The apparatus of clause 36 or 37, wherein the passive vibration member comprises one or more of a vibration plate, a display panel including a pixel configured to display an image, a screen panel on which an image is to be projected from a display apparatus, a light emitting diode lighting panel, an organic light emitting lighting panel, an inorganic light emitting lighting panel, a signage panel, a vehicular interior material, a vehicular exterior material, a vehicular glass window, a vehicular seat interior material, a vehicular ceiling material, a building ceiling material, a building interior material, a building glass window, an aircraft interior material, an aircraft glass window, and a mirror, and
   wherein the vibration plate comprises one or more material of a metal, plastic, wood, paper, fiber, cloth, leather, glass, rubber, carbon, and mirror.
39. The apparatus of clause 36, further comprising an enclosure coupled to a rear surface of the passive vibration member to form a closed space covering the one or more vibration generating apparatuses.
40. The apparatus of clause 39, further comprising a rear member disposed at the rear surface of the passive vibration member to cover the enclosure.

It will be apparent to those skilled in the art that various modifications and variations can be made in the present disclosure without departing from the scope of the disclosures. Thus, it is intended that the present disclosure covers the modifications and variations of this disclosure that come within the scope of the claims and their equivalents.

## Claims

1. A vibration apparatus, comprising:
a vibration generating part,
wherein the vibration generating part comprises:
a plurality of vibration parts each including a first surface including a first pattern portion and a second surface including a third pattern portion, the plurality of vibration parts being stacked on each other;
a first connection member electrically connected to the first pattern portion of each of the plurality of vibration parts; and
a second connection member electrically connected to the third pattern portion of each of the plurality of vibration parts.

2. The vibration apparatus of claim 1,
wherein the first surface of each of the plurality of vibration parts further includes a second pattern portion having a different shape from that of the first pattern portion, and the second surface of each of the plurality of vibration parts further includes a fourth pattern portion having a different shape from that of the third pattern portion; or optionally
wherein the first connection member is electrically separated from the fourth pattern portion of each of the plurality of vibration parts, and
wherein the second connection member is electrically separated from the second pattern portion of each of the plurality of vibration parts; or optionally further comprising a first cover member and a second cover member,
wherein the vibration generating part is disposed between the first cover member and the second cover member; or optionally
wherein the first connection member passes through the plurality of vibration parts and is electrically connected to the first pattern portion of each of the plurality of vibration parts, and
wherein the second connection member passes through the plurality of vibration parts and is electrically connected to the third pattern portion of each of the plurality of vibration parts.

3. The vibration apparatus of claim 2, wherein each of the plurality of vibration parts comprises:
a vibration layer including a piezoelectric material;
a first electrode layer at a first surface of the vibration layer, the first electrode layer including the first pattern portion and the second pattern portion; and
a second electrode layer at a second surface opposite to the first surface of the vibration layer, the second electrode layer including the third pattern portion and the fourth pattern portion.

4. The vibration apparatus of claim 3,
wherein each of a lateral surface of the first electrode layer and a lateral surface of the second electrode layer is spaced apart from a lateral surface of the vibration layer,
wherein the first pattern portion and the second pattern portion are configured at one lateral surface of the first electrode layer, and
wherein the third pattern portion and the fourth pattern portion are configured at one lateral surface of the second electrode layer; and optionally
wherein a distance between the lateral surface of the first electrode layer and the lateral surface of the vibration layer is greater than a thickness of the vibration layer or is two or more times the thickness of the vibration layer, and
wherein a distance between the lateral surface of the second electrode layer and the lateral surface of the vibration layer is greater than the thickness of the vibration layer or is two or more times the thickness of the vibration layer; or optionally
wherein the first pattern portion protrudes from one lateral surface of the first electrode layer to one lateral surface of the vibration layer, and
wherein the second pattern portion is spaced apart from the first pattern portion and is configured concavely from one lateral surface of the first electrode layer; or optionally
wherein the third pattern portion protrudes from the one lateral surface of the second electrode layer to one lateral surface of the vibration layer to correspond to the first pattern portion, and
wherein the fourth pattern portion is spaced apart from the third pattern portion and is configured concavely from the one lateral surface of the second electrode layer to correspond to the second pattern portion.

5. The vibration apparatus of claim 3,
wherein the first connection member is configured at one lateral surface of the vibration generating part and is connected to one lateral surface of the first pattern portion and one lateral surface of the vibration layer of each of the plurality of vibration parts, and
wherein the second connection member is configured at one lateral surface of the vibration generating part and is connected to one lateral surface of the third pattern portion and one lateral surface of the vibration layer of each of the plurality of vibration parts; and optionally
further comprising a signal supply member electrically connected to the vibration generating part,
wherein the signal supply member comprises:
a first signal line electrically connected to the first pattern portion and the first connection member; and
a second signal line electrically connected to the third pattern portion and the second connection member; and optionally
further comprising a first cover member and a second cover member,
wherein the vibration generating part is disposed between the first cover member and the second cover member, and
wherein a portion of the signal supply member is accommodated between the first cover member and the second cover member; and optionally
wherein the first signal line is disposed between the first cover member and the vibration generating part, and
wherein the second signal line is disposed between the second cover member and the vibration generating part; and optionally
further comprising a pad member configured at the signal supply member,
wherein the signal supply member further comprises a base film and an insulation film,
wherein the first signal line and the second signal line are disposed between the base film and the insulation film,
wherein the pad member is disposed between the base film and the insulation film, and
wherein a portion of the pad member is accommodated between the first cover member and the second cover member.

6. The vibration apparatus of claim 3,
wherein a first vibration part of the plurality of vibration parts further comprises a connection pattern at a first surface of the vibration layer and electrically separated from the first electrode layer, and
wherein the connection pattern is electrically connected to the second connection member; and optionally
wherein each of a lateral surface of the first electrode layer and a lateral surface of the second electrode layer is spaced apart from a lateral surface of the vibration layer,
wherein the first pattern portion protrudes from one lateral surface of the first electrode layer to one lateral surface of the vibration layer,
wherein the second pattern portion is spaced apart from the first pattern portion and is configured concavely from one lateral surface of the first electrode layer, and
wherein the connection pattern is configured in the second pattern portion and extends to one lateral surface of the vibration layer; or optionally
wherein the third pattern portion protrudes from the one lateral surface of the second electrode layer to one lateral surface of the vibration layer to correspond to the first pattern portion, and
wherein the fourth pattern portion is spaced apart from the third pattern portion and is configured concavely from the one lateral surface of the second electrode layer to correspond to the second pattern portion; or optionally
wherein the first connection member is configured at one lateral surface of the vibration generating part and is connected to one lateral surface of the first pattern portion and one lateral surface of the vibration layer of each of the plurality of vibration parts, and
wherein the second connection member is configured at one lateral surface of the vibration generating part, is connected to one lateral surface of the third pattern portion and one lateral surface of the vibration layer of each of the plurality of vibration parts, and is connected to the connection pattern.

7. The vibration apparatus of claim 6, further comprising a signal supply member electrically connected to the vibration generating part,
wherein the signal supply member comprises:
a first signal line electrically connected to the first connection member; and
a second signal line electrically connected to the second connection member.

8. The vibration apparatus of claim 7, further comprising a first cover member and a second cover member,
wherein the vibration generating part is disposed between the first cover member and the second cover member, and
wherein a portion of the signal supply member is accommodated between the first cover member and the second cover member; or optionally
further comprising a first cover member and a second cover member,
wherein the vibration generating part is disposed between the first cover member and the second cover member, and
wherein the first signal line and the second signal line are disposed between the first cover member and the vibration generating part.

9. The vibration apparatus of claim 4,
wherein the first connection member passes through the vibration layer of each of the plurality of vibration parts and a plurality of insulation members between the plurality of vibration parts and is electrically connected to the first pattern portion of each of the plurality of vibration parts and overlaps with the fourth pattern portion of each of the plurality of vibration parts, and
wherein the second connection member passes through the vibration layer of each of the plurality of vibration parts and the plurality of insulation members and is electrically connected to the third pattern portion of each of the plurality of vibration parts and overlaps with the second pattern portion of each of the plurality of vibration parts.

10. The vibration apparatus of claim 9,
wherein each of the plurality of vibration parts comprises:
a first connection pattern disposed at a first surface of the vibration layer and electrically separated from the first electrode layer; and
a second connection pattern disposed at a second surface of the vibration layer and electrically separated from the second electrode layer,
wherein the first pattern portion comprises a first hole configured at the first electrode layer,
wherein the second pattern portion comprises a second hole configured at the first connection pattern,
wherein the third pattern portion comprises a third hole configured at the second electrode layer, and
wherein the fourth pattern portion comprises a fourth hole configured at the second connection pattern.

11. The vibration apparatus of claim 10, wherein each of the plurality of insulation members comprises:
a fifth pattern portion overlapping the first connection pattern; and
a sixth pattern portion overlapping the second connection pattern; or optionally
wherein vibration layers of the plurality of vibration parts have a same poling direction, and
wherein each of the plurality of insulation members is disposed between two vibration parts vertically adjacent to each other among the plurality of vibration parts and is disposed between a second electrode layer of an upper vibration part and a first electrode layer of a lower vibration part of the two vibration parts vertically adjacent to each other; or optionally
wherein some of vibration layers of the plurality of vibration parts have different poling directions,
wherein each of the plurality of insulation members is disposed between two vibration parts vertically adjacent to each other among the plurality of vibration parts,
wherein some of the plurality of insulation members are disposed between a second electrode layer of an upper vibration part and a second electrode layer of a lower vibration part of the two vibration parts vertically adjacent to each other, and
wherein the other of the plurality of insulation members are disposed between a first electrode layer of the upper vibration part and a first electrode layer of the lower vibration part of the two vibration parts vertically adjacent to each other.

12. The vibration apparatus of claim 10,
wherein the vibration layer of each of the plurality of vibration parts comprises:
a first via hole between the first hole and the fourth hole; and
a second via hole between the second hole and the third hole,
wherein the first connection member is disposed at the first hole, the fourth hole, and the first via hole to pass through the vibration layers of the plurality of vibration parts and the plurality of insulation members, and
wherein the second connection member is disposed at the second hole, the third hole, and the second via hole to pass through the vibration layers of the plurality of vibration parts and the plurality of insulation members.

13. The vibration apparatus of claim 12, further comprising a signal supply member electrically connected to the vibration generating part,
wherein the signal supply member comprises:
a first signal line electrically connected to the first connection member; and
a second signal line electrically connected to the second connection member.

14. The vibration apparatus of claim 13, further comprising a first cover member and a second cover member,
wherein the vibration generating part is disposed between the first cover member and the second cover member, and
wherein a portion of the signal supply member is accommodated between the first cover member and the second cover member; or optionally
further comprising a first cover member and a second cover member,
wherein the vibration generating part is disposed between the first cover member and the second cover member, and
wherein the first signal line and the second signal line are disposed between the first cover member and the vibration generating part.

15. An apparatus, comprising:
a passive vibration member; and
one or more vibration generating apparatuses configured to vibrate the passive vibration member,
wherein the one or more vibration generating apparatuses comprise the vibration apparatus of any one of claims 1 to 14; or optionally
further comprising an enclosure disposed at a rear surface of the passive vibration member and configured to cover the one or more vibration generating apparatuses; or optionally
wherein the passive vibration member comprises one or more of a vibration plate, a display panel including a pixel configured to display an image, a screen panel on which an image is to be projected from a display apparatus, a light emitting diode lighting panel, an organic light emitting lighting panel, an inorganic light emitting lighting panel, a signage panel, a vehicular interior material, a vehicular exterior material, a vehicular glass window, a vehicular seat interior material, a vehicular ceiling material, a building ceiling material, a building interior material, a building glass window, an aircraft interior material, an aircraft glass window, and a mirror, and
wherein the vibration plate comprises one or more material of a metal, plastic, wood, paper, fiber, cloth, leather, glass, rubber, carbon, and mirror; or optionally
further comprising an enclosure coupled to a rear surface of the passive vibration member to form a closed space covering the one or more vibration generating apparatuses; or optionally
further comprising a rear member disposed at the rear surface of the passive vibration member to cover the enclosure.
